(19) Europäisches Patentamt
European Patent Office
Office européen des brevets

(11) EP 2 851 192 A1

(12) # EUROPEAN PATENT APPLICATION

published in accordance with Art. 153(4) EPC

(43) Date of publication:
**25.03.2015 Bulletin 2015/13**

(21) Application number: **13791148.3**

(22) Date of filing: **14.05.2013**

(51) Int Cl.:
***B32B 9/00*** *(2006.01)* ***C23C 16/42*** *(2006.01)*
***G09F 9/30*** *(2006.01)* ***H01L 31/042*** *(2014.01)*
***H01L 51/42*** *(2006.01)* ***H01L 51/50*** *(2006.01)*
***H05B 33/02*** *(2006.01)* ***H05B 33/10*** *(2006.01)*

(86) International application number:
**PCT/JP2013/063460**

(87) International publication number:
**WO 2013/172359 (21.11.2013 Gazette 2013/47)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **14.05.2012 JP 2012110826**

(71) Applicant: **Konica Minolta, Inc.**
**Tokyo 100-7015 (JP)**

(72) Inventor: **ISHIKAWA, Wataru**
**Tokyo 100-7015 (JP)**

(74) Representative: **Green, Mark Charles**
**Urquhart-Dykes & Lord LLP**
**The Podium**
**1 Eversholt Street**
**London NW1 2DN (GB)**

(54) **GAS BARRIER FILM, MANUFACTURING METHOD FOR GAS BARRIER FILM, AND ELECTRONIC DEVICE**

(57) The present invention is to provide a gas barrier film which has a high barrier property, excellent bending resistance and smoothness and suitability for cutting process, a manufacturing method for the same, and an electronic device using the gas barrier film.

A gas barrier film having a base, a first barrier layer formed on the surface of the base by a vapor growth method, a second barrier layer formed by a conversion treatment of a coating film formed by coating the surface of the first barrier layer with a first silicon compound, and a protective layer having no barrier property which is formed by a conversion treatment of a coating film formed by coating the surface of the second barrier layer with a second silicon compound.

FIG. 1

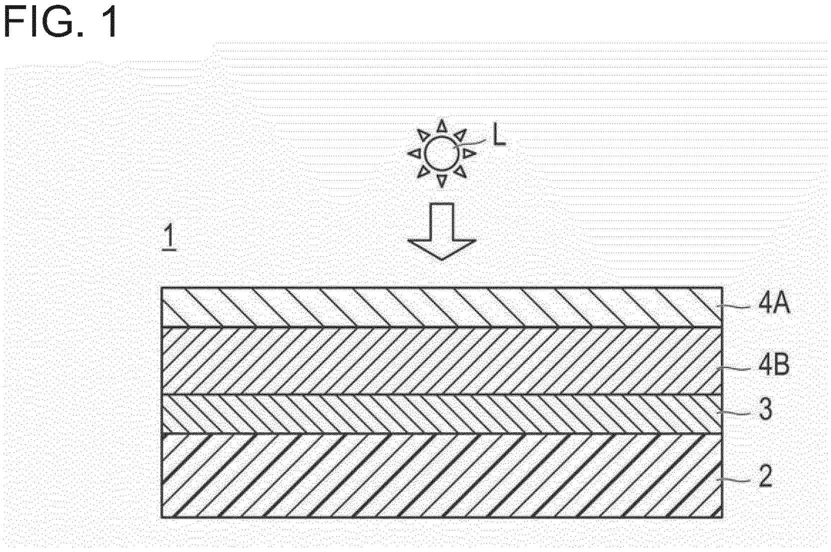

## Description

### TECHNICAL FIELD

The present invention relates to a gas barrier film, a method for manufacturing the same, and an electronic device using a gas barrier film. More specifically, it relates to a gas barrier film mainly used for packaging an electronic device, for a solar cell, or for a plastic substrate in a display material such as an organic EL element and a liquid crystal, a method for manufacturing the same, and an electronic device using a gas barrier film.

### BACKGROUND ART

Hitherto, a gas barrier film in which a thin layer of a metal oxide such as aluminum oxide, magnesium oxide, or silicon oxide is formed, on a plastic substrate or on a film surface has been widely used for packaging of a product which requires blocking of various types of gases such as water vapor and oxygen as well as for packaging to prevent quality deterioration of, for example, foods, industrial products, or medicinal products. Aside from the use for packaging, a gas barrier film is also used for a substrate for a liquid crystal display, a solar cell, and an organic electroluminescence (EL) substrate, for example.

As a method for manufacturing those gas barrier films, there are mainly known the following methods: a method for producing a gas barrier layer by a plasma chemical vapor deposition (CVD) method (chemical vapor growth method, chemical vapor deposition method); a method of coating with a coating liquid mainly containing a polysilazane followed by applying a surface treatment thereon; and a method of combining these two methods (for example, refer to Patent Literatures 1 to 3).

In the invention described in Patent Literature 1, there is disclosed that the compatibility of thick film formation for high gas barrier property and inhibition of cracks is achieved by a lamination method, which includes a wet process to form a polysilazane film having a thickness of 250 nm or less, followed by repeating two times or more of irradiation of the formed film with vacuum ultraviolet ray.

However, by the method described in Patent Literature 1, there remains a problem that bending property is not necessarily sufficient when only the lamination was repeated to achieve a higher gas barrier property. In addition, a phenomenon was caused in which the cut edge portion of the film is vigorously broken as glasses by the stress applied during the cutting process of the film. The effective area as a final product was decreased due to the crack on the cut surface of the film. As such, it was newly revealed that a problem of decreased production yield is present.

In the invention described in Patent Literature 2, there is disclosed a method in which a polysilazane is laminate-coated on a gas barrier layer formed on a resin base by a vacuum plasma CVD method, then the gas barrier layer is repaired by carrying out a heating treatment to further improve the barrier property. However, the performance as a gas barrier layer for an organic photoelectric conversion element is not sufficient. Accordingly, development of a gas barrier layer with a gas barrier property of a moisture permeating rate at a level which is notably lower than $1\times10^{-2}$ g/m$^2$·day, has been desired. Moreover, since the heating treatment of a polysilazane requires as long as 1 hour at 160°C, there has been a problem that the application range thereof is limited to a resin base having excellent heat resistance.

In the invention described in Patent Literature 3, a method is disclosed in which a polysilazane is coated on a gas barrier layer formed by an atmospheric pressure plasma CVD method to make the film smooth, and then, a conductive film is formed. Although the compatibility of a high barrier property and surface smoothness can be achieved by this method, a current status has a problem that the stress applied during bending is concentrated to the gas barrier layer to result in breakdown of the gas barrier layer due to the unrelieved stress, and inferior bending property. Further, the barrier film which is manufactured as described above also has a problem that, when exposed to high humidity, the barrier property is dramatically deteriorated after a certain period of time.

### Citation List

### Patent Literature

Patent Literature 1: Japanese Patent Application Laid-Open No. 2009-255040
Patent Literature 2: Japanese Patent No. 3511325
Patent Literature 3: Japanese Patent Application Laid-Open No. 2008-235165

## SUMMARY OF INVENTION

### Technical Problem

The present invention is achieved in view of the above-described problems, and an object thereof is to provide a gas barrier film which has a high barrier performance, excellent bending resistance and smoothness, and an appropriate cutting process suitability, a method for manufacturing the same, and an electronic device using the gas barrier film.

The aforementioned object of the present invention is achieved by a gas barrier film having a base, a first barrier layer formed on the surface of the base by a vapor growth method, a second barrier layer formed by a conversion treatment of a coating film formed by coating the surface of the first barrier layer with a first silicon compound, and a protective layer having no barrier property which is formed by a conversion treatment of a coating film formed by coating the surface of the second barrier layer with a second silicon compound.

### Effects of Invention

According to the present invention, it is possible to provide a gas barrier film which has a high barrier property, is excellent in bending resistance and smoothness, and has an appropriate cutting process suitability due to improved adhesiveness between a base and a barrier layer, and a method for manufacturing the gas barrier film and an electronic device using this gas barrier film.

## BRIEF DESCRIPTION OF DRAWINGS

Fig. 1 is a schematic cross-sectional view illustrating a preferred example of a layer constitution of a gas barrier film of the present invention.

Fig. 2 is a schematic cross-sectional view illustrating an example of a plasma CVD apparatus which can be used in the present invention.

Fig. 3 is a cross-sectional view illustrating an example of a solar cell consisting of an organic photoelectric conversion element of a bulk heterojunction type.

Fig. 4 is a cross-sectional view illustrating an example of a constitution of a solar cell consisting of an organic photoelectric conversion element provided with a bulk heterojunction layer.

Fig. 5 is a cross-sectional view illustrating another example of a constitution of a solar cell consisting of an organic photoelectric conversion element provided with a tandem type bulk heterojunction layer.

## DESCRIPTION OF EMBODIMENTS

Embodiments to carry out the present invention will be described in detail hereinbelow. The inventors of the present invention conducted intensive studies in view of the above-mentioned problems. As a result, it was found that, with a gas barrier film having a base, a first barrier layer formed on the surface of the base by a vapor growth method, a second barrier layer formed by a conversion treatment of a coating film formed by coating the surface of the first barrier layer with a first silicon compound, and a protective layer having no barrier property which is formed by a conversion treatment of a coating film formed by coating the surface of the second barrier layer with a second silicon compound, a gas barrier film which has a high water vapor barrier property and a high barrier performance due to improved adhesiveness between a barrier layer and a base, and also excellent bending resistance and smoothness can be achieved, thereby completing the present invention.

Further, the method for manufacturing a gas barrier film according to the present invention includes step (1) in which a first barrier layer is formed on at least one surface of a base by a vapor growth method, step (2) in which a second barrier layer is formed by a conversion treatment of a coating film formed by applying a liquid containing a first silicon compound on the first barrier layer, and step (3) in which a protective layer is formed by a conversion treatment of a coating film formed by coating the surface of the second barrier layer with a liquid containing a second silicon compound.

First, the constitution of the gas barrier film of the present invention is described by using Fig. 1. After that, each constitutional element of the gas barrier film is described. Fig. 1 is a schematic cross-sectional view illustrating an example of a layer constitution of the gas barrier film of the present invention.

In Fig. 1, a gas barrier film 1 according to the present invention has a constitution that a first barrier layer 3 formed on a base 2 by a vapor growth method, a second barrier layer 4B formed by coating and converting the first silicon compound on the first barrier layer 3, and a protective layer 4A with no barrier property formed thereon by coating

and converting the second silicon compound are laminated.

In the present invention, as a method for confirming a converted region which undergoes conversion and a non-converted region which does not undergo conversion after performing a conversion treatment of the second barrier layer 4B, it is possible that, with trimming in the depth direction of the second barrier layer 4A, successive measurements of characteristic values such as density, elastic modulus, and composition ratio (for example, ratio of "x" in $SiO_x$) are performed so as to obtain a bending point in the properties, which can be specified as an interface between a converted region and a non-converted region. Further, as the most effective method, a cross-section of the produced gas barrier film is cut out with a microtome, and the resulting extremely thin specimen is observed with a transmission electron microscope. At that time, by irradiating an electron beam during the observation, the interface between a converted region and a non-converted region will be clearly shown and, according to determination of the location of the interface, the thickness of a converted region and the thickness of a non-converted region can be easily determined. The method for determining the converted region according to observation with a transmission electron microscope will be described later in detail.

Further, from the viewpoint of improving the adhesiveness of the barrier layer, the gas barrier film according to the present invention may have an intermediate layer formed between the base and the first barrier layer. As for the intermediate layer, at least one layer of an anchor coat layer, a smooth layer, and a bleed out preventing layer is preferable. All three layers may be formed directly on the base. The order for laminating the three layers is not particularly limited. However, it is preferable that the bleed out preventing layer be formed on one surface of the base and the smooth layer be formed on the other surface. It is more preferable that the first barrier layer be laminated on the smooth layer. Furthermore, the smooth layer may be formed on both surfaces of the base.

With regard to the "gas barrier property" described in the present invention, if the water vapor permeability (water vapor permeation rate) ($60\pm0.5$°C, relative humidity of $(90\pm2)$%RH) measured according to the method of JIS K 7129-1992 is $1\times10^{-3}$ g/($m^2$·24h) or less, it is defined to have a gas barrier property. Further, it is preferable that the oxygen permeability (oxygen permeation rate) of the gas barrier film, which is measured according to the method of JIS K 7126-1987, be $1\times10^{-3}$ml/$m^2$·24h·atm or less (1 atm equals to $1.01325\times10^5$ Pa). As such, the expression "has no gas barrier property" means that the water vapor permeability (water vapor permeation rate) ($60\pm0.5$°C, relative humidity of $(90\pm2)$%RH) measured according to the method of JIS K 7129-1992 is 5 g/($cm^2$·24h) or more.

In the electronic device according to the present invention, the gas barrier film of the present invention is used. Hereinbelow, details of each constitutional element of the gas barrier film of the present invention and the method for producing each constitutional element are described.

[First barrier layer]

One characteristics of the first barrier layer according to the present invention is that it is formed by a vapor growth method. With the presence of the first barrier layer, moisture migration from the base can be prevented so that the conversion treatment at the time of forming the second barrier layer can be easily performed. Further, the first barrier layer according to the present invention is preferably formed with a metal compound by a chemical vapor deposition method or a physical vapor deposition method.

As a method for forming a thin film by a vapor growth method according to the present invention, there are roughly cited a physical vapor growth method and a chemical vapor growing method. The physical vapor growing method is a method of depositing a thin film of a target substance, for example, a carbon film, with a physical technique on a surface of a substance in a gas phase. Examples of the method include a vapor deposition method (resistance heating method, electron beam vapor deposition method, and molecular beam epitaxy method), an ion plating method, and a sputtering method. On the other hand, the chemical vapor growth method (chemical vapor deposition) is a method of supplying a raw material gas containing a target component for a thin film to be deposited as a film onto a base by a chemical reaction on a base surface or in a gas phase. In order to activate a chemical reaction, a method of generating plasma or the like is known. Further examples include a known CVD method such as a thermal CVD method, a catalytic chemical vapor growth method, a photo CVD method, a plasma CVD method, or an atmospheric pressure CVD method. In the present invention, any method can be advantageously used. Although not particularly limited thereto, from the viewpoint of film forming speed and a treatment area, a plasma CVD method is preferably applied. When the first barrier layer is formed by a chemical vapor deposition method, it is advantageous in terms of gas barrier property.

According to selection of conditions such as a metal compound as a raw starting material (also referred to as a raw material), a decomposition gas, a decomposition temperature, and applied power, a gas barrier layer obtained by a plasma CVD method or a plasma CVD method at or near the atmospheric pressure can separately produce metal carbide, metal nitride, metal oxide, metal sulfide, metal halide, and also a mixture thereof (that is, metal oxynitride, metal oxyhalide, metal carbonitride, or the like), and therefore desirable.

For example, if a silicon compound is used as a raw material compound and oxygen is used for a decomposition gas, silicon oxide will be generated. Moreover, if a zinc compound is used as a raw material compound and carbon

disulfide is used for a decomposition gas, zinc sulfide will be generated. The reason of this is as follows. In a plasma space, there exist very active charged particles and active radicals in a high density, as a result, a chemical reaction of multi-steps will be accelerated at a high speed in the plasma space to result in conversion of elements present in the plasma space into a thermodynamically stable compound in an extremely short time.

As such a raw material, as long as it has an ordinary or a transition metal element, any states of a gas, a liquid, and a solid under normal temperature and atmospheric pressure may be used. When it is a gas, it can be introduced as it is in an electric discharge space, but when it is a liquid or a solid, it is used, after making it evaporate by means such as heating, bubbling, reducing pressure, ultrasonic irradiation, or the like. Moreover, it may be used by diluting with a solvent, and organic solvents such as methanol, ethanol, and n-hexane, and a mixed solvent thereof can be used as a solvent. In addition, since these diluting solvents are decomposed into a state of a molecule or an atom during a plasma electric discharge process, their influences can be almost ignored.

However, it is preferably a compound having vapor pressure in the temperature range of 0°C to 250°C under atmospheric pressure, and more preferably a compound in a liquid state in the temperature range of 0°C to 250°C. The reason is that, as the inside of a chamber for plasma film forming is under pressure which is close to atmospheric pressure, it is difficult to send gas to the inside of a chamber for plasma film forming when the compound cannot vaporize under atmospheric pressure and also the amount of a raw material compound to be sent to the inside of a chamber for plasma film forming can be controlled with good precision when it is in a liquid state. Meanwhile, when the heat resistance of a plastic film used for film forming of a gas barrier layer is 270°C or lower, it is preferable to have a compound with vapor pressure at the temperature which is 20°C or lower below from the heat resistant temperature of the plastic film.

The metal compound as a raw material compound for a vapor growth method is not particularly limited, but examples thereof include a silicon compound, a titanium compound, a zirconium compound, an aluminum compound, a boron compound, a tin compound, and an organometallic compound.

Among them, examples of the silicon compound include silane, tetramethoxysilane, tetraethoxysilane, tetra-n-propoxysilane, tetra-iso-propoxysilane, tetra-n-butoxysilane, tetra-t-butoxysilane, dimethyldimethoxysilane, dimethyldiethoxysilane, diethyldimethoxysilane, diphenyldimethoxysilane, methyltriethoxysilane, ethyltrimethoxysilane, phenyltriethoxysilane, (3,3,3-trifluoropropyl) trimethoxysilane, hexamethyldisiloxane, bis(dimethylamino)dimethylsilane, bis(dimethylamino)methyl vinyl silane, bis(ethylamino)dimethylsilane, N,O-bis(trimethylsilyl)acetamide, bis(trimethylsilyl)carbodiimide, diethylaminotrimethylsilane, dimethylaminodimethylsilane, hexamethyldisilazane, hexamethylcyclotrisilazane, heptamethyldisilazane, nonamethyltrisilazane, octamethylcyclotetrasilazane, tetrakis dimethylaminosilane, tetraisocyanate silane, tetramethyldisilazane, tris(dimethylamino)silane, triethoxyfluorosilane, allyldimethylsilane, allyltrimethylsilane, benzyltrimethylsilane, bis(trimethylsilyl)acetylene, 1,4-bistrimethylsilyl-1,3-butadiine, di-t-butylsilane, 1,3-disilabutane, bis(trimethylsilyl)methane, cyclopentadienyltrimethyl silane, phenyldimetylsilane, phenyltrimethylsilane, propargyltrimethylsilane, tetramethylsilane, trimethylsilyl acetylene, 1-(trimethylsilyl)-1-propyne, tris(trimethylsilyl) methane, tris(trimethylsilyl)silane, vinyl trimethylsilane, hexamethyldisilane, octamethylcyclotetrasiloxane, tetramethylcyclotetrasiloxane, hexamethylcyclo-tetrasiloxane, and M silicate 51.

Examples of the titanium compound include titanium methoxide, titanium ethoxide, titanium isopropoxide, titanium tetraisopropoxide, titanium n-butoxide, titanium diisopropoxide(bis-2,4-pentanedionate), titanium diisopropoxide(bis-2,4-ethylacetoacetate), titanium di-n-butoxide(bis-2,4-pentanedionate), titanium acetylacetonate, butyl titanate dimer, and the like.

Examples of the zirconium compound include zirconium n-propoxide, zirconium n-butoxide, zirconium t-butoxide, zirconium tri-n-butoxide acetylacetonate, zirconium di-n-butoxide bisacetylacetonate, zirconium acetylacetonate, zirconium acetate, zirconium hexafluoropentanedionate, and the like.

Examples of the aluminum compound include aluminum ethoxide, aluminum triisopropoxide, aluminum isopropoxide, aluminum n-butoxide, aluminum s-butoxide, aluminum t-butoxide, aluminum acetylacetonate, triethyldialuminum tris-butoxide, and the like.

Examples of the boron compound include diborane, tetraborane, boron fluoride, boron chloride, boron bromide, borane-diethyl ether complex, borane-THF complex, borane-dimethyl sulfide complex, boron trifluoride diethyl ether complex, triethylborane, trimethoxyborane, triethoxyborane, tri(isopropoxy)borane, borazol, trimethylborazol, triethylborazol, triisopropylborazol, and the like.

Examples of the tin compound include tetraethyl tin, tetramethyl tin, diaceto-di-n-butyl tin, tetrabutyl tin, tetraoctyl tin, tetraethoxy tin, methyltriethoxy tin, diethyldiethoxy tin, triisopropylethoxy tin, diethyl tin, dimethyl tin, diisopropyl tin, dibutyl tin, diethoxy tin, dimethoxy tin, diisopropoxy tin, dibutoxy tin, tin dibutylate, tin diacetoacetonate, ethyl tin acetoacetonate, ethoxy tin acetoacetonate, dimethyl tin diacetoacetonate, and the like; a tin hydride compound and the like; and tin halides such as tin dichloride and tin tetrachloride.

Further, examples of the organometallic compound include antimony ethoxide, arsenic triethoxide, barium 2,2,6,6-tetramethylheptanedionate, beryllium acetylacetonate, bismuth hexafluoropentanedionate, dimethyl cadmium, calcium 2,2,6,6-tetramethylheptanedionate, chromium trifluoropentanedionate, cobalt acetylacetonate, copper hexafluoropentanedionate, magnesium hexafluoropentanedionate-dimethyl ether complex, gallium ethoxide, tetraethoxy

germanium, tetramethoxy germanium, hafnium t-butoxide, hafnium ethoxide, indium acetylacetonate, indium 2,6-dimethylaminoheptanedionate, ferrocene, lanthanum isopropoxide, lead acetate, tetraethyl lead, neodymium acetylacetonate, platinum hexafluoropentanedionate, trimethylcyclopentadienyl-platinum, rhodium dicarbonylacetylacetonate, strontium 2,2,6,6-tetramethylheptanedionate, tantalum methoxide, tantalum trifluoroethoxide, tellurium ethoxide, tungsten ethoxide, vanadium triisopropoxideoxide, magnesium hexafluoroacetylacetonate, zinc acetylacetonate, diethyl zinc, and the like.

Further, examples of decomposition gases for decomposing raw material gases containing these metals to obtain inorganic compounds include hydrogen gas, methane gas, acetylene gas, carbon monoxide gas, carbon dioxide gas, nitrogen gas, ammonium gas, nitrous oxide gas, nitrogen oxide gas, nitrogen dioxide gas, oxygen gas, water vapor, fluorine gas, hydrogen fluoride, trifluoroalcohol, trifluorotoluene, hydrogen sulfide, sulfur dioxide, carbon disulfide, chlorine gas, and the like. The above-described decomposition gases may also be mixed with inert gases such as argon gas and helium gas.

A desired barrier layer can be obtained by appropriately selecting a raw material gas containing a metallic element and a decomposition gas. A first barrier layer formed by a chemical vapor deposition method is preferably a metal carbide, a metal nitride, a metal oxide, a metal halide, a metal sulfide, or a composite compound thereof, from the viewpoint of transparency.

Specifically, the first barrier layer according to the present invention which is formed by a vapor growth method preferably contains at least one selected from the group consisting of silicon oxide, silicon oxynitride, and silicon nitride. It is more preferable to contain at least one selected from silicon oxide, silicon oxynitride, and silicon nitride in view of a gas barrier property and transparency. It is still more preferable to contain at least one selected from silicon oxide and silicon oxynitride. Further, it is desirable that the first barrier layer be formed substantially or entirely as an inorganic layer.

Herein, the average film thickness of the first barrier layer according to the present invention is, although not particularly limited, preferably 50 to 600 nm, and more preferably 100 to 500 nm. When the thickness is in such a range, it has a high gas barrier performance, and excellent bending resistance and cutting processing suitability.

A plasma CVD method will be specifically described below.

Fig. 2 is a schematic cross-sectional view illustrating an example of a plasma CVD apparatus which can be used in the present invention.

In Fig. 2, a plasma CVD apparatus 101 includes a vacuum tank 102 and a susceptor 105 is placed on the bottom surface side of the inside of the vacuum tank 102. A cathode electrode 103 is placed at a position, facing the susceptor 105, on the ceiling side of the inside of the vacuum tank 102. A heating medium circulating system 106, a vacuum pumping system 107, a gas introduction system 108, and a high frequency power source 109 are placed outside the vacuum tank 102.

A heating medium is placed in the heating medium circulating system 106. A heating and cooling apparatus 160 including a pump which allows a flow of the heating medium, a heating apparatus which heats the heating medium, a cooling apparatus which cools it, a temperature sensor with which the temperature of the heating medium is measured, and a memory apparatus which memorizes a set temperature for the heating medium is disposed in the heating medium circulating system 106.

The heating and cooling apparatus 160 is constituted to measure the temperature of the heating medium, to heat or cool the heating medium to the memorized set temperature, and to supply the heating medium to the susceptor 105. The supplied heating medium flows into the susceptor 105, heats or cools the susceptor 105, and returns to the heating and cooling apparatus 160. At that time, the temperature of the heating medium is higher or lower than the set temperature, and the heating and cooling apparatus 160 heats or cools the heating medium to the set temperature and supplies the heating medium to the susceptor 105. A cooling medium is circulated between the susceptor and the heating and cooling apparatus 160 in this manner and the susceptor 105 is heated or cooled by the supplied heating medium having the set temperature.

The vacuum tank 102 is connected to the vacuum pumping system 107, and, prior to starting a film formation treatment by the plasma CVD apparatus 101, the heating medium is heated to increase its temperature from room temperature to the set temperature while pre-evacuating the inside of the vacuum tank 102 and the heating medium having the set temperature is supplied to the susceptor 105. The susceptor 105 is at room temperature at the beginning of its use and the supply of the heating medium having the set temperature results in an increase in the temperature of the susceptor 105. The heating medium having the set temperature is circulated for a predetermined time and a substrate 110 as a subject for film forming is thereafter conveyed into the vacuum tank 102 while maintaining vacuum atmosphere in the vacuum tank 102 and is placed on the susceptor 105.

A large number of nozzles (pores) are formed on the surface, facing the susceptor 105, of the cathode electrode 103. The cathode electrode 103 is connected to the gas introduction system 108, and a CVD gas is sprayed from the nozzles of the cathode electrode 103 into the vacuum tank 102 with vacuum atmosphere by introducing the CVD gas from the gas introduction system 108 into the cathode electrode 103.

The cathode electrode 103 is connected to the high frequency power source 109 and the susceptor 105 and

the vacuum tank 102 are connected to a ground potential. Plasma of the introduced CVD gas is formed by supplying the CVD gas from the gas introduction system 108 into the vacuum tank 102, starting the high frequency power source 109 while supplying the heating medium having a predetermined temperature from the heating and cooling apparatus 160 to the susceptor 105, and applying a high-frequency voltage to the cathode electrode 103.

When the CVD gas activated in the plasma reaches on the surface of the substrate 110 on the susceptor 105, a thin film grows on the surface of the substrate 110. During the growth of the thin film, the thin film is formed in the state in which the heating medium having a predetermined temperature is supplied from the heating and cooling apparatus 160 to the susceptor 105 and the susceptor 105 is heated or cooled by the heating medium and maintained at a predetermined temperature. Generally, the lower limit temperature of a growth temperature at which the thin film is formed depends on the film quality of the thin film while the upper limit temperature thereof depends on the permissible range of damage to the thin film that has been already formed on the substrate 110.

The lower limit temperature and the upper limit temperature depend on the material quality of the thin film to be formed, the material quality of the thin film that has been already formed, or the like, and the lower limit temperature is 50°C and the upper limit temperature is not higher than the heat-resistant temperature of the base to secure the film quality when a SiN film or a SiON film, which is used in a high barrier film or the like, is formed.

The correlation between the film quality of the thin film formed by the plasma CVD method and a film formation temperature and the correlation between damage to an article to be film-formed (substrate 110) and the film formation temperature are predetermined. For example, during a plasma CVD process, it is preferable that the lower limit temperature of the substrate 110 be 50°C and the upper limit temperature thereof be 250°C.

Furthermore, when a high-frequency voltage of 13.56 MHz or more is applied to the cathode electrode 103 to form plasma, the relationship between the temperature of the heating medium supplied to the susceptor 105 and the temperature of the substrate 110 is premeasured and for maintaining the temperature of the substrate 110 between the lower limit temperature and the upper limit temperature during the plasma CVD process, the temperature of the heating medium supplied to the susceptor 105 is determined.

For example, it is set to memorize the lower limit temperature (50°C in this case) and to supply the heating medium, of which the temperature is controlled to the lower limit temperature or higher, to the susceptor 105. The heating medium flowing back from the susceptor 105 is heated or cooled and the heating medium having the set temperature of 50°C is supplied to the susceptor 105. For example, a mixed gas of silane gas and ammonia gas with nitrogen gas or hydrogen gas is supplied as the CVD gas to form a SiN film in the state in which the temperature of the substrate 110 is maintained at the lower limit temperature or higher and the upper limit temperature or lower.

Immediately after starting the plasma CVD apparatus 101, the susceptor 105 is at room temperature and the temperature of the heating medium flowing back from the susceptor 105 to the heating and cooling apparatus 160 is lower than the set temperature. Thus, immediately after the start, the heating and cooling apparatus 160 heats the heating medium flowing back to increase its temperature to the set temperature and supplies the heating medium to the susceptor 105. In this case, the susceptor 105 and the substrate 110 are heated by the heating medium to have increased temperature and the substrate 110 is maintained in the range of the lower limit temperature or higher and the upper limit temperature or lower.

The temperature of the susceptor 105 is increased due to heat flowing in from plasma by consecutively forming thin films on a plurality of substrates 110. In this case, the heating medium flowing back from the susceptor 105 to the heating and cooling apparatus 160 has higher temperature than the lower limit temperature (50°C) and the heating and cooling apparatus 160 therefore cools the heating medium and supplies the heating medium having the set temperature to the susceptor 105. As a result, the thin films can be formed while maintaining the substrates 110 in the range of the lower limit temperature or higher and the upper limit temperature or lower.

As described above, the heating and cooling apparatus 160 heats the heating medium in the case in which the temperature of the heating medium flowing back is lower than the set temperature and cools the heating medium in the case in which the temperature thereof is higher than the set temperature, and thus the heating medium having the set temperature is supplied to the susceptor in both cases. As a result, the substrate 110 is maintained in the temperature range of the lower limit temperature or higher and the upper limit temperature or lower.

After formation of the thin film with a predetermined film thickness, the substrate 110 is conveyed outside the vacuum tank 102, the substrate 110 on which no film has been formed is conveyed into the vacuum tank 102, and a thin film is formed while supplying the heating medium having the set temperature in the same manner as described above.

An example of the method for forming a first barrier layer by a vacuum plasma CVD method is given above, and, as the method for forming the first barrier layer, a plasma CVD method without the need for vacuum is preferred and an atmospheric pressure plasma CVD method is also preferred.

The atmospheric pressure plasma CVD method by which plasma CVD treatment is carried out near atmospheric pressure has high productivity without the need for pressure reduction as well as a high film formation rate due to a high plasma density in comparison with a plasma CVD method under vacuum, and further provides an extremely homogeneous film since the mean free step of a gas is very short at a high pressure condition under atmospheric pressure in comparison

with the conditions of an ordinary CVD method.

In the case of the atmospheric pressure plasma treatment, nitrogen gas or an element from Group 18 of the periodic table, specifically, helium, neon, argon, krypton, xenon, radon, or the like is used as a discharge gas. Among these, nitrogen, helium, and argon are preferably used, and, particularly, nitrogen is preferred also in view of the low cost.

[Step (1) for forming first barrier layer]

With regard to the method for manufacturing a gas barrier film according to the present invention, step (1) in which a first barrier layer is formed on at least one surface of a base by a vapor growth method is preferably performed by mixing raw material gas containing the aforementioned metal element and the aforementioned decomposition gas by a chemical vapor deposition method or a physical vapor deposition method.

Further, the vapor growth method of step (1) is as described in the above, and the chemical vapor deposition method by the plasma CVD, which is described in Fig. 2, is particularly preferable.

[Second barrier layer]

The second barrier layer according to the present invention is obtained by a conversion treatment of a coating film formed by applying a first silicon compound on the first barrier layer. Thus, it is preferable that a silicon compound be added to a solvent to prepare a solution containing a silicon compound and the resulting solution be coated on the first barrier layer.

Further, the average thickness of the second barrier layer according to the present invention is preferably 10 nm to 1 μm, and more preferably 10 nm to 500 nm.

The average thickness within the aforementioned range is preferred from the viewpoint of barrier performance.

As a method for coating the (first) silicon compound, any suitable wet type coating method may be adopted. Specific examples thereof include spin coating methods, roll coating methods, flow coating methods, inkjet methods, spray coating methods, printing methods, dip coating methods, flow casting film formation methods, bar coating methods, gravure printing methods, and the like. The thickness of coated film may be suitably set depending on the purpose. For example, the coated film thickness is appropriately set so that the thickness after drying is preferably around 1 nm to 100 μm, more preferably around 10 nm to 10 μm, most preferably around 10 nm to 1 μm.

(First silicon compound)

The first silicon compound according to the present invention is not particularly limited as long as the coating liquid containing the silicon compound can be prepared. However, from the viewpoint of a film formation property, a few defects such as cracking, and a small amount of residual organic matter, the first silicon compound according to the present invention preferably contains polysilazane, and more preferably polysilazane such as perhydropolysilazane or organopolysilazane; and polysiloxane such as silsesquioxane.

Examples of the first silicon compound according to the present invention include perhydropolysilazane, organopolysilazane, silsesquioxane, tetramethylsilane, trimethylmethoxysilane, dimethyldimethoxysilane, methyltrimethoxysilane, trimethylethoxysilane, dimethyldiethoxysilane, methyltriethoxysilane, tetramethoxysilane, tetramethoxysilane, hexamethyldisiloxane, hexamethyldisilazane, 1,1-dimethyl-1-silacyclobutane, trimethylvinylsilane, methoxydimethylvinylsilane, trimethoxyvinylsilane, ethyltrimethoxysilane, dimethyldivinylsilane, dimethylethoxyethynylsilane, diacetoxydimethylsilane, dimethoxymethyl-3,3,3-trifluoropropylsilane, 3,3,3-trifluoropropyltrimethoxysilane, aryltrimethoxysilane, ethoxydimethylvinylsilane, arylaminotrimethoxysilane, N-methyl-N-trimethylsilylacetamide, 3-aminopropyltrimethoxysilane, methyltrivinylsilane, diacetoxymethylvinylsilane, methyltriacetoxysilane, aryloxydimethylvinylsilane, diethylvinylsilane, butyltrimethoxysilane, 3-aminopropyldimethylethoxysilane, tetravinylsilane, triacetoxyvinylsilane, tetraacetoxysilane, 3-trifluoroacetoxypropyltrimethoxysilane, diaryldimethoxysilane, butyldimethoxyvinylsilane, trimethyl-3-vinylthiopropylsilane, phenyltrimethylsilane, dimethoxymethylphenylsilane, phenyltrimethoxysilane, 3-acryloxypropyldimethoxymethylsilane, 3-acryloxypropyltrimethoxysilane, dimethylisopentyloxyvinylsilane, 2-aryloxyethylthiomethoxytrimethylsilane, 3-glycidoxypropyltrimethoxysilane, 3-arylaminopropyltrimethoxysilane, hexyltrimethoxysilane, heptadecafluorodecyltrimethoxysilane, dimethylethoxyphenylsilane, benzoyloxytrimethylsilane, 3-methacryloxypropyldimethoxymethylsilane, 3-methacryloxypropyltrimethoxysilane, 3-isocyanatepropyltriethoxysilane, dimethylethoxy-3-glycidoxypropylsilane, dibutoxydimethylsilane, 3-butylaminopropyltrimethylsilane, 3-dimethylaminopropyldiethoxymethylsilane, 2-(2-aminoethylthioethyl)triethoxysilane, bis(butylamino)dimethylsilane, divinylmethylphenylsilane, diacetoxymethylphenylsilane, dimethyl-p-tolylvinylsilane, p-styryltrimethoxysilane, diethylmethylphenylsilane, benzyldimethylethoxysilane, diethoxymethylphenylsilane, decylmethyldimethoxysilane, diethoxy-3-glycidoxypropyplmethylsilane, octyloxytrimethylsilane, phenyltrivinylsilane, tetraaryloxysilane, dodecyltrimethylsilane, diarylmethylphenylsilane, diphenylmethylvinylsilane, diphenylethoxymethylsilane, diacetoxydiphenylsilane, dibenzyldimethylsilane, diaryldiphenylsilane, octadecyltrimethylsilane, methyloctadecyldimethylsilane, docosylmethyldimethylsilane, 1,3-divinyl-1,1,3,3-tetramethyldisiloxane, 1,3-divinyl-1,1,3,3-tetramethyldisilazane, 1,4-bis(dimethylvinylsilyl)benzene, 1,3-bis(3-acetoxypropyl)tetramethyldisiloxane, 1,3,5-trimethyl-1,3,5-trivinylcyclotrisiloxane, 1,3,5-tris(3,3,3-trifluoropropyl)-1,3,5-trimethylcyclotrisiloxane, octamethylcyclotetrasiloxane, 1,3,5,7-tetraethoxy-1,3,5,7-tetramethylcyclotetrasiloxane, and decamethylcyclopentasiloxane.

Examples of the silsesquioxane include Q8 series manufactured by Mayaterials, Inc., that is, Octakis(tetramethylammonium)pentacyclo-octasiloxane-octakis(yloxide)hydrate; Octa(tetramethylammonium)silsesquioxane, Octakis(dimethylsiloxy)octasilsesquioxane, Octa[[3-[(3-ethyl-3-oxetanyl)methoxy]propyl]dimethylsiloxy]octasilsesquioxane; Octaallyloxetane silsesquioxane, Octa[(3-propylglycidylether)dimethylsiloxy]silsesquioxane; Octakis[[3-(2,3-epoxypropoxy)propyl]dimethylsiloxy]octasilsesquioxane, Octakis[[2-(3,4-epoxycyclohexyl)ethyl]dimethylsiloxy]octasilsesquioxane, Octakis[2-(vinyl)dimethylsiloxy]silsesquioxane; Octakis(dimethylvinylsiloxy)octasilsesquioxane, Octakis[(3-hydroxypropyl)dimethylsiloxy]octasilsesquioxane, Octa[(methacryloylpropyl)dimethylsilyloxy]silsesquioxane, Octakis[(3-methacryloxypropyl)dimethylsiloxy]octasilsesquioxane, and hydrogenated silsesquioxane containing no organic group.

Among them, inorganic silicon compounds are particularly preferred and inorganic silicon compounds which are solid at normal temperature are more preferred. Perhydropolysilazane, hydrogenated silsesquioxane, and the like are more preferably used.

"Polysilazane", which is a polymer having a silicon-nitrogen bond, is a ceramic precursor inorganic polymer consisting of Si-N, Si-H, N-H, or the like, such as $SiO_2$, $Si_3N_4$, or an intermediate solid solution $SiO_xN_y$ therebetween.

For coating to prevent a film base from being damaged, a compound that is ceramized and converted into silica at a relatively low temperature (low-temperature ceramized polysilazane) is preferred, and, for example, a compound having a main skeleton having a unit represented by the following general formula (1) described in Japanese Patent Application Laid-Open No. 8-112879 is preferred.

[Chem. 1]

General formula (1)

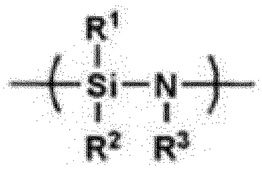

In the above-described general formula (1), $R^1$, $R^2$, and $R^3$ each independently represent a hydrogen atom, an alkyl group (an alkyl group preferably having 1 to 30 carbon atoms, more preferably having 1 to 20 carbon atoms), an alkenyl group (preferably an alkenyl group having 2 to 20 carbon atoms), a cycloalkyl group (preferably a cycloalkyl group having 3 to 10 carbon atoms), an aryl group (preferably an aryl group having 6 to 30 carbon atoms), a silyl group (silyl group preferably having 3 to 20 carbon atoms), an alkylamino group (preferably an alkylamino group having 1 to 40 carbon atoms, more preferably 1 to 20 carbon atoms), or an alkoxy group (preferably an alkoxy group having 1 to 30 carbon atoms). However, it is preferable that at least one of $R^1$, $R^2$, and $R^3$ be a hydrogen atom.

The alkyl group in $R^1$, $R^2$, and $R^3$ described above is a straight-chain or branched-chain alkyl group. Specific examples of the alkyl group having 1 to 30 carbon atoms include a methyl group, an ethyl group, an n-propyl group, an isopropyl group, an n-butyl group, an isobutyl group, a sec-butyl group, a tert-butyl group, an n-pentyl group, an isopentyl group, a tert-pentyl group, a neopentyl group, a 1,2-dimethylpropyl group, an n-hexyl group, an isohexyl group, a 1,3-dimethylbutyl group, a 1-isopropylpropyl group, a 1,2-dimethylbutyl group, an n-heptyl group, a 1,4-dimethylpentyl group, a 3-ethylpentyl group, a 2-methyl-1-isopropyl propyl group, a 1-ethyl-3-methylbutyl group, an n-octyl group, a 2-ethylhexy group, a 3-methyl-1-isopropylbutyl group, a 2-methyl-1-isopropyl group, a 1-t-butyl-2-methylpropyl group, an n-nonyl group, a 3,5,5-trimethylhexyl group, an n-decyl group, an isodecyl group, an n-undecyl group, a 1-methyldecyl group, an n-dodecyl group, an n-tridecyl group, an n-tetradecyl group, an n-pentadecyl group, an n-hexadecyl group, an n-heptadecyl group, an n-octadecyl group, an n-nonadecyl group, an n-eicosyl group, an n-heneicosyl group, an n-docosyl group, an n-tricosyl group, an n-tetracosyl group, an n-pentacosyl group, an n-hexacosyl group, an n-heptacosyl group, an n-octacosyl group, and an n-triacontyl group, and the like.

Examples of the alkenyl group having 2 to 20 carbon atoms include a vinyl group, a 1-propenyl group, an allyl group, an isopropenyl group, a 1-butenyl group, a 2-butenyl group, a 1-pentenyl group, and a 2-pentenyl group.

Examples of the cycloalkyl group having 3 to 10 carbon atoms include a cyclopropyl group, a cyclobutyl group, a cyclopentyl group, a cyclohexyl group, a cycloheptyl group, a cyclooctyl group, a cyclononyl group, and a cyclodecyl

group.

Examples of the aryl group having 6 to 30 carbon atoms include, but are not particularly limited to, non-fused hydrocarbon groups such as a phenyl group, a biphenyl group, and a terphenyl group; and fused polycyclic hydrocarbon groups such as a pentalenyl group, an indenyl group, a naphthyl group, an azulenyl group, a heptalenyl group, a biphenylenyl group, a fluorenyl group, an acenaphthylenyl group, a pleiadenyl group, an acenaphthenyl group, a phenalenyl group, a phenanthryl group, an anthryl group, a fluoranethenyl group, an acephenanthrylenyl group, an aceanthrylenyl group, a triphenylenyl group, a pyrenyl group, a chrysenyl group, and a naphthacenyl group.

Examples of the silyl group having 3 to 20 carbon atoms include alkyl/arylsilyl groups and specific examples thereof include a trimethylsilyl group, a triethylsilyl group, a triisopropylsilyl group, a t-butyldimethylsilyl group, a methyldiphenylsilyl group, and a t-butyldiphenylsilyl group.

Examples of the alkylamino group having 1 to 40 carbon atoms include, but are not particularly limited to, a dimethylamino group, a diethylamino group, a diisopropylamino group, a methyl-tert-butylamino group, a dioctylamino group, a didecylamino group, a dihexadecylamino group, a di-2-ethylhexylamino group, and a di-2-hexyldecylamino group.

Examples of the alkoxy group having 1 to 30 carbon atoms include a methoxy group, an ethoxy group, a propoxy group, an isopropoxy group, a butoxy group, a pentyloxy group, a hexyloxy group, a 2-ethylhexyloxy group, an octyloxy group, a nonyloxy group, a decyloxy group, an undecyloxy group, a dodecyloxy group, a tridecyloxy group, a tetradecyloxy group, a pentadecyloxy group, a hexadecyloxy group, a heptadecyloxy group, an octadecyloxy group, a nonadecyloxy group, an eicosyloxy group, a heneicosyloxy group, a docosyloxy group, a tricosyloxy group, a tetracosyloxy group, a pentacosyloxy group, a hexacosyloxy group, a heptacosyloxy group, an octacosyloxy group, and a triacontyloxy group.

In accordance with the present invention, for the polysilazane according to the present invention, the perhydropolysilazane in which all of $R^1$, $R^2$, and $R^3$ in the general formula (1) are hydrogen atoms is particularly preferred from the viewpoint of density as a gas barrier film to be obtained.

The compound having the main skeleton having the unit represented by the above-described general formula (1) preferably has a number average molecular weight of 100 to 50000. The number average molecular weight can be measured by gel permeation chromatograph (GPC).

Meanwhile, organopolysilazane in which a part of a hydrogen atom moiety bound to Si thereof is substituted by an alkyl group or the like has an advantage that adhesion with the base which is an undercoat is improved and a hard and fragile ceramic film formed by polysilazane can be provided with toughness by having an alkyl group such as a methyl group to inhibit a crack from being generated even in the case of a greater (average) film thickness. These perhydropolysilazane and organopolysilazane may be appropriately selected or mixed and used, depending on the application.

Perhydropolysilazanes are estimated to have a structure in which a straight-chain structure and a ring structure of six- and eight-membered rings at the center are present. As for the molecular weight thereof, they have a number average molecular weight (Mn) of around 600 to 2000 (in terms of polystyrene), and there are a liquid or solid substance, and the state of which varies depends on the molecular weight. They are marketed in the state of solutions in which they are dissolved in organic solvents and the commercially available products can be used as polysilazane-containing coating liquids without being processed.

Other examples of polysilazanes ceramized at a low temperature include a silicon alkoxide-added polysilazane obtained by reacting the polysilazane having the main skeleton having the unit represented by the above-described general formula (1) with silicon alkoxide (for example, see Japanese Patent Application Laid-Open No. 5-238827), a glycidol-added polysilazane obtained by reaction with glycidol (for example, see Japanese Patent Application Laid-Open No. 6-122852), an alcohol-added polysilazane obtained by reaction with alcohol (for example, see Japanese Patent Application Laid-Open No. 6-240208), a metal carboxylate-added polysilazane obtained by reaction with a metal carboxylate (for example, see Japanese Patent Application Laid-Open No. 6-299118), an acetylacetonato complex-added polysilazane obtained by reaction with an acetylacetonato complex containing a metal (see Japanese Patent Application Laid-Open No. 6-306329), a metallic fine particles-added polysilazane obtained by adding metallic fine particles (for example, see Japanese Patent Application Laid-Open No. 7-196986), and the like. Alternatively, a commercially available product may also be used as a polysilazane.

It is not preferable to use such an alcohol-based organic solvent or an organic solvent containing water, since they easily react with the first silicon compound (for example, polysilazane), as an organic solvent which can be used to prepare a solution containing the first silicon compound according to the present invention. Thus, hydrocarbon solvents such as aliphatic hydrocarbons, alicyclic hydrocarbons, and aromatic hydrocarbons; halogenated hydrocarbon solvents; and ethers such as aliphatic ethers and alicyclic ethers can be specifically used. Specifically, there are hydrocarbons such as pentane, hexane, cyclohexane, toluene, xylene, solvesso, and turpentine; halogen hydrocarbons such as methylene chloride and trichloroethane; ethers such as dibutyl ether, dioxane, and tetrahydrofuran; and the like. These organic solvents may be selected depending on properties such as solubility of polysilazane and rates of evaporation of organic solvents and a plurality of organic solvents may be mixed.

The concentration of polysilazane in the polysilazane-containing coating liquid according to the present invention varies depending on the film thickness of the second barrier layer of target and the pot life of the coating liquid. However, it is preferably around 0.2 to 35% by mass.
Amine or a metal catalyst may also be added into the polysilazane-containing coating liquid in order to promote conversion into a silicon oxide compound. Specifically, this include AQUAMICA manufactured by AZ Electronic Materials Co. NAX120-20, NN110, NN310, NN320, NL110A, NL120A, NL150A, NP110, NP140, SP140, and the like.

<Conversion treatment>

In the second barrier layer according to the present invention, the conversion treatment of a coating film formed by applying the first silicon compound refers to a reaction of converting the (first) silicon compound into silicon oxide or silicon oxynitride, and specifically, to the treatment of forming an inorganic thin film with a level at which the gas barrier film of the present invention can contribute to expression of a gas barrier property (a water vapor transmission rate of $1 \times 10^{-3}$ g/(m$^2$·24h) or less) as a whole. For the reaction of converting the (first) silicon compound into silicon oxide or silicon oxynitride, a known method based on the conversion reaction of the second barrier layer can be selected. The formation of a silicon oxide film or a silicon oxynitride layer by a substitution reaction of the silicon compound requires a high temperature of 450°C or higher and it is difficult to be adopted in a flexible base of plastic or the like.
Accordingly, a conversion reaction using plasma, ozone, or ultraviolet ray with which the conversion reaction is possible at lower temperature is preferred for producing the gas barrier film of the present invention, from the viewpoint of adaptation to a plastic substrate. For example, the conversion treatment according to the present invention is preferably at least one selected from a group consisting of a plasma treatment, a heating treatment, and ultraviolet ray irradiation (including a vacuum ultraviolet ray irradiation treatment).

<Plasma treatment>

In the present invention, a known method can be used as a plasma treatment which can be used as the conversion treatment, and the above-mentioned atmospheric pressure plasma treatment and the like may be preferably exemplified.

<Heating treatment>

The conversion treatment can be carried out by heating treatment of a coating film containing the (first) silicon compound in combination with an excimer irradiation treatment described below or the like.
As the heating treatment, for example, a method of bringing a substrate into contact with a heat generator such as a heating block and heating a coating film by heat conduction, a method of heating atmosphere by an external heater with a resistance wire or the like, a method of using light in the infrared region with, for example, an IR heater, and the like are included, but the treatment is not particularly limited. A method capable of maintaining the smoothness of a coating film containing a silicon compound may be selected appropriately.
It is preferable to appropriately adjust the temperature of a coating film during the heating treatment in the range of 50°C to 250°C, and more preferably in the range of 100°C to 200°C.
Further, the heating time is preferably in the range of 1 second to 10 hours, and more preferably in the range of 10 seconds to 1 hour.
In the present invention, a layer (second barrier layer) itself formed from a coating film containing a silicon compound preferably expresses a gas barrier property (water vapor transmission rate of $1 \times 10^{-3}$ g/(m$^2$·24h) or less) and an excimer light treatment described below is particularly preferred as a conversion means for obtaining such a second barrier layer.

<Ultraviolet ray irradiation treatment>

In accordance with the present invention, the treatment by ultraviolet ray irradiation is also preferred as one of conversion treatment methods. Ozone or an active oxygen atom generated by ultraviolet ray (synonymous with ultraviolet light) has a high oxidation capacity and can form a silicon oxide film or a silicon oxynitride film having high density and an insulation property at a low temperature.
By this ultraviolet ray irradiation, the base is heated to excite and activate $O_2$ and $H_2O$, contributing to ceramization (silica conversion), an ultraviolet ray absorber, and polysilazane itself. As a result, the ceramization of the polysilazane is promoted and further densification of a ceramic film to be obtained is achieved. The ultraviolet ray irradiation is effectively carried out at any time as long as it is carried out after the formation of a coating film.
In the method according to the present invention, any commonly used apparatus for generating ultraviolet ray

can be used.

The ultraviolet ray as described herein generally refers to electromagnetic waves having a wavelength of 10 to 400 nm, and ultraviolet ray of 210 to 375 nm is preferably used in the case of an ultraviolet ray irradiation treatment other than the vacuum ultraviolet ray (10 to 200 nm) treatment described below.

For irradiation with ultraviolet ray, it is preferable to set irradiation intensity and irradiation time in the range in which the base supporting the second barrier layer to be irradiated is not damaged.

When the case of using a plastic film as the base is taken as an example, for example, a distance between the base and an ultraviolet ray irradiation lamp can be set, so that intensity on a base surface is 20 to 300 $mW/cm^2$, preferably 50 to 200 $mW/cm^2$, to perform irradiation for 0.1 second to 10 minutes using the lamp with 2 kW (80 W/cm $\times$ 25 cm).

Generally, when the temperature of the base during ultraviolet ray irradiation treatment is 150°C or higher, deterioration in the property of the base, such as deformation of the base or reduction in its strength, occurs in the case of a plastic film or the like. However, a conversion treatment at a higher temperature is possible in the case of a film with high heat resistance such as polyimide or a substrate with a metal or the like. Accordingly, the temperature of the base during the ultraviolet ray irradiation has no general upper limit and can be appropriately set by those skilled in the art depending on the kind of the base. Further, atmosphere for ultraviolet ray irradiation is not particularly limited and it may be carried out in the air.

Examples of a means for generating ultraviolet ray include, but are not limited to, metal halide lamps, high-pressure mercury lamps, low-pressure mercury vapor lamps, xenon arc lamps, carbon arc lamps, excimer lamps (single wavelength of 172 nm, 222 nm, or 308 nm; for example, manufactured by Ushio Inc.), UV light lasers, and the like. Further, when the second barrier layer is irradiated with generated ultraviolet ray, the ultraviolet ray from a generation source is desirably reflected by a reflecting plate and applied on the second barrier layer from the viewpoint of achieving improvement in efficiency and uniform irradiation.

The ultraviolet ray irradiation may be adapted to a batch treatment or a consecutive treatment and may be appropriately selected depending on the shape of the base used. For example, in the case of the batch treatment, the base (for example, silicon wafer) having the second barrier layer on the surface thereof can be treated with an ultraviolet ray baking furnace including such an ultraviolet ray generation source as described above. The ultraviolet ray baking furnace itself is generally known, and for example, an ultraviolet ray baking furnace manufactured by Eye Graphics Co., Ltd. may be used. Further, when the base having the second barrier layer on the surface thereof has a long film shape, it can be ceramized by being consecutively irradiated with ultraviolet ray in a drying zone including such an ultraviolet ray generation source as described above while conveying it. The time required for the ultraviolet ray irradiation, which depends on the base used and the composition and concentration of the second barrier layer, is generally 0.1 second to 10 minutes, preferably 0.5 second to 3 minutes.

<Vacuum ultraviolet ray irradiation treatment: Excimer irradiation treatment>

In accordance with the present invention, the most preferred conversion treatment method is a treatment by vacuum ultraviolet ray irradiation (excimer irradiation treatment). The conversion treatment by the vacuum ultraviolet ray irradiation is suitably selected depending on the kind of the silicon compound for forming the second barrier layer. However, when it is used for a coating film containing the first silicon compound which has been exemplified above, it is preferable that the second barrier layer be formed by a conversion treatment of performing irradiation with vacuum ultraviolet ray which has a wavelength component of 180 nm or less. Further, for example, when the first silicon compound is polysilazane, it is a method for forming a silicon oxide film at a relatively low temperature (about 200°C or lower) by making an oxidation reaction proceed by active oxygen or ozone while directly cutting an atomic bond by the action of only a photon, called a light quantum process, preferably with use of the energy of light of 100 to 200 nm, higher than interatomic bonding force in a polysilazane compound, more preferably with use of the energy of light with a wavelength of 100 to 180 nm. Meanwhile, it is preferable to perform a heating treatment together as mentioned above when the excimer irradiation treatment is carried out, and the details of heating treatment conditions in that case are as mentioned above.

As a vacuum ultraviolet light source necessary therefor, a noble gas excimer lamp is preferably used.

A noble gas atom such as Xe, Kr, Ar, or Ne does not chemically bind to make a molecule and is therefore referred to as an inert gas. However, a noble gas atom (excited atom) gaining energy by discharge and the like can bind to another atom to make a molecule. When the noble gas is xenon,

$$e + Xe \rightarrow e + Xe^{*}$$

$$Xe^{*} + Xe + Xe \rightarrow Xe_2^{*} + Xe$$

are established, and excimer light of 172 nm is emitted when transition of $Xe_2$*, which is an excited excimer molecule, to a ground state occurs.

Characteristics of the excimer lamp include high efficiency due to concentration of emission on one wavelength to cause almost no emission of light other than necessary light. Further, the temperature of a target object can be kept low since surplus light is not emitted. Furthermore, instant lighting and flashing are possible since the time is not required for starting/restarting.

A method of using dielectric barrier discharge is known to obtain excimer light emission. The dielectric barrier discharge is very thin discharge called micro discharge similar to lightning, generated in the gas space, which is disposed between both electrodes via a dielectric (transparent quartz in the case of the excimer lamp), by applying a high frequency and a high voltage of several tens of kHz to the electrodes, and, when a streamer of the micro discharge reaches a tube wall (dielectric), a dielectric surface is charged and the micro discharge therefore becomes extinct. It is discharge in which the micro discharge spreads over the whole tube wall and generation and extinction thereof are repeated. Therefore, light flicker which can be recognized even by the naked eye occurs. Since a streamer at a very high temperature locally and directly reaches the tube wall, deterioration in the tube wall may also be accelerated.

For a method of efficiently obtaining excimer light emission, electrodeless electric field discharge is also possible other than the dielectric barrier discharge.

It is electrodeless electric field discharge by capacitive coupling and is also sometimes called RF discharge. Although a lamp, electrodes, and arrangement thereof may be basically the same as those in the dielectric barrier discharge, a high frequency applied between both electrodes illuminates at several of MHz. In the electrodeless electric field discharge, discharge uniform in terms of space and time is obtained as described above and a long-lasting lamp without flicker is therefore obtained.

In the case of the dielectric barrier discharge, since micro discharge occurs only between the electrodes, the outside electrode must cover the whole external surface and have a material, through which light passes, for extracting light to the outside, in order to cause discharge in the whole discharge space. Therefore, the electrode in which thin metal wires are reticulated is used. This electrode is easily damaged by ozone or the like generated by vacuum ultraviolet ray in oxygen atmosphere since wires which are as thin as possible are used so as not to block light.

For preventing this, it is necessary to make the periphery of the lamp, that is, the inside of an irradiation apparatus have an inert gas atmosphere such as nitrogen and to dispose a window with synthetic quartz to extract irradiated light. The window with synthetic quartz is not only an expensive expendable product but also causes the loss of light.

Since a double cylinder type lamp has an outer diameter of around 25 mm, a difference in the distances between an irradiated surface just under a lamp axis and the side surface of the lamp is not negligible, and it causes a large difference in illuminance. Accordingly, even if such lamps are closely arranged, no uniform illumination distribution is obtained. The irradiation apparatus provided with the window with synthetic quartz enables equal distances in an oxygen atmosphere and provides a uniform illumination distribution.

It is not necessary to reticulate an external electrode when the electrodeless electric field discharge is used. Only by disposing the external electrode on a part of the external surface of the lamp, glow discharge spreads over the whole discharge space. For the external electrode, an electrode which serves also as a light reflecting plate typically made of an aluminum block is used on the back surface of the lamp. However, since the outer diameter of the lamp is large as in the case of the dielectric barrier discharge, synthetic quartz is required for having a uniform illumination distribution.

The biggest characteristic of a narrow tube excimer lamp is a simple structure. Both ends of a quartz tube are closed only to seal a gas for excimer light emission therein. Accordingly, a quite inexpensive light source can be provided.

The double cylinder type lamp is easily damaged during handling or transportation in comparison with the narrow tube lamp since processing of connection and closing of both ends of its inner and outer tube is carried out. The tube of the narrow tube lamp has an outer diameter of around 6 to 12 mm, and a high voltage is needed for starting when it is too thick.

As discharge form, any of the dielectric barrier discharge and the electrodeless electric field discharge can be used. As for the shape of the electrode, a surface contacting the lamp may be planar; however, the lamp can be well fixed and the electrode closely contacts the lamp to have more stabilized discharge by the shape fitting with the curved surface of the lamp. Further, a light reflecting plate can be also made when the curved surface is made to be a specular surface with aluminum.

A Xe excimer lamp is excellent in luminous efficiency since an ultraviolet ray with a short wavelength of 172 nm is radiated at a single wavelength. This light enables generation of a high concentration of a radical oxygen atomic species or ozone with a very small amount of oxygen because of having a high oxygen absorption coefficient. Further,

the energy of light with a short wavelength of 172 nm which dissociates the bond of an organic matter is known to have a high activity. Conversion of a polysilazane film can be realized in a short time by the high energy of this active oxygen or ozone and ultraviolet radiation. Accordingly, shortening of process time and reduction in the area of a facility, caused by a high throughput, and irradiation of an organic material, a plastic substrate, or the like, which is easily damaged by heat, are enabled in comparison with the low-pressure mercury vapor lamp which emits wavelengths of 185 nm and 254 nm or plasma cleaning.

The excimer lamp can be made to illuminate by input of a low power because of having high light generation efficiency. Further, it does not emit light with a long wavelength which becomes a cause for increasing temperature due to light but irradiates energy with a single wavelength in an ultraviolet range, and therefore has a characteristic of capable of suppressing an increase in the surface temperature of an article to be irradiated. Therefore, it is suitable for a flexible film material such as polyethylene terephthalate which is considered to be easily affected by heat.

(Determination of converted region in second barrier layer)

The second barrier layer according to the present invention is obtained by, after forming a coating film having the first silicon compound on the first barrier layer, performing a conversion treatment by using a means L for conversion treatment, for example, irradiation with vacuum ultraviolet ray having a wavelength component of 180 nm or less from the upper region as described above. Within the second barrier layer which received the conversion treatment, the conversion progresses on the surface side of the means L for conversion treatment while the conversion does not progress or does not occur at the first barrier layer side. As a result, a converted region in which the conversion occurs and a non-converted region in which no conversion occurs are formed within the layer. In other words, the second barrier layer according to the present invention is heterogeneous in the film thickness direction, and when the second barrier layer is formed from a coating film containing polysilazane, for example, a polysilazane region cross-linked with a high density (that is, converted region) is formed near the surface layer but the region from the surface layer to the first barrier layer side in the depth direction contains little amount of cross-linked polysilazane (that is, non-converted region). It is also confirmed from the graph, which is Fig. 1 of Japanese Patent Application Laid-Open No. 2012-16854, in which an atomic ratio (composition) in the film thickness direction is calculated based on XPS measurement of a gas barrier film. Specifically, when polysilazane coating is performed according to the conditions described in the literature and it is converted into a barrier layer by a conversion treatment by irradiation with an excimer lamp, the O/Si ratio is in the range of from 2.2 (surface) to 1.6 or so at a position corresponding to 5% of the entire barrier layer thickness from the surface of the barrier layer (that is, at a position which is 7.5 nm from the surface), and at a position corresponding to 95% of the thickness from the base side, it is shown to be in the range of from 1.6 (maximum value) to 0.7 (minimum value). Further, in the range of from about 0 to 110 μm in the depth direction of the barrier layer, the N/Si ratio is 0.7 at maximum. However, it is found that the N/Si ratio dramatically decreases in a region closer to the base (that is, 110 μm to 150 μm).

In the second barrier layer according to the present invention, when polysilazane is coated as the first silicon compound, the conversion rate of the entire layer is preferably 10 to 50% or so.

In a preferred embodiment of the present invention, the second barrier layer 4B has a low converted region (non-converted region) at the side of a base 2 and a high converted region (converted region) at a surface side. The converted region formed by a conversion treatment can be confirmed with a various kinds of methods. The most effective method is confirmation by observation with a transmission electron microscope (TEM) for a cross-section of the second barrier layer after being subjected to the conversion treatment.

<Cross-section TEM observation>

Cross-section TEM observation is performed after preparing a thin specimen of the gas barrier film of the present invention with a FIB processing apparatus described below. Here, when an electron beam is continuously irradiated to the sample, a contrasting difference appears to be present between a portion receiving damage by an electron beam and a portion without receiving damage. The converted region according to the present invention is made densely by a conversion treatment and it hardly receives damage by an electron beam, while the non-converted region receives damage by an electron beam and quality deterioration will be recognized. By the confirmation of the cross-section TEM observation, it is possible to calculate the film thickness of the converted region and the non-converted region.

(FIB processing)

Apparatus: SMI 2050 manufactured by SII
Processing ion: (Ga 30 kV)

Sample thickness: 100 nm to 200 nm
(TEM observation)
Apparatus: JEM 2000FX manufactured by JEOL Ltd. (accelerating voltage: 200 kV)
Electron beam irradiation time: 5 seconds to 60 seconds

The film thickness of the converted region which is estimated in such a manner is, in terms of the ratio of the film thickness compared to the thickness of the second barrier layer 4B, preferably 0.2 or more and 0.9 or less. It is more preferably 0.3 or more and 0.9 or less, and more preferably 0.4 or more and 0.8 or less. Since the barrier performance and bending property of the second barrier layer are improved in the case in which the film thickness of the converted region based on the total film thickness of the second barrier layer 4A is 0.2 or more and the barrier performance and the bending property are improved in the case of 0.9 or less, both cases are preferred.
As described in accordance with the present invention, breaking (cracking) due to stress concentration is prevented and both of a high barrier property and a stress relaxation function can be achieved by setting a ratio of the converted region in the second barrier layer in the range defined as described above in the gas barrier layer obtained by subjecting the second barrier layer to a conversion treatment. Particularly, it is preferable that an effect of the present invention be significantly exhibited since the surface treatment can be efficiently carried out with vacuum ultraviolet ray in a short time by adopting vacuum ultraviolet treatment as a conversion treatment method.

<Film density of second barrier layer>

In the present invention, the first barrier layer is preferably formed with a film containing silicon oxide, silicon nitride, or a silicon oxynitride compound, and the film density d1 of a converted region on a treated surface of the second barrier layer and the film density d2 of a non-converted region which has not been converted can be obtained according to the following method.

(Measurement of X ray reflection ratio of film density distribution)

· An X ray reflection ratio measuring apparatus: Thin film structure evaluation apparatus ATX-G manufactured by Rigaku Corporation
· X ray source target: Copper (1.2 kW)
· Measurement: an X ray reflection ratio curve is measured using a 4 crystal monochromatic meter to produce a model of a density distribution profile, and then fitting is carried out to obtain a density distribution in a film thickness direction.

In the present invention, the numerical order of the aforementioned film density d1 and d2 preferably satisfies the relationship of d1 > d2.
In the second barrier layer according to a preferred embodiment of the present invention, a converted region exists, and the converted region has the following characteristics.

1) From the second barrier layer according to the present invention, no clear interface which distinguishes the regions having a different property is observed by an observation of a dislocation line using the super-high resolving TEM (Transmission Electron Microscope) of the cross-section.
Meanwhile, if it is intended to laminate regions having a different property with a vapor deposition method, it will be certainly produced an interface from the nature of the method. Due to the minute non-uniformity which occurs at the interface, there will appear dislocation lines, such as spiral transposition and edge-like transposition, at the time of deposition of the gaseous phase molecule in the lamination direction, and they are observed by the super-high resolving TEM.
Since the second barrier layer according to a preferred embodiment of the present invention is subjected to a conversion treatment for a coated film, it is presumed that regions having a different property can be formed without interface and without producing dislocation lines which are easily produced at the time of deposition of the gaseous phase molecule.
2) In the second barrier layer according to a preferred embodiment of the present invention, a high-density region is formed in the converted region. When an atomic distance of Si-O in the high-density region is measured with FT-IR analysis in the depth direction, it is possible to identify a fine-crystalline region and also possible to identify existence of a crystal region in the highest-density region.

Usually, $SiO_2$ is observed to be crystallized by a heating treatment at 1000°C or higher. On the other hand, $SiO_2$ in a surface region of a second barrier layer of the present invention can be crystallized even by a heating treatment at a low temperature of 200°C or lower on a resin base. A clear reason for this is not found. The present inventors assumed as follows. A 3 to 5 ring structure contained in polysilazane has a favorable atomic distance for forming a crystal structure. Thus, it is not required a dissolution, rearrangement and crystallization process usually occurred at a temperature of 1000°C or higher. A conversion treatment already contributes to the short distance order, and it can achieve structure ordering with less energy. Especially, in an irradiation treatment with vacuum ultraviolet ray, it is preferable to perform breaking of chemical bond such as Si-OH with an irradiation treatment with vacuum ultraviolet ray in combination with an oxidation treatment by ozone generated in the irradiation space. This combination is preferable to have an effective processing.

Particularly, in the conversion treatment of the second barrier layer of a preferred embodiment of the present invention, it is most preferable to perform a conversion treatment by irradiation with vacuum ultraviolet ray to form a converted region. Although the mechanism of forming this converted region has not been evident, the present inventors presume that direct breaking of a silazane compound by photo energy and surface oxidation reaction by an activated oxygen or ozone generated in the gas phase proceed simultaneously to result in converting speed difference of the conversion treatment at a surface side and an inner side. As a result, a converted region is formed. Further, as a means to control actively the converting speed difference of the conversion treatment, a method of controlling the surface oxidation reaction by an activated oxygen or ozone generated in the gas phase can be considered. Namely, by changing the condition of the elements which contribute the surface oxidation reaction, such as oxygen concentration, a treatment temperature, a humidity, irradiation distance and irradiation time, during the irradiation, a desired composition, film thickness, and density of the converted region can be obtained. Especially, it is preferable to have a mode in which the condition of oxygen concentration is varied during the irradiation. A nitrogen concentration of a surface side can be reduced by increasing the oxygen concentration in conjunction with the change of conditions so as to have an increase in the film thickness.

As for the conditions for conversion, it can be selected from the following range, for example, in the case of a second barrier layer having a thickness of 10 to 1000 nm: luminous intensity of vacuum ultraviolet ray of 10 to 200 $mJ/cm^2$, irradiation distance of 0.1 to 10 mm, oxygen concentration of 0 to 5%, dew point of 10 to -50°C, a temperature of 25 to 200°C, and treatment time of 0.1 to 150 sec. The temperature is preferably 50 to 200°C, and more preferably 70 to 200°C.

Meanwhile, higher irradiation intensity results in an increased probability of a collision between a photon and a chemical bond in polysilazane and also enables time of conversion reaction to be shortened. Further, since the number of photons entering into the inside is also increased, the thickness of the converted film can also be increased and/or film quality can be enhanced (densification). However, when irradiation time is too long, flatness may be deteriorated or a material other than the barrier film may be damaged. Although the degree of proceeding of reaction is generally considered based on an accumulated amount of light, represented by the product of irradiation intensity and irradiation time, the absolute value of irradiation intensity may also become important in the case of a material having the same composition but various structural forms, like silicon oxide.

Accordingly, in accordance with the present invention, it is preferable to carry out the conversion treatment of applying the maximum irradiation intensity of 100 to 200 $mW/cm^2$ at least once in the vacuum ultraviolet ray irradiation step. The treatment time can be shortened without sharply deteriorating conversion efficiency by having 100 $mW/cm^2$ or more. Further, by having 200 $mW/cm^2$ or less, gas barrier performance can be efficiently kept (increase in gas barrier property is slowed down even by irradiation at more than 200 $mW/cm^2$), and thus not only damage to a substrate but also damage to other members of a lamp and a lamp unit can be suppressed, and the life of the lamp itself can also be prolonged.

Further, when the second barrier layer according to the present invention is subjected to a conversion treatment by using vacuum ultraviolet ray, the accumulated light amount of the vacuum ultraviolet ray is preferably 1000 $mJ/cm^2$ or more and 10000 $mJ/cm^2$ or less.

The accumulated light amount of the vacuum ultraviolet ray in the range of 1000 to 10000 $mJ/cm^2$ or less is preferable from the viewpoint of barrier performance and productivity.

<Surface roughness of second barrier layer: Smoothness>

The surface roughness (Ra) of the surface of the conversion treatment side of the second barrier layer according to the present invention is preferably 2 nm or less, and more preferably 1 nm or less. The surface roughness in the range defined as described above is preferred since, in use as a resin base for an electronic device, light transmission efficiency is improved by a smooth film surface with a few recesses and projections and energy conversion efficiency is improved by reducing a leakage current between electrodes. The surface roughness (Ra) of the gas barrier layer according to the present invention can be measured by the following method.

(Method for measuring surface roughness: AFM measurement)

The surface roughness is roughness regarding the amplitude of fine recesses and projections, calculated from the profile curve with recesses and projections, which is consecutively measured by a detector having a tracer with a very small tip radius, by AFM (atomic force microscope), for example, DI3100, manufactured by Digital Instruments, Inc., in which a section of several tens of μm in a measurement direction is measured several times by the tracer with a very small tip radius.

[Step (2) for forming second barrier layer]

According to the step (2) for forming a second barrier layer by a conversion treatment of a coating film formed by coating the surface of the first barrier layer with a liquid containing a first silicon compound in relation to the method for manufacturing a gas barrier film of the present invention, it is preferable that a coating film be formed by coating the surface of the first barrier layer with a liquid containing a first silicon compound, the coating film be subjected to a pre-treatment, and the coating film after pre-treatment be subjected to a conversion treatment. It is more preferable that a coating film be formed by coating the surface of the first barrier layer with a liquid containing a first silicon compound, the coating film be subjected to a pre-treatment, and the coating film after pre-treatment be subjected to a conversion treatment of irradiating vacuum ultraviolet ray having a wavelength component of 180 nm or less to form a second barrier layer.

As the method for forming a coating film by coating of a liquid containing a first silicon compound or the conversion treatment is as described above, only the pre-treatment is described hereinbelow.

<Pre-treatment of coating film formed by coating of first silicon compound>

It is preferable that moisture be removed from the coating film formed by coating a first silicon compound according to the present invention (hereinbelow, simply referred to as a "silicon compound coating film") either before the conversion treatment or during the conversion treatment. In order to achieve it, a pre-treatment is preferably performed for manufacturing a second barrier layer. The pre-treatment preferably includes a step (A) for heating at 50 to 200°C before irradiation with vacuum ultraviolet ray. It is more preferable to include the step (A) for heating at 50 to 200°C before irradiation with vacuum ultraviolet ray for the purpose of removing an organic solvent in a silicon compound coating film and subsequently a step (B) for the purpose of removing moisture in a silicon compound coating film. By removing moisture either before or during the conversion treatment, the efficiency of the following conversion treatment is improved.

In the step (A), an organic solvent is mainly removed. As such, drying conditions can be suitably decided by means of such as heating treatment, and at this time, the condition may be in the state for removing moisture. As a heat treatment temperature, although a high temperature is preferable from the viewpoint of rapid treatment, it is preferable to determine a temperature and a processing time suitably in consideration of the heat damage to the resin film base. For example, when using a polyethylene terephthalate base whose glass transposition temperature (Tg) is 70°C as a resin base, a heating treatment temperature can be set at 200°C or lower. As for the treatment time, it is preferable to set to be a short time so as to remove a solvent and lower the heat damage of a base. When the heating treatment temperature is 200°C or lower, it can be set within 30 minutes.

The step (B) is a step to remove moisture contained in the coating film of a silicon compound. As a method for removing moisture, removing moisture by maintaining a low humidity environment is preferable. Since the humidity under a low humidity environment changes depending on the temperature, a preferred embodiment for a relation between the temperature and the humidity will be decided by defining the dew point. A preferable dew point is 4°C (temperature 25°C/humidity 25%) or lower, a more preferable dew point is -8°C (temperature 25°C/humidity 10%) or lower, and a still more preferable dew point is -31°C (temperature 25°C/humidity 1%) or lower. It is preferable that the maintaining time be suitably decided depending on the thickness of the second barrier layer. Under the conditions in which the thickness of the second barrier layer is 1.0 μm or less, it is preferable that the dew point be -8°C or lower and the maintaining time is 5 minutes or longer. Meanwhile, the lower limit of the dew point is generally -50°C or higher, and preferably -40°C or higher, although it is not particularly limited thereto. Under the conditions in which the film thickness of the second barrier layer is 1.0 μm or less, it is preferable that the dew point be -8°C or lower and the maintaining time is 5 minutes or longer. Further, in order to facilitate the removal of moisture, it is possible to perform drying under reduced pressure. The pressure for the drying under reduced pressure may be selected from a normal pressure to 0.1 MPa.

Preferred conditions of the step (B) in relation to the conditions of the step are as follows. For example, when the solvent is removed at a temperature of 50 to 200°C and the treatment time of 1 minute to 30 minutes in the step (A), it can select the conditions for the removal of moisture of the dew point of 4°C or lower and the treatment time of 5 minutes to 120 minutes in the step (B). The step (A) and the step (B) can be distinguished from each other according

to the change of the dew point and it can be distinguished when the difference of the dew points in the process atmosphere between the steps (A) and (B) becomes 10°C or higher.

The coating film of a silicon compound is preferably subjected to a conversion treatment with maintaining its condition even after the moisture has been removed by the step (B).

(Water content in coating film of silicon compound)

The water content in the coating film of a silicon compound can be measured according to the analytical method described below.

Headspace - gas chromatography/Mass spectroscopy

Apparatus: HP6890GC/HP5973MSD
Oven: 40°C (2 min), then increased to 150°C with an increase rate of 10°C/min
Column: DB-624 (0.25 mmid × 30 m)
Inlet: 230°C
Detector: SIM
m/z = 18
HS condition: 190°C and 30 min

The water content in the coating film of the first silicon compound is defined as a value of the water content (g), which is obtained by the above-described analytical method, divided by the volume of the second barrier layer (L). In a state in which moisture has been removed by the second step, it is preferably 0.1 % (g/L) or less. More preferably, the water content is 0.01 % (g/L) or less (not more than the detection limit).

In the present invention, it is a preferred embodiment to remove moisture before conversion treatment or during conversion treatment from the viewpoint of promoting a dehydration reaction of a second barrier layer which is converted to silanol.

[Protective layer]

The protective layer according to the present invention is obtained by a conversion treatment of a coating film which has been formed by coating a second silicon compound on a second barrier layer. As such, it is preferable that the second silicon compound be added to a solvent to prepare a solution containing a second silicon compound and the resulting solution is coated on a surface of the second barrier layer. The protective layer according to the present invention is a thin film having no gas barrier property, in other words, a thin film having water vapor permeability (water vapor permeation rate) (60±0.5°C, a relative humidity of (90±2)%RH) of 5 g/($cm^2$·24h) or more.

In the gas barrier film, by having the protective layer according to the present invention, a component for forming a protective layer reacts with the protrusions of irregularities on a surface of the barrier, and thus excellent smoothness can be obtained. Further, according to alleviation of stress in a glass state on a surface of the barrier, excellent bending resistance, smoothness, and cutting process suitability can be obtained.

As a component for forming a protective layer reacts with the protrusions of irregularities on a surface of the barrier, excellent smoothness can be obtained. Further, according to alleviation of stress in a glass state on a surface of the barrier, bending under pressure and cutting process suitability can be obtained.

Further, the average thickness of the protective layer according to the present invention is preferably 10 nm to 1 μm, and more preferably 100 nm to 1 μm.

The average thickness within the aforementioned range is preferred from the viewpoint of the barrier performance.

Since the method for coating a second silicon compound according to the present invention and average coating film thickness are the same as those described for the method for coating a first silicon compound, and thus further descriptions are not made herein.

Further, with regard to the conversion treatment of a protective layer according to the present invention, the method, conditions, and apparatus are the same as those for the conversion treatment for forming a second barrier layer described above, and thus further descriptions are not made herein unless particularly mentioned in the following description. Further, it is particularly preferable that a conversion treatment using vacuum ultraviolet ray is performed for the protective layer according to the present invention.

Unlike the second barrier layer, it is preferable that the protective layer according to the present invention be

homogeneous both in the plane direction and in the depth direction. In other words, it is preferable that a non-converted region hardly exist therein. When polysiloxane is used as the second silicon compound, it is believed that the almost all siloxanes are cross-linked to each other in the protective layer after the conversion treatment.

As for the vacuum ultraviolet ray used for forming the protective layer of the present invention, an irradiation treatment with vacuum ultraviolet ray which is the same as the description given above for forming the first barrier layer can be applied. In that case, the accumulated light amount of the vacuum ultraviolet ray when a protective layer is formed by converting a polysiloxane layer according to the present invention is preferably 500 $mJ/cm^2$ or more to 10,000 $mJ/cm^2$ or less. If the accumulated light amount of vacuum ultraviolet ray is 500 $mJ/cm^2$ or more, sufficient barrier performance can be obtained, and if the accumulated light amount is 10,000 $mJ/cm^2$ or less, a protective layer having high smoothness can be formed without giving any deformation to the base.

Further, when the film density of the protective layer according to the present invention is 0.35 $g/cm^3$ or more, sufficient mechanical strength of a coating film can be obtained. On the other hand, when the film density of the protective layer according to the present invention is 1.2 $g/cm^3$ or less, sufficient cutting process suitability can be obtained. The film density of the protective layer is preferably 0.4 to 1.1 $g/cm^3$, and more preferably 0.5 to 1.0 $g/cm^3$.

The second silicon compounds according to the present invention is not particularly limited if it allows preparation of a coating liquid containing a silicon compound. However, from the viewpoint of having film forming property and having little defects like crack and less residual organic substances, the second silicon compound of the present invention preferably contains polysiloxane.

Examples of the polysiloxane include those described above (the first silicon compound) and those described below, and thus further descriptions are not made herein.

[Step (3) for forming protective layer]

With regard to a step for forming a protective layer according to the present invention, it is preferable that a solution in which the second silicon compound and a solvent are admixed with each other (a solution containing a second silicon compound) be coated on a surface of the second barrier layer to form a coating film followed by performing a conversion treatment of the coating film. It is more preferable that a coating liquid containing polysiloxane be coated on a surface of the second barrier layer by a wet coating method for a pre-treatment followed by irradiating the pre-treated coating film with vacuum ultraviolet ray to form a protective layer as a polysiloxane-converted layer. It is still more preferable that a coating liquid containing polysiloxane be coated on a surface of the second barrier layer by a wet coating method followed by drying, and a protective layer as a polysiloxane-converted layer is formed by irradiating the dried coating film with vacuum ultraviolet ray.

The coating liquid for forming a protective layer, which is used for forming a protective layer, is preferably a mixture solution of a second silicon compound and an organic solvent. It is more preferable to contain mainly (A) polysiloxane and (B) an organic solvent.

The polysiloxane applicable for forming the protective layer according to the present invention is not particularly limited. However, organopolysiloxane represented by the following General Formula (a) is particularly preferable.

First, descriptions are given for a system in which organopolysiloxane represented by the following General Formula (a) is used as (A) polysiloxane.

[Chem. 2]

General Formula (a)

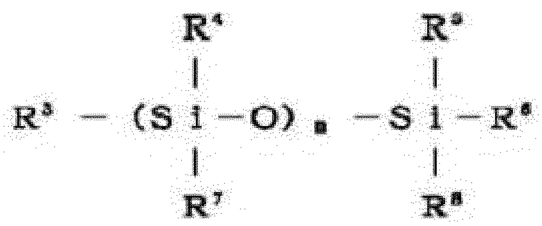

In the above General Formula (a), each of $R^3$ to $R^8$ represents an organic group having 1 to 8 carbon atoms each of which is the same as or different from each other. At least one of the $R^3$ to $R^8$ contains any of an alkoxy group and a hydroxyl group. m is 1 or higher.

Examples of the organic group having 1 to 8 carbon atoms and represented by the $R^3$ to $R^8$ include a halogenated alkyl group such as a γ-chloropropyl group, and a 3,3,3-trifluoropropyl group; a vinyl group; a phenyl group; a (meth)acrylic acid ester group such as a γ-methacryloxypropyl group; an epoxy-containing alkyl group such as a γ-glycidoxypropyl

group; a mercapto-containing alkyl group such as a γ-mercaptopropyl group; an aminoalkyl group such as a γ-aminopropyl group; an isocyanate-containing alkyl group such as a γ-isocyanatepropyl group; a straight or branched alkyl group such as a methyl group, an ethyl group, an n-propyl group, and an isopropyl group; an alicyclic alkyl group such as a cyclohexyl group, and a cyclopentyl group; a straight or branched alkoxy group such as a methoxy group, an ethoxy group, an n-propoxy group, and an isopropoxy group; and an acyl group such as an acetyl group, a propionyl group, a butyryl group, a valeryl group, and a caproyl group.

Further, in the General Formula (a) according to the present invention, it is particularly preferably organopolysiloxane in which m is 1 or more and a weight average molecular weight is 1,000 to 20,000 in terms of polystyrene. If the weight average molecular weight of the organopolysiloxane is 1,000 or more in terms of polystyrene, cracks hardly occur in the protective layer to be formed, and thus the water vapor barrier property can be maintained; and if the weight average molecular weight of the organopolysiloxane is 20,000 or less in terms of polystyrene, curing of the protective layer to be formed becomes sufficient, and thus sufficient hardness can be obtained as the protective layer to be obtained.

Examples of (B) the organic solvent applicable to the present invention include an alcohol-based solvent, a ketone-based solvent, an amide-based solvent, an ester-based solvent, and an aprotic solvent.

Herein, as the alcohol-based solvent, n-propanol, iso-propanol, n-butanol, iso-butanol, sec-butanol, tert-butanol, n-pentanol, iso-pentanol, 2-methylbutanol, sec-pentanol, tert-pentanol, 3-methoxybutanol, n-hexanol, 2-methylpentanol, sec-hexanol, 2-ethylbutanol, propylene glycol monomethyl ether, propylene glycol monoethyl ether, propylene glycol monopropyl ether, propylene glycol monobutyl ether, and the like are preferable.

Examples of the ketone-based solvent include acetone, methyl ethyl ketone, methyl-n-propyl ketone, methyl-n-butyl ketone, diethyl ketone, methyl-iso-butyl ketone, methyl-n-pentyl ketone, ethyl-n-butyl ketone, methyl-n-hexyl ketone, di-iso-butyl ketone, trimethyl nonanone, cyclohexanone, 2-hexanone, methyl cyclohexanone, 2,4-pentanedione, acetonylacetone, acetophenone, fenchone, and the like, and β-diketones such as acetylacetone, 2,4-hexanedione, 2,4-heptanedione, 3,5-heptanedione, 2,4-octanedione, 3,5-octanedione, 2,4-nonanedione, 3,5-nonanedione, 5-methyl-2,4-hexanedione, 2,2,6,6-tetramethyl-3,5-heptanedione, and 1,1,1,5,5,5-hexafluoro-2,4-heptanedione. They may be used singly, or two or more of them may be used simultaneously.

Examples of the amide-based solvent include formamide, N-methylformamide, N,N-dimethylformamide, N-ethylformamide, N,N-diethylformamide, acetamide, N-methylacetamide, N,N-dimethylacetamide, N-ethylacetamide, N,N-diethylacetamide, N-methylpropionamide, N-methylpyrrolidone, N-formylmorpholine, N-formylpiperidine, N-formylpyrrolidine, N-acetylmorpholine, N-acetylpiperidine, and N-acetylpyrrolidine. Those amide-based solvents may be used singly, or two or more of them may be used simultaneously.

Examples of the ester-based solvent include diethyl carbonate, ethylene carbonate, propylene carbonate, diethyl carbonate, methyl acetate, ethyl acetate, γ-butyrolactone, γ-valerolactone, n-propyl acetate, iso-propyl acetate, n-butyl acetate, iso-butyl acetate, sec-butyl acetate, n-pentyl acetate, sec-pentyl acetate, 3-methoxyburyl acetate, methylpentyl acetate, 2-ethylbutyl acetate, 2-ethylhexyl acetate, benzyl acetate, cyclohexyl acetate, methyl cyclohexyl acetate, n-nonyl acetate, methyl acetoacetate, ethyl acetoacetate, ethylene glycol monomethyl ether acetate, ethylene glycol monoethyl ether acetate, diethylene glycol monomethyl ether acetate, diethylene glycol monoethyl ether acetate, diethylene glycol mono-n-butyl ether acetate, propylene glycol monomethyl ether acetate, propylene glycol monoethyl ether acetate, propylene glycol monopropyl ether acetate, propylene glycol monobutyl ether acetate, dipropylene glycol monomethyl ether acetate, dipropylene glycol monoethyl ether acetate, glycol diacetate, methoxy triglycol acetate, ethyl propionate, n-butyl propionate, iso-amyl propionate, diethyl oxalate, di-n-butyl oxalate, methyl lactate, ethyl lactate, n-butyl lactate, n-amyl lactate, diethyl malonate, dimethyl phthalate, and diethyl phthalate. Those ester-based solvents may be used singly, or two or more of them may be used simultaneously.

Examples of the aprotic solvent include acetonitrile, dimethyl sulfoxide, N,N,N',N'-tetraethyl sulfamide, hexamethylphosphoric triamide, N-methylmorphorone, N-methylpyrrole, N-ethylpyrrole, N-methylpiperidine, N-ethylpiperidine, N,N-dimethylpiperazine, N-methylimidazole, N-methyl-4-piperidone, N-methyl-2-piperidone, N-methyl-2-pyrrolidone, 1,3-dimethyl-2-imidazolidinone, and 1,3-dimethyltetrahydro-2-(1H)-pyrimidinone. Those organic solvents may be used singly, or two or more of them may be used simultaneously.

As (B) the organic solvent, an alcohol-based solvent is preferable among the above-described organic solvents. Examples of the application method of a coating liquid for forming a protective layer include a spin coating method, a dipping method, a roller blade method, and a spraying method.

The film thickness of the protective layer which is formed with a coating liquid for forming a protective layer (after conversion treatment) is preferably in the range of 100 nm to 10 μm. If the film thickness of the protective layer is 100 nm or more, the barrier property under a high humidity can be ensured, and if the film thickness is 10 μm or less, the stable coating property can be obtained during the formation of the protective layer, and the high light transmittance can be achieved.

In addition, the protective layer according to the present invention is preferably formed as a pre-treatment, through the step (A) for heating at a heating temperature of 50°C to 200°C before irradiation with vacuum ultraviolet ray. When the heating temperature is 50°C or higher, a sufficient barrier property can be obtained, and if the heating temperature is 200°C or lower, a protective layer having high smoothness can be formed without giving any deformation to the base.

With regard to the heating method used in the heating step, it can be performed using a hot plate, an oven, a furnace, and the like, and as to the heating atmosphere, under an atmosphere, under a nitrogen atmosphere, under an argon atmosphere, under a vacuum, or under reduced pressure in which oxygen concentration is controlled, and the like, the heating method can be performed.

Further, with regard to the protective layer according to the present invention, it is more preferable to have the heating step (A) at 50 to 200°C for the purpose of removing an organic solvent in a coating film of silicone compound before irradiation with vacuum ultraviolet ray, and the subsequent step (B) for the purpose of removing moisture in a coating film of a silicon compound. By removing moisture before the conversion treatment or during the conversion treatment, the efficiency of the following conversion treatment is improved.

Since the heating step (A) as a pre-treatment step and the step for removing moisture in a coating film of silicone component are the same as the pre-treatment of a second buffer layer, descriptions are not made herein.

[Anchor coat layer]

On a surface of the base of the present invention, from the viewpoint of the improvement of the adhesiveness to the first barrier layer, an anchor coat layer is preferably formed as an intermediate layer. As an anchor coat agent used for the formation of the anchor coat layer, a polyester resin, an isocyanate resin, a urethane resin, an acrylic resin, an ethylene vinyl alcohol resin, a modified vinyl resin, an epoxy resin, a modified styrene resin, a modified silicone resin, alkyl titanate, and the like can be used. The anchor coat agent may be used alone or in combination of two or more kinds thereof. Among them, an epoxy resin is particularly preferable. Further, into these anchor coat agents, a conventionally known additive can also be added. Further, the above-described anchor coat agents are applied on a base by a known method such as a roll coating method, a gravure coating method, a knife coating method, a dip coating method, and a spray coating method, the solvent, the diluent, and the like are dried and removed, and thus an anchor coat layer can be formed. The application amount of the anchor coating agent is preferably around 0.1 to 5 $g/m^2$ (in a dry state).

[Smooth layer]

Furthermore, it is desirable to dispose a smooth layer as the intermediate layer on the surface of the base according to the present invention. Particularly, the surface preferably has a pencil hardness of H or more, as defined in JIS K 5600-5-4. Further, it is preferable to dispose such a smooth layer as to have a maximum cross-sectional height Rt (p) of surface roughness of the intermediate layer satisfying 10 nm < Rt (p) < 30 nm, as defined by JIS B 0601: 2001.

The film thickness of the smooth layer is not limited but the film thickness of the smooth layer is preferably 0.1 μm to 10 μm, and more preferably in the range of 0.5 μm to 6 μm, for covering the recesses and projections of the surface of the resin base to form the smooth surface and for securing flexibility.

Particularly, when the second barrier layer is formed on the first barrier layer by chemical vapor deposition with conversion of a coating film of a silicon compound as in the present invention, the second barrier layer has merits of repairing the defects of the first barrier layer and smoothening the surface, but on the other hand, also has such a demerit that, due to occurrence of contraction in a conversion process from the coating film to the high-density inorganic film having a high gas barrier property, a defect may occur by having the stress thereof applied to the first barrier layer and the constitution of the present invention may not be sufficiently utilized.

As a result of extensive examination, the present inventors found that the disposition of such a smooth layer that a layer in the lower portion of the first barrier layer has a surface maximum elevation difference Rt satisfying 10 nm < Rt < 30 nm, concentration of contraction stress on the first barrier layer during forming of the second barrier layer is prevented, and thus the constitution of the present invention can be exhibited at maximum level.

Furthermore, a higher content of the inorganic component of the smooth layer is preferred from the viewpoint of adhesiveness between the first barrier layer and the base and from the viewpoint of increasing the hardness of the smooth layer and a composition ratio thereof in the whole smooth layer is preferably 10% by mass or more, and more preferably 20% by mass or more. The smooth layer may have organic-inorganic hybrid composition like a mixture of an organic resinous binder (photosensitive resin) with inorganic particles or may be an inorganic layer which can be formed by a sol-gel method or the like.

The smooth layer is also disposed in order to flatten the roughened surface of a transparent resin film base, on which projections and/or the like are present, or to fill and flatten recesses and projections or pinholes generated in a transparent first barrier layer that are caused by the projections present on the transparent resin film base. Such a smooth layer is basically formed by curing a thermosetting resin or a photosensitive resin.

Examples of the thermosetting resin used for formation of the smooth layer include, but are not particularly limited to, thermosetting urethane resins consisting of acrylic polyols and isocyanate prepolymers, phenolic resins, urea

melamine resins, epoxy resins, unsaturated polyester resins, silicone resins (resins containing silsesquioxane having an organic-inorganic hybrid structure as a basic skeleton; and the like), and the like. Of these, the epoxy resins and the silicone resins are preferred and the epoxy resins are particularly preferred.

Further, examples of the photosensitive resin used for formation of the smooth layer include a resin composition consisting of an acrylate compound having a radical reactive unsaturated compound; a resin composition consisting of an acrylate compound and a mercapto compound having a thiol group; a resin composition in which a polyfunctional acrylate monomer such as epoxy acrylate, urethane acrylate, polyester acrylate, polyether acrylate, polyethylene glycol acrylate, or glycerol methacrylate is dissolved; and the like. Any mixture of such resin compositions as described above may also be used and is not particularly limited as long as the mixture is a photosensitive resin containing a reactive monomer having one or more photopolymerizable unsaturated bonds in a molecule.

Examples of the reactive monomer having one or more photopolymerizable unsaturated bonds in a molecule include methyl acrylate, ethyl acrylate, n-propyl acrylate, isopropyl acrylate, n-butyl acrylate, isobutyl acrylate, tert-butyl acrylate, n-pentyl acrylate, n-hexyl acrylate, 2-ethyl hexyl acrylate, n-octyl acrylate, n-decyl acrylate, hydroxyethyl acrylate, hydroxypropyl acrylate, allyl acrylate, benzyl acrylate, butoxyethyl acrylate, butoxyethylene glycol acrylate, cyclohexyl acrylate, dicyclopentanyl acrylate, 2-ethyl hexyl acrylate, glycerol acrylate, glycidyl acrylate, 2-hydroxyethyl acrylate, 2-hydroxypropyl acrylate, isobornyl acrylate, isodecyl acrylate, isooctyl acrylate, lauryl acrylate, 2-methoxyethyl acrylate, methoxy ethylene glycol acrylate, phenoxy ethyl acrylate, stearyl acrylate, ethylene glycol diacrylate, diethylene glycol diacrylate, 1,4-butanediol diacrylate, 1,5-pentanediol diacrylate, 1,6-hexandiol diacrylate, 1,3-propanediol acrylate, 1,4-cyclohexanediol diacrylate, 2,2-dimethylolpropane diacrylate, glycerol diacrylate, tripropylene glycol diacrylate, glycerol triacrylate, trimethylolpropane triacrylate, polyoxyethyl trimethylolpropane triacrylate, pentaerythritol triacrylate, pentaerythritol tetraacrylate, ethylene oxide modified pentaerythritol triacrylate, ethylene oxide modified pentaerythritol tetraacrylate, propione oxide modified pentaerythritol triacrylate, propione oxide modified pentaerythritol tetraacrylate, triethylene glycol diacrylate, polyoxypropyl trimethylolpropane triacrylate, butylene glycol diacrylate, 1,2,4-butanediol triacrylate, 2,2,4-trimethyl-1,3-pentanediol diacrylate, diallyl fumarate, 1,10-decanediol dimethylacrylate, pentaerythritol hexaacrylate, and monomers obtained by substituting the above-described acrylates with methacrylates, γ-methacryloxypropyltrimethoxysilane, 1-vinyl-2-pyrrolidone, and the like. The above-described reactive monomers may be used singly or as mixtures of two or more kinds thereof, or as mixtures with other compounds.

As a composition of the photosensitive resin, a photopolymerization initiator is contained.

Examples of the photopolymerization initiator include benzophenone, methyl o-benzoylbenzoate, 4,4-bis(dimethylamine)benzophenone, 4,4-bis(diethylamine)benzophenone, α-aminoacetophenone, 4,4-dichlorobenzophenone, 4-benzoyl-4-methyldiphenyl ketone, dibenzyl ketone, fluorenone, 2,2-diethoxyacetophenone, 2,2-dimethoxy-2-phenylacetophenone, 2-hydroxy-2-methylpropiophenone, p-tert-butyldichloroacetophenone, thioxanthone, 2-methylthioxanthone, 2-chlorothioxanthone, 2-isopropylthioxanthone, diethylthioxanthone, benzyldimethyl ketal, benzylmethoxyethyl acetal, benzoin methyl ether, benzoin butyl ether, anthraquinone, 2-tert-butylanthraquinone, 2-amylanthraquinone, β-chloroanthraquinone, anthrone, benzanthrone, dibenzosuberone, methyleneanthrone, 4-azidobenzylacetophenone, 2,6-bis(p-azidobenzylidene)cyclohexane, 2,6-bis(p-azidobenzylidene)-4-methylcyclohexanone, 2-phenyl-1,2-butadione-2-(o-methoxycarbonyl)oxime, 1-phenyl-propanedione-2-(o-ethoxycarbonyl)oxime, 1,3-diphenyl-propanetrione-2-(o-ethoxycarbonyl)oxime, 1-phenyl-3-ethoxy-propanetrione-2-(o-benzoyl)oxime, Michler's ketone, 2-methyl[4-(methylthio)phenyl]-2-morpholino-1-propane, 2-benzyl-2-dimethylamino-1-(4-morpholinophenyl)-butanone-1, naphthalenesulfonyl chloride, quinolinesulfonyl chloride, n-phenylthioacridone, 4,4-azobisisobutyronitrile, diphenyl disulfide, benzthiazole disulfide, triphenylphosphine, camphorquinone, carbon tetrabromide, tribromophenylsulfone, benzoin peroxide, and Eosine, as well as combinations of a photoreductive pigment such as Methylene Blue and a reducing agent such as ascorbic acid or triethanolamine, and the like. The photopolymerization initiators may be used singly or in combination of two or more kinds thereof.

The method for forming a smooth layer is not particularly limited, however, the formation is preferably performed by wet coating methods such as spin coating methods, spray coating methods, blade coating methods, and dip coating methods, and dry coating methods such as vapor deposition methods.

For forming of the smooth layer, an additive such as an oxidation inhibitor, an ultraviolet ray absorber, or a plasticizer may be optionally added to the above-mentioned photosensitive resin, if necessary. A resin or an additive suitable for improving the film forming property or for preventing occurrence of pinholes may also be used in any smooth layer irrespective of the laminate position of the smooth layer.

Examples of solvents to be used for forming the smooth layer by using a coating liquid in which the photosensitive resin is dissolved or dispersed in such a solvent may include alcohols such as methanol, ethanol, n-propanol, isopropanol, ethylene glycol, and propylene glycol; terpenes, such as α- or β-terpineol, and the like; ketones such as acetone, methyl ethyl ketone, cyclohexanone, N-methyl-2-pyrrolidone, diethyl ketone, 2-heptanone, and 4-heptanone; aromatic hydrocarbons such as toluene, xylene, and tetramethylbenzene; glycol ethers such as cellosolve, methyl cellosolve, ethyl cellosolve, carbitol, methyl carbitol, ethyl carbitol, butyl carbitol, propylene glycol monomethyl ether, propylene glycol monoethyl ether, dipropylene glycol monomethyl ether, dipropylene glycol monoethyl ether, triethylene glycol monomethyl ether, and triethylene glycol monoethyl ether; acetic esters such as ethyl acetate, butyl acetate, cellosolve acetate, ethyl cellosolve acetate, butyl cellosolve acetate, carbitol acetate, ethyl carbitol acetate, butyl carbitol acetate, propylene glycol monomethyl ether acetate, propylene glycol monoethyl ether acetate, 2-methoxyethyl acetate, cyclohexyl acetate, 2-ethoxyethyl acetate, and 3-methoxybutyl acetate; diethylene glycol dialkyl ether, dipropylene glycol dialkyl ether, ethyl 3-ethoxypropionate, methyl benzoate, N,N-dimethylacetamide, and N,N-dimethylformamide.

As described above, as the smoothness of the smooth layer, a maximum cross-sectional height Rt (p), which is a value represented by surface roughness specified in JIS B 0601, is preferably 10 nm or more and 30 nm or less. In the case of less than 10 nm, a coating film property may be deteriorated when coating means contacts the surface of the smooth layer in a coating manner with a wire bar, a wireless bar, or the like in the step of coating a silicon compound described below. Further, in the case of more than 30 nm, it may be difficult to smooth recesses and projections after coating the silicon compound.

The surface roughness is roughness regarding the amplitude of fine recesses and projections, calculated from the profile curve with recesses and projections, which is consecutively measured by a detector having a tracer with a very small tip radius, by AFM (atomic force microscope), in which a section of several tens of $\mu$m in a measurement direction is measured many times by the tracer with a very small tip radius. Specifically, a measurement range for single measurement is 80 $\mu$m $\times$ 80 $\mu$m and three measurements are carried out on different measurement spots.

As one of preferred aspects of the smooth layer, when a photosensitive resin is used as an additive, for example, for the smooth layer, reactive silica particles having a photosensitive group with photopolymerization reactivity introduced to the surface (hereinafter also simply referred to as "reactive silica particles") are contained in the photosensitive resin. Examples of the photosensitive group having photopolymerizability may include polymerizable unsaturated groups represented by a (meth)acryloyloxy group; and the like. The photosensitive resin may also contain a compound capable of allowing photopolymerization reaction with the photosensitive group having photopolymerization reactivity introduced to the surface of the reactive silica particles, for example, an unsaturated organic compound having a polymerizable unsaturated group. Further, the photosensitive resin with a solid content adjusted by appropriately mixing such reactive silica particles or an unsaturated organic compound having a polymerizable unsaturated group with a general-purpose diluting solvent may be used.

As for the average particle diameter of the reactive silica particles, an average particle diameter of 0.001 to 0.1 $\mu$m is preferred. By adjusting the average particle diameter in such a range, a smooth layer having both an optical property in which an antiglare property and resolution are satisfied in a good balance, which is an effect of the present invention, and a hard-coat property becomes easier to be formed, by use in combination with a matting agent consisting of inorganic particles with an average particle diameter of 1 to 10 $\mu$m described below. From the viewpoint of obtaining such an effect more easily, it is more preferable to use reactive silica particles having an average particle diameter of 0.001 to 0.01 $\mu$m.

Such inorganic particles as mentioned above are preferably contained in the smooth layer used in the present invention at a mass ratio of 10% or more. It is further preferable to contain 20% or more. Addition of 10% or more results in improvement in adhesiveness with the gas barrier layer.

In the present invention, there may be used as reactive silica particles a substance in which silica particles are chemically bonded by generating a silyloxy group between the silica particles via a hydrolysis reaction of a hydrolyzable silyl group of a hydrolyzable silane modified with a polymerizable unsaturated group.

Examples of the hydrolyzable silyl group include carboxylate silyl groups such as an alkoxy silyl group and an acetoxy silyl group; halogenated silyl groups such as a chloro silyl group; an amino silyl group; an oxime silyl group; a hydride silyl group; and the like.

Examples of the polymerizable unsaturated group include an acryloyloxy group, a methacryloyloxy group, a vinyl group, a propenyl group, a butadienyl group, a styryl group, an ethynyl group, a cinnamoyl group, a malate group, an acrylamide group, and the like.

In the present invention, it is desirable that the thickness of the smooth layer be 0.1 to 10 $\mu$m, preferably 1 to 6 $\mu$m. The thickness of 1 $\mu$m or more results in sufficient smoothness for a film having a smooth layer and also in easy improvement in surface hardness while the thickness of 10 $\mu$m or less results in easy adjustment of the balance in the optical property of a smooth film and enables easy prevention of the curl of a smooth film when a smooth layer is disposed only on one surface of a transparent polymeric film.

[Bleed out preventing layer]

In the gas barrier film of the present invention, a bleed out preventing layer may be formed as the intermediate layer. The bleed out preventing layer is disposed on the surface opposite to the surface of the base having the smooth layer for the purpose of inhibiting the phenomenon of the contamination of the contact surface due to the migration of an unreacted oligomer or the like from the inside of the film base to the surface, when the film having the smooth layer is heated. As long as the bleed out preventing layer has this function, the bleed out preventing layer may have the same

constitution as that of the smooth layer.

Further, since large film contraction occurs when a conversion treatment is performed, it is preferable to suppress crosswise deformation thereof and to prevent cracks. To that end, a so-called hard coat layer having a high surface hardness or elastic modulus can be disposed, but the above-described bleed out preventing layer can also play the role of the hard coat layer.

Examples of an unsaturated organic compound having a polymerizable unsaturated group, which may be incorporated in the bleed out preventing layer may include a polyvalent unsaturated organic compound having two or more polymerizable unsaturated groups in the molecule or a monovalent unsaturated organic compound having one polymerizable unsaturated group in the molecule.

Herein, examples of the polyvalent unsaturated organic compound include ethylene glycol di(meth)acrylate, diethylene glycol di(meth)acrylate, glycerol di(meth)acrylate, glycerol tri(meth)acrylate, 1,4-butanediol di(meth)acrylate, 1,6-hexanediol di(meth)acrylate, neopentyl glycol di(meth)acrylate, trimethylolpropane tri(meth)acrylate, dicyclopentanyl di(meth)acrylate, pentaerythritol tri(meth)acrylate, pentaerythritol tetra(meth)acrylate, dipentaerythritol hexa(meth)acrylate, dipentaerythritol monohydroxypenta(meth)acrylate, ditrimethylolpropane tetra(meth)acrylate, diethylene glycol di(meth)acrylate, polyethylene glycol di(meth)acrylate, tripropylene glycol di(meth)acrylate, and polypropylene glycol di(meth)acrylate.

Further, examples of the monovalent unsaturated organic compound include methyl (meth)acrylate, ethyl (meth)acrylate, propyl (meth)acrylate, butyl (meth)acrylate, 2-ethylhexy (meth)acrylate, isodecyl (meth)acrylate, lauryl (meth)acrylate, stearyl (meth)acrylate, allyl (meth)acrylate, cyclohexyl (meth)acrylate, methylcyclohexyl (meth)acrylate, isobornyl (meth)acrylate, 2-hydroxyethyl (meth)acrylate, 2-hydroxypropyl (meth)acrylate, glycerol (meth)acrylate, glycidyl (meth)acrylate, benzyl (meth)acrylate, 2-ethoxyethyl (meth)acrylate, 2-(2-ethoxyethoxy)ethyl (meth)acrylate, butoxyethyl (meth)acrylate, 2-methoxyethyl (meth)acrylate, methoxydiethylene glycol (meth)acrylate, methoxytriethylene glycol (meth)acrylate, methoxypolyethylene glycol (meth)acrylate, 2-methoxypropyl (meth)acrylate, methoxydipropylene glycol (meth)acrylate, methoxytripropylene glycol (meth)acrylate, methoxypolypropylene glycol (meth)acrylate, polyethylene glycol (meth)acrylate, and polypropylene glycol (meth)acrylate.

As other additive agents, a matting agent may be incorporated. As a matting agent, inorganic particles having an average particle diameter of around 0.1 to 5 $\mu$m are preferred.

As such inorganic particles, silica, alumina, talc, clay, calcium carbonate, magnesium carbonate, barium sulfate, aluminum hydroxide, titanium dioxide, zirconium dioxide, and the like may be used, either singly or in combination of two or more kinds.

Herein, the matting agent consisting of inorganic particles is desirably contained at a rate of 2 parts by mass or more, preferably 4 parts by mass or more, and more preferably 6 parts by mass or more, but 20 parts by mass or less, preferably 18 parts by mass or less, and more preferably 16 parts by mass or less, based on 100 parts by mass of the solid content of a hard coat agent.

In the bleed out preventing layer, a thermoplastic resin, a thermosetting resin, an ionizing radiation curable resin, a photopolymerization initiator, or the like may also be incorporated as a component other than a hard coat agent and a matting agent. It is particularly preferable to incorporate a thermosetting resin.

Examples of the thermosetting resin include thermosetting urethane resins consisting of acrylic polyols and isocyanate prepolymers, phenolic resins, urea melamine resins, epoxy resins, unsaturated polyester resins, and silicone resins.

Further, examples of the thermoplastic resin include cellulose derivatives such as acetyl cellulose, nitrocellulose, acetyl butyl cellulose, ethyl cellulose, and methyl cellulose, vinyl-based resins such as vinyl acetate and copolymers thereof, vinyl chloride and copolymers thereof, and vinylidene chloride and copolymers thereof, acetal-based resins such as polyvinyl formal and polyvinyl butyral, acrylic resins such as acryl resins and copolymers thereof and methacryl resins and copolymers thereof, polystyrene resins, polyamide resins, linear polyester resins, and polycarbonate resins.

Further, as the ionizing radiation curable resin, there may be used a resin cured by irradiating an ionizing radiation curing coating composition mixed with one or two or more of photopolymerizable prepolymers, photopolymerizable monomers, and the like with ionizing radiation (ultraviolet ray or electron beam). As the photopolymerizable prepolymer, there is particularly preferably used an acrylic prepolymer that has two or more acryloyl groups in one molecule and is provided with a three-dimensional network structure by crosslinking curing. As the acrylic prepolymer, urethane acrylate, polyester acrylate, epoxy acrylate, melamine acrylate, or the like may be used. Further, as the photopolymerizable monomers, the polyvalent unsaturated organic compounds described above and the like may be used.

Further, examples of the photopolymerization initiator include acetophenone, benzophenone, Michler's ketone, benzoin, benzyl methyl ketal, benzoin benzoate, hydroxycyclohexyl phenyl ketone, 2-methyl-1-(4-(methylthio)phenyl)-2-(4-morpholinyl)-1-propane, $\alpha$-acyloxime ester, and thioxanthones.

Such a bleed out preventing layer as described above can be formed by preparing a coating liquid by blending a hard coat agent, a matting agent, and optionally another component with an appropriately optionally used diluting solvent, coating the coating liquid on the surface of the base film by a coating method known in the art, and thereafter

irradiating the liquid with ionizing radiation to cure the liquid. A method for irradiation with ionizing radiation can be performed by irradiation with ultraviolet ray in a wavelength region of 100 to 400 nm, and preferably 200 to 400 nm, which is emitted from an ultra-high-pressure mercury lamp, a high-pressure mercury lamp, a low-pressure mercury lamp, a carbon arc, a metal halide lamp, or the like, or by irradiation with electron beams in a wavelength region of 100 nm or less, which is emitted from a scanning-type or curtain-type electron beam accelerator.

It is desirable that the thickness of the bleed out preventing layer in accordance with the present invention be 1 to 10 μm, and preferably 2 to 7 μm. The thickness of 1 μm or more easily allows sufficient heat resistance for a film while the thickness of 10 μm or less results in easy adjustment of the balance in the optical property of a smooth film and enables easy prevention of the curl of a gas barrier film when a smooth layer is disposed only on one surface of a transparent polymeric film.

[Gas barrier film]

The gas barrier film of the present invention has a base, a first barrier layer, a second barrier layer, and a protective layer that are laminated in order, and it is characterized in that the protective layer has no gas barrier property.

Average thickness of the gas barrier film of the present invention is preferably 10 nm to 1 μm, and more preferably 100 nm to 1 μm. Meanwhile, the laminate in which a first barrier layer, a second barrier layer, and a protective layer that are laminated in order (not including a base) is described herein as a "gas barrier layer unit".

The present invention may have a constitution that the gas barrier layer unit is disposed on both surfaces of a base. In such case, the gas barrier layer unit (a first barrier layer, a second barrier layer, and a protective layer) formed on both surfaces of a base may be the same or different from each other. By having the gas barrier layer unit formed on both surfaces, dimensional change due to moisture absorption and release by the base film itself under harsh conditions of a high temperature and a high humidity is suppressed so that the stress to the gas barrier layer unit is alleviated and the device durability is improved. Further, when a heat resistant resin is used as a base, the effect of having the gas barrier layer unit on both the front and back sides is significant, and therefore desirable. In other words, since a heat resistant resin represented by polyimide or polyether imide is non-crystalline, it has a higher moisture absorption value compared to PET or PEN that is crystalline, and thus it experiences higher dimensional change of a base that is caused by humidity. In this regard, by disposing the gas barrier layer unit on both the front and back sides of a base, the dimensional change of a base can be suppressed under conditions with a high temperature and also a high humidity.

When it is used for a flexible display, in particular, the process temperature may be higher than 200°C during a step for producing an array, and thus a base with high heat resistance is preferably used. Moreover, in addition to a base with high heat resistance, it is possible to form an intermediate layer (anchor coat layer, a smooth layer, and/or a bleed out preventing layer) between a base and a first barrier layer of the gas barrier film of the present invention.

According to a preferred embodiment of the gas barrier layer of the present invention, a first barrier layer 3 formed by a chemical vapor deposition method, a second barrier layer 4B having a non-converted region and a converted region as a result of performing a conversion treatment, and a protective layer 4A are present. By having a constitution in which a non-converted region is present between the dense first barrier layer 3 and the converted region of the second barrier layer 4B, concentration of stress during bending of a specific layer can be suppressed and the bending resistance can be dramatically improved. It was also found that, by disposing a protective layer without a gas barrier property on an outermost surface, the barrier property can be guaranteed under a high humidity, which leads to the completion of the present invention.

Furthermore, the thickness of the converted region, which is formed on a surface side of the second barrier layer 4B of the present invention, preferably has a film thickness ratio of 0.2 to 0.9, more preferably 0.3 to 0.9, and still more preferably 0.4 to 0.8 compared to the entire film thickness of the second barrier layer 4B.

(Measuring method of elastic modulus: Nanoindentation)

In a preferred embodiment of the gas barrier film of the present invention, it is preferable that a first barrier layer 3 formed with a chemical vapor deposition method contains silicon oxide or silicon oxynitride, and that elastic moduli satisfy the relationship of: E1 > E2 > E3, when E1 is an elastic modulus of the first barrier layer 3, E2 is an elastic modulus of the modified region in the second barrier layer 4B, and E3 is an elastic modulus of the non-converted region in the second barrier layer 4B.

The elastic moduli of the converted region and the non-converted region in the first barrier layer, and the second barrier layer can be determined with a conventionally known measuring method of elastic modulus. For example, the following methods are cited: a method for measuring a fixed strain under the condition of applying a predetermined frequency (Hz) by using VIBRON DDV-2 (manufactured by Orientech Co., Ltd.); a method of obtaining measurement value by changing an application strain with a predetermined frequency after forming a second barrier layer on a transparent base by using an measuring apparatus of RSA-II (manufactured by Rheometrics, Inc.); and a measuring method by using a nanoindenter applied with a nanoindentation method such as Nano Indenter TMXP/DCM (manufactured by MTS Systems Corporation).

From the viewpoint of measuring the elastic modulus of each of the very thin layers relating to the present invention with high precision, it is preferable to use a method in which determination is made by measuring with a nanoindenter.

The "nanoindentation method" described here is a way to measure as follows. After pushing an indenter of the triangular pyramid having a tip radius of about 0.1 to 1 μm with an ultra minute load to impress a load to the second barrier layer prepared on the transparent base which is a target measuring object, the indenter is removed to unload. Then, after creating a load-displacement curve, an elastic modulus (a reduced modulus) is obtained from the impressed load obtained from the load-displacement curve and the pushing depth. In this nanoindentation method, it can measure a displacement resolution with high accuracy of 0.01 nm employing a very small load such as a maximum load of 20 mN with a head assembly of a load resolution of 1 nN.

In particular, with respect to a second barrier layer of the present invention which has different elastic moduli depending on the cross-sectional direction, it is preferable to push an indenter having an ultra minute triangular pyramid from the cross section to measure the elastic modulus at the opposite side to the base side in the cross section. In such case, a nanoindenter which can operate within a scanning electron microscope has been developed from the viewpoint of increasing accuracy more, and the measurement can be made by using such nanoindenter.

As for the measurement value of the elastic modulus of each layer, it is preferable to satisfy the relationship of $E1 > E2 > E3$, from the measured values of elastic modulus as described above. By satisfying this relationship, the stress concentration at the time of bending can be suppressed in the converted region (E2) in the convered treatment side and the first barrier layer (E1), and thus bending resistance is extremely improved. A preferable elastic modulus value E1 depends on the material composing the first barrier layer. For example, in the case of silicon oxide or silicon oxynitride, preferably, it is 10 to 100 GPa, and more preferably, it is 20 to 50 GPa. E2 and E3 of the second barrier layer can be arbitrarily adjusted by changing the converting condition within the extent which satisfies the above-mentioned expression.

(Method for measuring characteristic values of gas barrier film)

Each of the characteristic values of a gas barrier film of the present invention can be measured according to the following methods.

<Measurement of water vapor transmission rate>

For the measurement of water vapor transmission rate by the B method described above in JIS K 7129 (1992), various methods have been proposed. For example, the representative methods are: a cup method, a dry sensor method (Lassy method) and an infrared sensor method (Mocon method). With increasing a gas barrier property, there are cases of reaching a measurement limit by these methods, and thus the following methods are also proposed.

(Methods for measurement of water vapor transmission rate other than the above)

1. Ca method

A method of utilization of a phenomenon that a metal Ca is deposited on a gas barrier film and the metal Ca is corroded with water passing through the film. A water vapor transmission rate is calculated from a corrosion area and time to reach it.

2. A method proposed by MORESCO Corporation (News Release on Dec. 8, 2009)

A method of delivery between a sample space under atmospheric pressure and a mass spectrometer in an ultra-high vacuum through a cold trap for water vapor.

3. HTO method (General Atomics (U.S.))

A method of calculating a water vapor transmission rate by using tritium.

4. Method proposed by A-Star (Singapore) (International Publication No. WO 2005/95924)

A method of calculating a water vapor transmission rate from a variation in electrical resistance and a 1/f fluctuation component existing therein by using a material (for example, Ca, Mg) with electrical resistance varied by water vapor or oxygen in a sensor.

In the gas barrier film of the present invention, a method for measuring a water vapor transmission rate is not particularly limited but measurement by a Ca method described below was carried out as the method for measuring a water vapor transmission rate in the present invention.

<Ca method used in the present invention>

Vapor deposition apparatus: Vacuum deposition apparatus JEE-400, manufactured by JEOL Ltd.
Constant temperature and constant humidity oven: Yamato Humidic Chamber IG47M
Metal corroded by reaction with water: Calcium (granular)
Water vapor impermeable metal: Aluminum (ϕ3-5 mm, granular)
Production of a cell for evaluation of water vapor barrier property

Metal calcium was deposited on the surface of the gas barrier layer of a barrier film sample using a vacuum deposition apparatus (vacuum deposition apparatus JEE-400, manufactured by JEOL Ltd.), while masking other than the portions to be deposited (9 positions of 12 mm × 12 mm) on the gas barrier film sample before a transparent conductive film was formed. Then, the mask was removed while the vacuum state was maintained, and aluminum was deposited from another metal deposition source onto the whole surface of one side of the sheet. After the aluminum sealing, the vacuum state was released, and promptly, the aluminum sealed surface was faced with quartz glass having a thickness of 0.2 mm through a UV curable resin for sealing (manufactured by Nagase ChemteX Corporation) under dried nitrogen atmosphere, followed by being irradiated with ultraviolet ray to produce the evaluation cells. In order to confirm the change in gas barrier property before and after the bending, cells for evaluation of a water vapor barrier property were produced also by using gas barrier films which were not subjected to the above-described bending treatment.

The obtained samples with both sealed surfaces were stored under a high temperature and a high humidity of 60°C and 90%RH, and the amount of water permeated into the cell was calculated from the amount of corrosion of metal calcium based on the method described in Japanese Patent Application Laid-Open No. 2005-283561.

In order to confirm that there is no water vapor permeation from a surface other than the barrier film surface, a sample in which metal calcium was deposited on a 0.2 mm thick quartz glass plate instead of the gas barrier film sample was stored under the same high temperature and high humidity of 60°C and 90%RH, as a comparative sample, to confirm that there was no corrosion of metal calcium even after a lapse of 1000 hours.

The gas barrier film of the present invention preferably has a lower water vapor transmission rate, for example, preferably of 0.001 to 0.00001 $g/m^2 \cdot 24h$, and more preferably 0.0001 to 0.00001 $g/m^2 \cdot 24h$.

<Measurement of oxygen transmission rate>

The measurement is performed using an oxygen transmission rate measuring apparatus (model name: "OXTRAN" (registered trademark) ("OXTRAN" 2/20)) manufactured by MOCON (U.S.) under the conditions of a temperature of 23°C and a humidity of 0%RH based on the B method (isopiestic method) described in JIS K7126 (1987). Further, the measurement is performed once for each of two test pieces and the average value of two measured values is regarded as the value of an oxygen transmission rate.

The gas barrier film of the present invention preferably has a lower oxygen transmission rate, for example, more preferably of less than 0.001 $g/m^2 \cdot 24h \cdot atm$ (not more than the detection limit).

(Packaging shape of gas barrier film)

The gas barrier film of the present invention can be continuously produced and wound in a roll form (so-called, roll-to-roll production). In that occasion, it is preferable to wind up by pasting a protective sheet on the side formed with a gas barrier layer. In particular, when the gas barrier film of the present invention is used as a sealing material of an organic thin layer device, there often occur cases in which defect is produced by a dust (for example, a particle) adhered to a surface. Thus, it is very effective to paste a protective sheet in a place of high cleanness to prevent adhesion of a dust. It is also effective in prevention of a scratch to the gas barrier layer surface which may be introduced at the time

of winding.

Although a protective sheet is not limited in particular, it can be used a common "protective sheet" or "peeling sheet" having a composition of a resin substrate having a thickness of about 100 μm provided with an adhesion layer of weak tackiness.

[Electronic device]

The gas barrier film of the present invention can be applied to an electronic device. The gas barrier film can be preferably used not only in an organic thin film device such as an organic thin film photoelectric conversion element or an organic electroluminescence element but also in a display electronic device such as flexible LCD or electronic paper for which a manufacturing method includes a high temperature treatment.

(Organic photoelectric conversion element)

The gas barrier film of the present invention can be used as various materials for sealing and films for sealing and, for example, can be used in a film for sealing an organic photoelectric conversion element.

When the gas barrier film of the present invention is used in an organic photoelectric conversion element, such a constitution that the gas barrier film is used as a base to receive sunlight from the arrangement side of the gas barrier film is enabled since the gas barrier film of the present invention is transparent. That is, for example, a transparent conductive thin film such as ITO can be disposed as a transparent electrode on the gas barrier film to constitute a resin base for an organic photoelectric conversion element. In addition, the ITO transparent conductive film disposed on the base is used as an anode, a porous semiconductor layer is formed thereon, a cathode consisting of a metal film is further formed to form an organic photoelectric conversion element, another sealing material (which may be the same) is overlapped thereon, the gas barrier film base is adhered to the periphery thereof to seal the element, thereby enabling the organic photoelectric conversion element to be sealed, and, as a result, the influence of a gas such as moisture or oxygen in outside air on the organic photoelectric conversion element can be blocked.

The resin base for an organic photoelectric conversion element is obtained by forming a transparent conductive film on the gas barrier layer of the gas barrier film formed in such a manner.

Formation of a transparent conductive film can be conducted by using a vacuum deposition method, a sputtering method, or the like and it can also be produced by a coating method such as a sol-gel method using, for example, a metal alkoxide of indium, tin, or the like. As for the (average) film thickness of the transparent conductive film, a transparent conductive film in the range of 0.1 to 1000 nm is preferred.

Subsequently, the gas barrier film of the present invention and an organic photoelectric conversion element employing a resin base for an organic photoelectric conversion element in which a transparent conductive film is formed thereon will be described.

<Sealing film and method for producing sealing film>

In accordance with the present invention, the gas barrier film of the present invention can be used as a substrate for a sealing film.

Regarding the gas barrier film of the present invention, on a gas barrier layer unit, a transparent conductive layer is further formed as an anode, a layer constituting an organic photoelectric conversion element and a layer to be a cathode are laminated on the anode, and an additional gas barrier film is overlapped thereon as a sealing film, followed by adhering for sealing.

Further, particularly, a metal foil on which resin laminate (polymer film) is formed cannot be used as a gas barrier film on the light extracting side but is preferably used as a sealing film when it is a sealing material which is inexpensive and has low water vapor permeability and is not intended to be used for extraction of light (transparency is not required).

In accordance with the present invention, a metal foil refers to a metallic foil or film formed by rolling or the like, and it is distinguished from a metal thin film formed by sputtering, vapor deposition, or the like, or from a conductive film formed from a fluid electrode material such as a conductive paste.

Examples of the metal foil, although the kind of the metal thereof is not particularly limited, include a copper (Cu) foil, an aluminum (Al) foil, a gold (Au) foil, a brass foil, a nickel (Ni) foil, a titanium (Ti) foil, a copper alloy foil, a stainless steel foil, a tin (Sn) foil, a high nickel alloy foil, and the like. Among these various metal foils, examples of particularly preferable metal foil include an Al foil.

The thickness of the metal foil is preferably 6 to 50 μm. In the case of less than 6 μm, pinholes may be generated during use depending on a material used in the metal foil to prevent a necessary barrier property (water vapor transmission rate, oxygen transmission rate) from being obtained. In the case of more than 50 μm, a cost may be increased or the

thickness of an organic photoelectric conversion element may be increased depending on a material used in the metal foil, so that the merits of the film may be compromised.

In a metal foil laminated with a resin film (a polymer film), various materials described in "New Development of Functionalized Wrapping Material" (Toray Research Center, Inc.) may be used for the resin film, examples of which include polyethylene-based resins, polypropylene-based resins, polyethylene terephthalate-based resins, polyamide-based resins, ethylene-vinyl alcohol copolymer-based resins, ethylene-vinyl acetate copolymer-based resins, acrylonitrile-butadiene copolymer-based resins, cellophane-based resins, vinylon-based resins, vinylidene chloride-based resins, and the like. A resin such as a polypropylene-based resin or a nylon-based resin may be stretched, or, further, may be coated with a vinylidene chloride-based resin. With respect to a polyethylene-based resin, a low density resin or a high density resin may also be used.

Although it will be mentioned later, as a method for sealing two films, for example, a method of laminating a resin layer which can be thermally fused using a commonly used impulse sealer and sealing the resin layer with an impulse sealer by fusing is preferred; and, in this case, the (average) film thickness is desirably 300 μm or less since, as for sealing between gas barrier films, handlability of the film during a sealing operation is deteriorated and thermal fusion with an impulse sealer or the like is difficult to achieve when the (average) film thickness of the film is more than 300 μm.

<Sealing of organic photoelectric conversion element>

In accordance with the present invention, the organic photoelectric conversion element can be sealed by: forming each layer of an organic photoelectric conversion element on a resin base for an organic photoelectric conversion element produced by forming a transparent conductive layer on the resin film (gas barrier film) having the gas barrier layer unit of the present invention; and thereafter covering the cathode surface with the above-described sealing film under an environment purged with an inert gas.

As the inert gas, a noble gas such as He or Ar is preferably used besides $N_2$, a noble gas obtained by mixing He and Ar is also preferred, and the ratio of a noble gas in the gas is preferably 90 to 99.9% by volume. The storage stability is improved by sealing under an environment purged with an inert gas.

When an organic photoelectric conversion element is sealed using the metal foil laminated with a resin film (polymer film), it is preferable to form a ceramic layer on a metal foil and to adhere the surface of the ceramic layer onto the cathode of the organic photoelectric conversion element, but not the surface of the laminated resin film. When the polymer film side of the sealing film is adhered onto the cathode of the organic photoelectric conversion element, it may occasionally have partial electrical conduction.

As a method of adhering a sealing film onto the cathode of an organic photoelectric conversion element, mention is made of a method of laminating a resin film which is commonly used and can be thermally fused with an impulse sealer, for example, a film which can be thermally fused, such as an ethylene-vinyl acetate copolymer (EVA) or polypropylene (PP) film or a polyethylene (PE) film, followed by sealing by fusing with an impulse sealer.

As an adhesion method, a dry lamination method is excellent in view of workability. In this method, a curable adhesive layer of around 1.0 to 2.5 μm is generally used. However, since the adhesive may form a tunnel, and a bleed out, or cause wrinkles when the applied amount of the adhesive is excessive, the applied amount of the adhesive is preferably adjusted within 3 to 5 μm as a dried (average) film thickness.

Hot melt lamination is a method to melt a hot melt adhesive and apply it onto a base to form an adhesive layer, and, with this method, the thickness of the adhesive layer can be set generally in a wide range of 1 to 50 μm. As a base resin for a generally used hot melt adhesive, EVA, EEA, polyethylene, butyl rubber, or the like is used, rosin, a xylene resin, a terpene-based resin, a styrene-based resin, or the like is used as a tackifying agent, and a wax or the like is used as a plasticizer.

An extrusion lamination method is a method to apply a resin melted at a high temperature onto a base using a die, and it is possible to set the thickness of the resin layer generally in a wide range of 10 to 50 μm.

As a resin used for the extrusion lamination, LDPE, EVA, PP, or the like is generally used.

[Ceramic layer]

In the gas barrier film of the present invention, a ceramic layer formed of a compound with an inorganic oxide, a nitride, a carbide, or the like can be disposed from the viewpoint of, for example, further enhancement of a gas barrier property when the organic photoelectric conversion element is sealed, as mentioned above.

Specifically, it can be formed with $SiO_x$, $Al_2O_3$, $In_2O_3$, $TiO_x$, tin-indium oxide(ITO), AlN, $Si_3N_4$, $SiO_xN$, $TiO_xN$, SiC, or the like.

The ceramic layer may be laminated by a known method such as a sol-gel method, a vapor deposition method, CVD, PVD, or a sputtering method.

For example, it can also be formed using polysilazane by the same method as in the case of the second barrier layer. In this case, it can be formed by coating a composition consisting of polysilazane to form a polysilazane coating, followed by conversion into ceramic.

Further, as for the ceramic layer according to the present invention, composition of silicon oxide or a metal oxide containing silicon oxide as a main component, or a mixture of a metal carbide, a metal nitride, a metal sulfide, a metal halide, and the like (such as a metal oxynitride or a metal oxide-halide), or the like can be separately produced by selecting conditions of an organometallic compound which is a source material (also referred to as a raw material), a decomposition gas, a decomposition temperature, an input power, and the like for an atmospheric pressure plasma method.

Silicon oxide is generated, for example, by using a silicon compound as a source compound and oxygen as a decomposition gas. Further, silicon oxynitride is generated by using silazane or the like as a source compound. This is because very active charged particles/active radicals are present at high density in plasma space, a multi-stage chemical reaction is therefore promoted at a very high speed in the plasma space, and elements present in the plasma space are converted into a thermodynamically stable compound in a very short time.

Such a source material for forming a ceramic layer may be in any gas, liquid, or solid state under ordinary temperature and normal pressure as long as it is a silicon compound. It can be introduced without being processed into discharge space when it is a gas whereas it is vaporized by means such as heating, bubbling, decompression, or ultrasonic irradiation and is used when it is liquid or solid. Further, it may also be diluted with a solvent and used, and, as the solvent, organic solvents such as methanol, ethanol and n-hexane, and mixed solvents thereof may be used. Since these diluent solvents are decomposed in a molecular or atomic state during plasma discharge treatment, their influences can be almost disregarded.

Examples of the silicon compounds include silane, tetramethoxysilane, tetraethoxysilane, tetra-n-propoxysilane, tetraisopropoxysilane, tetra-n-butoxysilane, tetra-t-butoxysilane, dimethyldimethoxysilane, dimethyldiethoxysilane, diethyldimethoxysilane, diphenyldimethoxysilane, methyltriethoxysilane, ethyltrimethoxysilane, phenyltriethoxysilane, (3,3,3-trifluoropropyl)trimethoxysilane, hexamethyldisiloxane, bis(dimethylamino)dimethylsilane, bis(dimethylamino)methylvinylsilane, bis(ethylamino)dimethylsilane, N,O-bis(trimethylsilyl)acetamide, bis(trimethylsilyl)carbodiimide, diethylaminotrimethysilane, dimethylaminodimethylsilane, hexamethyldisilazane, hexamethylcyclotrisilazane, heptamethyldisilazane, nonamethyltrisilazane, octamethylcyclotetrasilazane, tetrakisdimethylaminosilane, tetraisocyanatesilane, tetramethyldisilazane, tris(dimethylamino)silane, triethoxyfluorosilane, allyldimethylsilane, allyltrimethylsilane, benzyltrimethylsilane, bis(trimethylsilyl)acetylene, 1,4-bistrimethylsilyl-1,3-butadiine, di-t-butylsilane, 1,3-disilabutane, bis(trimethylsilyl)methane, cyclopentadienyltrimethylsilane, phenyldimethylsilane, phenyltrimethylsilane, propargyltrimethylsilane, tetramethylsilane, trimethylsilylacetylene, 1-(trimethylsilyl)-1-propine, tris(trimethylsilyl)methane, tris(trimethylsilyl)silane, vinyltrimethylsilane, hexamethyldisilane, octamethylcyclotetrasiloxane, tetramethylcyclotetrasiloxane, hexamethylcyclotetrasiloxane, and M silicate 51.

Further, examples of the decomposition gases for decomposing these raw material gases containing silicon to obtain a ceramic layer include hydrogen gas, methane gas, acetylene gas, carbon monoxide gas, carbon dioxide gas, nitrogen gas, ammonium gas, nitrous oxide gas, nitrogen oxide gas, nitrogen dioxide gas, oxygen gas, water vapor, fluorine gas, hydrogen fluoride, trifluoroalcohol, trifluorotoluene, hydrogen sulfide, sulfur dioxide, carbon disulfide, and chlorine gas.

A ceramic layer containing silicon oxide and a nitride, a carbide, or the like can be obtained by appropriately selecting a raw material gas containing silicon and a decomposition gas.

In the atmospheric pressure plasma method, these reactive gases are mainly mixed with a discharge gas which easily become in a plasma state and the resultant is fed into a plasma discharge generator. As a discharge gas, a nitrogen gas and/or an element from Group 18 of the periodic table, specifically, helium, neon, argon, krypton, xenon, radon, or the like is used. Of these, particularly, nitrogen, helium, and argon are preferably used.

A film is formed by mixing the above-described discharge gas and reactive gas and supplying the mixture as a thin film forming (mixing) gas to an atmospheric pressure plasma discharge generator (plasma generator). Although the ratio of the discharge gas and the reactive gas varies depending on the property of the film to be obtained, the reactive gas is supplied at a rate of the discharge gas to the whole mixture gas, of 50% or more.

In the laminated ceramic layer constituting the gas barrier resin base according to the present invention, the ceramic layer mainly composed of silicon oxide according to the present invention containing at least any one of an O atom and a N atom, and a Si atom can be obtained by combining, for example, the above-described organosilicon compound further with an oxygen gas and a nitrogen gas at a specified rate.

The thickness of the ceramic layer according to the present invention is desirably within the range of 10 to 2000 nm in consideration of a gas barrier property and light transmittance while it is preferably 10 to 200 nm for exerting preferable performance in a good balance on the whole further in consideration of flexibility.

Next, each layer of an organic photoelectric conversion element material (constitution layer) constituting an organic photoelectric conversion element will be described.

[Constitution of organic photoelectric conversion element and solar cell]

Preferred modes of the organic photoelectric conversion element of the present invention will be described, however, the present invention is not limited thereto.

The organic photoelectric conversion element is not particularly limited, and it is sufficient that it is an element which has an anode, a cathode and at least one electric power generation layer (a mixed layer of a p type semiconductor and an n type semiconductor, also referred to as a bulk heterojunction layer or an i layer) sandwiched between them, and generates electric current when irradiated with light.

Preferred specific examples of the layer constitution of the organic photoelectric conversion element will be described in the following (i) to (v): (i) Anode/electric power generation layer/cathode; (ii) anode/hole transport layer/electric power generation layer/cathode; (iii) anode/hole transport layer/electric power generation layer/electron transport layer/cathode; (iv) anode/hole transport layer/p type semiconductor layer/electric power generation layer/n type semiconductor layer/electron transport layer/cathode; and (v) anode/hole transport layer/first light-emitting layer/electron transport layer/intermediate electrode/hole transport layer/second light-emitting layer/electron transport layer/cathode.

The electric power generation layer needs to contain a p type semiconductor material which can transport a hole, and an n type semiconductor material which can transport an electron, and these materials may form a heterojunction with substantially two layers or may form a bulk heterojunction having both mixed in a single layer. However, the bulk heterojunction is preferred because of high photoelectric conversion efficiency. The p type semiconductor material and the n type semiconductor material used in the electric power generation layer will be described later.

As the same as the case of an organic EL element, the efficiency of extracting holes and electrons from the anode/cathode, respectively, can be improved by sandwiching the electric power generation layer between a hole transport layer and an electron transport layer and, therefore, the constitutions having those ((ii) and (iii)) are more preferred. The electric power generation layer itself may also be of a constitution in which the electric power generation layer is sandwiched between a layer containing a p type semiconductor material and a layer containing an n type semiconductor material single substance as in (iv) (also referred to as p-i-n constitution) in order to improve the rectification property of holes and electrons (selectivity of carriers extraction). In order to increase the utilization efficiency of sunlight, it may also be of a tandem constitution (constitution in (v)) in which sunlight with different wavelengths is absorbed by respective electric power generation layers.

In order to improve the utilization rate of sunlight (photoelectric conversion efficiency), it is also possible to adopt a constitution of a back contact type organic photoelectric conversion element in which a hole transport layer 14 and an electron transport layer 16 are formed on a pair of comb electrodes, respectively, and a photoelectric conversion portion 15 is arranged thereon, according to a change into the sandwich structure in an organic photoelectric conversion element 10 as illustrated later in Fig. 3.

Further, preferred modes of the organic photoelectric conversion elements of the present invention will be described below in detail.

Fig. 3 is a cross-sectional view illustrating an example of a solar cell consisting of a bulk heterojunction type organic photoelectric conversion element.

In Fig. 3, in a bulk heterojunction type organic photoelectric conversion element 10, a transparent electrode 12, a hole transport layer 17, an electric power generation layer 14 of a bulk heterojunction layer, an electron transport layer 18, and a counter electrode 13 are sequentially laminated on one surface of a substrate 11.

The substrate 11 is a member which holds the transparent electrode 12, the electric power generation layer 14, and the counter electrode 13 which are laminated sequentially. In this embodiment, light to be photoelectrically converted enters from the side of the substrate 11 and, accordingly, the substrate 11 is a member which can transmit light to be photoelectrically converted, namely, a transparent member with respect to the wavelength of light to be photoelectrically converted. As the substrate 11, for example, a glass substrate, a resin substrate, or the like is used. The substrate 11 is not essential and the organic bulk heterojunction type organic photoelectric conversion element 10 may also be constituted by forming the transparent electrode 12 and the counter electrode 13 on both sides of the electric power generation layer 14, for example.

The electric power generation layer 14 is a layer which converts light energy into electric energy, and is constituted of a bulk heterojunction layer in which a p type semiconductor material and an n type semiconductor material are uniformly mixed. A p type semiconductor material relatively functions as an electron donating material (donor), and an n type semiconductor material relatively functions as an electron accepting material (acceptor).

In Fig. 3, light incident from the transparent electrode 12 through the substrate 11 is absorbed by an electron acceptor or an electron donor in the bulk heterojunction layer of the electric power generation layer 14, an electron is transferred from the electron donor to the electron acceptor to form a pair of a hole and an electron (charge separation state). The generated electric charge is transported by an internal electric field, for example, the electric potential difference between the transparent electrode 12 and the counter electrode 13 when the work functions of the transparent electrode 12 and the counter electrode 13 are different, an electron passes between electron acceptors while a hole

passes between electron donors, and then each are transported to different electrodes, and a photocurrent is detected. For example, when the work function of the transparent electrode 12 is larger than the work function of the counter electrode 13, the electron is transported to the transparent electrode 12 and the hole is transported to the counter electrode 13. In addition, if the size of a work function is reversed, the electron and the hole will be transported to the reverse direction to that described above. Moreover, the transportation directions of an electron and a hole are also controllable by applying a potential between the transparent electrode 12 and the counter electrode 13.

In addition, although not described in Fig. 3, it may also have another layer such as a hole blocking layer, an electron blocking layer, an electron injection layer, a hole injection layer, or a smoothening layer.

More preferred constitution is a constitution in which the above-mentioned electric power generation layer 14 is composed of three layered lamination constitution of so-called p-i-n as illustrated in Fig. 4. The common bulk heterojunction layer is a single layer i containing a p type semiconductor material and an n type semiconductor material mixed with each other; but, by sandwiching the i layer 14i between a p layer 14p composed of a p type semiconductor material single substance and an n layer 14n composed of an n type semiconductor material single substance, the rectifying property of a hole and an electron becomes higher, the loss caused by the recombination or the like of a hole and an electron in charge separation state is reduced, and thus still higher photoelectric conversion efficiency can be obtained.

Furthermore, it is also possible to make a tandem type constitution produced by laminating such photoelectric conversion elements for the purpose of improving a sunlight utilization efficiency (photoelectric conversion efficiency).

Fig. 5 is a cross-sectional view illustrating an example of a solar cell consisting of an organic photoelectric conversion element which is provided with a tandem-type bulk heterojunction layer.

In the case of a tandem type constitution, after laminating a transparent electrode 12 and a first electric power generation layer 14' successively on a substrate 11, a charge recombination layer 15 is laminated, thereafter, a second electric power generation layer 16 and then a counter electrode 13 are laminated to achieve a tandem type constitution. The second electric power generation layer 16 may be a layer which absorbs the same spectrum as an absorption spectrum of the first electric power generation layer 14', or it may be a layer which absorbs a different spectrum, however, it is preferably a layer which absorbs a different spectrum. Moreover, both first electric power generation layer 14' and second electric power generation layer 16 may also be of the three layered lamination constitution of p-i-n as mentioned above.

Materials constituting these layers will be described below.

[Organic photoelectric conversion element material]

(p type semiconductor material)

Examples of p type semiconductor materials used in an electric power generation layer (bulk heterojunction layer) in an organic photoelectric conversion element include various condensed polycyclic aromatic low molecular weight compounds and conjugated polymers and oligomers.

Examples of the condensed polycyclic aromatic low molecular weight compounds include compounds such as anthracene, tetracene, pentacene, hexacene, heptacene, chrysene, picene, fulminene, pyrene, peropyrene, perylene, terylene, quoterylene, coronene, ovalene, circumanthracene, bisanthene, zethrene, heptazethrene, pyranthrene, violanthene, isoviolanthene, circobiphenyl, and anthradithiophene; porphyrin, copper phthalocyanine; tetrathiafulvalene (TTF)-tetracyanoquinodimethane (TCNQ) complex, bis(ethylenedithio)tetrathiafulvalene (BEDT-TTF)-perchloric acid complex; and derivatives and precursors thereof.

Examples of the derivatives containing the condensed polycycles described above include pentacene derivatives having a substituent described in International Publication No. WO 03/16599, International Publication No. WO 03/28125, US Patent No. 6,690,029, Japanese Patent Application Laid-Open No. 2004-107216, and the like; pentacene precursors described in US Patent Application Publication No. 2003/136964; acene-based compounds substituted by a trialkylsilylethynyl group described in J. Amer. Chem. Soc., vol. 127. No 14. 4986, J. Amer. Chem. Soc, vol. 123, p 9482, J. Amer. Chem. Soc., vol. 130 (2008), No. 9, 2706, and the like.

Examples of the conjugated polymers include polythiophenes such as poly-3-hexylthiohene (P3HT) and oligomers thereof, polythiophenes having a polymerizable group described in Technical Digest of the International PVSEC-17, Fukuoka, Japan, 2007, P 1225, polythiophene-thienothiophene copolymers described in Nature Material, (2006) vol. 5, p 328, polythiophene-diketopyrrolopyrrole copolymers described in International Publication No. WO 2008/000664, polythiophene-thiazolothiazole copolymers described in Adv Mater, 2007 p 4160, polythiophene copolymers such as PCPDTBT described in Nature Mat., vol. 6 (2007), p 497, polypyrroles and oligomers thereof, polyanilines, polyphenylenes and oligomers thereof, polyphenylenevinylenes and oligomers thereof, polythienylenevinylenes and oligomers thereof, polyacethylene, polydiacetylene, and polymer materials such as $\sigma$-conjugated polymers such as polysilane and polygerman.

As oligomer materials other than polymer materials, oligomers such as $\alpha$-sexithionene $\alpha,\omega$-dihexyl-$\alpha$-sex-

ithionene, α,ω-dihexyl-α-quinquethionene, and α,ω-bis(3-butoxypropyl)-α-sexithionene, which are thiophene hexamers, can be preferably used.

Among these compounds, preferred are compounds which have such high solubility in an organic solvent so as to allow a solution process and which form a crystalline thin film and can realize a high mobility after drying.

When an electron transport layer is formed on an electric power generation layer by a coating method, since there may occur the problem that the solution for the electron transport layer may dissolve the electric power generation layer, there can also be used such a material as to be insoluble after coating a layer by a solution process.

Examples of such materials may include materials insoluble through cross-linked polymerization after being coated, such as polythiophenes having a polymerizable group as described in Technical Digest of the International PVSEC-17, Fukuoka, Japan, 2007, p 1225; materials insoluble (to be pigments) by reaction of a soluble substituent by applying energy such as heat as described in US Patent Application Publication No. 2003/136964, Japanese Patent Application Laid-Open No. 2008-16834, and the like.

(N Type semiconductor materials)

Examples of n type semiconductor materials used in the bulk heterojunction layer in the organic photoelectric conversion element may include, but are not particularly limited to, fullerene, octaazaporphyrin, a perfluoro compound of a p type semiconductor, of which hydrogen atoms are replaced with fluorine atoms (such as perfluoropentacene or perfluorophthalocyanine), and a polymer compound which contains an aromatic carboxylic acid anhydride and its imide as a skeleton, such as naphthalenetetracarboxylic anhydride, naphthalenetetracarboxylic diimide, perylenetetracarboxylic anhydride, or perylenetetracarboxylic diimide.

However, preferred is a fullerene derivative which enables high speed (~ 50 fs) and effective charge separation with varieties of p type semiconductor materials. Examples of the fullerene derivative may include fullerene C60, fullerene C70, fullerene C76, fullerene C78, fullerene C84, fullerene C240, fullerene C540, mixed fullerene, fullerene nano-tube, multilayered nano-tube, single-layered nano-tube, nano-horn (cone type), and the like, and a fullerene derivative obtained by substituting a part thereof with a hydrogen atom, a halogen atom, a substituted or unsubstituted alkyl group, an alkenyl group, an alkynyl group, an aryl group, a heteroaryl group, a cycloalkyl group, a silyl group, an ether group, a thioether group, an amino group, a silyl group, or the like.

Among these, it is preferable to use a fullerene derivative which has an improved solubility by having a substituent, such as [6,6]-phenyl C61-butyric acid methyl ester (abbreviated name: PCBM), [6,6]-phenyl C61-butyric acid-n-butyl ester (PCBnB), [6,6]-phenyl C61-butyric acid-isobutyl ester (PCBiB), [6,6]-phenyl C61 - butyric acid n-hexyl ester (PCBH), bis-PCBM described in Adv. Mater., vol. 20 (2008), p 2116, amino fullerene described in Japanese Patent Application Laid-Open No. 2006-199674, metallocene fullerene described in Japanese Patent Application Laid-Open No. 2008-130889, and fullerene having a cyclic ether group described in US Patent No. 7,329,709.

(Hole transport layer · electron blocking layer)

The organic photoelectric conversion element 10 preferably has the hole transport layer 17 between the bulk heterojunction layer and the anode, since it becomes possible to more effectively extract charges generated in the bulk heterojunction layer.

For the hole transport layer 17, there can be used, for example: PEDOT, such as BaytronP (trade name) manufactured by Starck Vitec Co.; polyaniline and its dope material; a cyan compound described in International Publication No. WO 2006/019270; and the like. In addition, the hole transport layer which has a LUMO level lower than the LUMO level of the n type semiconductor material used in a bulk heterojunction layer is imparted with an electron blocking function having an rectifying effect by which the electron generated in the bulk heterojunction layer is not passed to the anode side. Such a hole transport layer is also called an electron blocking layer, and it is more preferable to use a hole transport layer having such a function. Examples of these materials include triaryl amine-based compounds as described in Japanese Patent Application Laid-Open No. 5-271166, metal oxides such as molybdenum oxide, nickel oxide and tungsten oxide, and the like. Moreover, the layer which includes a single substance of a p type semiconductor material used in the bulk heterojunction layer can also be used. As a means for forming these layers, although any one of a vacuum deposition method and a solution coating method can be used, but preferably used is a solution coating method. When a coated film is formed in an under layer before forming the bulk heterojunction layer, it will have an effect of leveling the coating surface, thus an effect such as leaking is reduced, and therefore desirable.

(Electron transport layer · hole blocking layer)

The organic photoelectric conversion element 10 preferably has the electron transport layer 18 between the bulk heterojunction layer and the cathode, since it becomes possible to more effectively extract charges generated in

the bulk heterojunction layer.

As the electron transport layer 18, octaazaporphyrin and a perfluoro compound of a p type semiconductor (such as perfluoro pentacene or perfluoro phthalocyanine) can be used, and, similarly, the electron transport layer which has a HOMO level deeper than the HOMO level of the p type semiconductor material used for a bulk heterojunction layer is imparted with a hole blocking function having an rectifying effect by which the hole generated in the bulk heterojunction layer is not passed to the cathode side. Such an electron transport layer is also called a hole blocking layer, and it is more preferable to use the electron transport layer which has such a function. As such materials, there can be used phenanthrene-based compounds such as bathocuproine; n type semiconductor materials such as naphthalenetetracarboxylic acid anhydride, naphthalenetetracarboxylic acid diimide, perylenetetracarboxylic acid anhydride and perylenetetracarboxylic acid diimide; n type inorganic oxides such as titanium oxide, zinc oxide and gallium oxide; alkali metal compounds such as lithium fluoride, sodium fluoride and cesium fluoride; and the like. Moreover, the layer composed of a single substance of an n type semiconductor material used in the bulk heterojunction layer can also be used. As a means for forming these layers, although any one of a vacuum deposition method and a solution coating method can be used, preferably used is the solution coating method.

(Other layers)

It is also preferable to have a constitution containing various intermediate layers in an organic photoelectric conversion element for the purpose of improvement in energy conversion efficiency and improvement in lifetime of the element. Examples of the interlayer may include hole blocking layers, electron blocking layers, hole injection layers, electron injection layers, exciton blocking layers, UV absorption layers, light reflection layers, wavelength conversion layers, and the like.

(Transparent electrode: First electrode)

In the organic photoelectric conversion element, the transparent electrode may be a cathode or an anode and can be selected according to the constitution of the organic photoelectric conversion element, but the transparent electrode is preferably used as an anode. For example, when the transparent electrode is used as an anode, it is preferably an electrode which transmits light of 380 to 800 nm. As materials, there can be used, for example, transparent conductive metal oxides such as indium tin oxide (ITO), $SnO_2$, and ZnO, metal thin films such as gold, silver, and platinum, metal nanowires, and carbon nanotubes.

Also usable is a conductive polymer selected from a group consisting of derivatives of polypyrrole, polyaniline, polythiophene, polythienylene vinylene, polyazulene, polyisothianaphthene, polycarbazole, polyacethylene, polyphenylene, polyphenylene vinylene, polyacene, polyphenyl acetylene, polydiacetylene, and polynaphthalene. A transparent electrode can also be constructed by combining a plurality of these conductive compounds.

(Counter electrode: Second electrode)

A counter electrode may also be a sole layer of a conductive material, however, in addition to materials with conductivity, a resin may also be used in combination to hold the materials. As a conductive material for the counter electrode, examples include a material in which a metal, an alloy, or an electric conductive compound, having a small work function (4 eV or less), or a mixture thereof is used as an electrode material. Specific examples of such electrode materials include sodium, sodium-potassium alloy, magnesium, lithium, magnesium/copper mixtures, magnesium/silver mixtures, magnesium/aluminum mixtures, magnesium/indium mixtures, aluminum/aluminum oxide ($Al_2O_3$) mixtures, indium, lithium/aluminum mixtures, rare earth metals, and the like. Among these, from the viewpoints of an electron extracting property and resistance to oxidation or the like, preferred is a mixture of these metals and the second metal which is a metal that has a larger work function and is more stable than these metals, for example, a magnesium/silver mixture, a magnesium/aluminum mixture, a magnesium/indium mixture, an aluminum/aluminum oxide ($Al_2O_3$) mixture, a lithium/aluminum mixture, aluminum, or the like. The counter electrode can be produced by forming a thin film by using a method such as vapor deposition or sputtering of the electrode materials. Further, the (average) film thickness is generally selected from a range of 10 nm to 5 $\mu$m, and preferably from 50 to 200 nm.

When a metallic material is used as a conductive material for a counter electrode, light from the counter electrode side is reflected and it is reflected to the first electrode side, this light becomes possible to be used again, and then according to re-absorption by a photoelectric conversion layer, an improvement in its photoelectric conversion efficiency is obtained, and therefore the metallic material is preferable.

The counter electrode 13 may also be made of a metal (for example, gold, silver, copper, platinum, rhodium, ruthenium, aluminum, magnesium, indium, or the like), nanoparticles made of carbon, nanowires, or a nano structure and a dispersion of nanowires is preferable, since it can form a transparent counter electrode having high electrical

conductivity by a coating method.

When the counter electrode side is prepared to be light transmitting, after producing a thin film of a conductive material suitable for a counter electrode, for example, aluminum and aluminum alloy, silver, a silver compound, and the like, and having a (average) film thickness of around 1 to 20 nm, a light transmitting counter electrode can be produced by disposing a film of a conductive light transmitting material cited for the description of the above-described transparent electrode.

(Intermediate electrode)

As a material for an intermediate electrode which is needed in a tandem constitution as described in the above-mentioned (v) (or in Fig. 5), preferred is a layer using the compound having both transparency and electrical conductivity, and materials used for the above-mentioned transparent electrode are usable (a transparent metal oxide such as ITO, AZO, FTO, or titanium oxide; a very thin metal layers made of Ag, Al, or Au; a layer containing nanoparticles and nanowires; a conductive polymer material such as PEDOT: PSS or polyaniline; and the like).

In addition, among the aforementioned hole transport layer and electron transport layer, there may be a combination used as an intermediate electrode (electric charge recombination layer) when they are suitably combined and laminated with each other, and, when such a constitution is employed, it is preferable since a step for forming a layer can be eliminated.

(Metal nanowire)

A conductive fiber can be used in the organic photoelectric conversion element, an organic or inorganic fiber coated with a metal, a conductive metal oxide fiber, a metal nanowire, a carbon fiber, a carbon nanotube, or the like can be used as the conductive fiber. However, a metal nanowire is preferred.

Generally, a metal nanowire indicates a linear structure composed of a metallic element as a main component. In particular, the metal nanowire in accordance with the present invention means a linear structure having a diameter of a nanometer (nm) size.

In order to form a long conductive path by one metal nanowire and to express an appropriate light scattering property, a metal nanowire according to the present invention preferably has an average length of 3 $\mu$m or more, more preferably 3 to 500 $\mu$m, and particularly preferably 3 to 300 $\mu$m. In addition, the relative standard deviation of the length is preferably 40% or less. Moreover, from the viewpoint of transparency, the average diameter is preferably smaller while the average diameter is preferably larger from the viewpoint of electrical conductivity. In accordance with the present invention, the average diameter of the metal nanowire is preferably from 10 to 300 nm, and more preferably from 30 to 200 nm. In addition, the relative standard deviation of the diameter is preferably 20% or less.

There is no restriction in particular to the metal composition of the metal nanowire according to the present invention, and it can be composed of one or a plurality of metals of noble metal elements or base metal elements; it preferably contains at least one metal belonging to the group consisting of noble metals (for example, gold, platinum, silver, palladium, rhodium, iridium, ruthenium, osmium, and the like), iron, cobalt, copper, and tin; and at least silver is preferably included therein from the viewpoint of electrical conductivity. Moreover, for the purpose of achieving compatibility of conductivity and stability (sulfuration or oxidation resistance and migration resistance of metal nanowire), it also preferably contains silver and at least one metal belonging to the noble metals except silver. When the metal nanowire according to the present invention contains two or more metallic elements, for example, the surface and the inside of the metal nanowire may have different metal composition from each other or the whole metal nanowire may have the same metal composition.

In accordance with the present invention, there is no limitation in particular to a means for producing a metal nanowire but, for example, a known method such as a liquid phase method or a gas phase method may be used. There is also no limitation in particular to a specific production method, and a known production method may be used. For example, a method for producing an Ag nanowire may be referred to Adv. Mater., 2002, 14, 833-837; Chem. Mater., 2002, 14, 4736-4745, and the like; a method for producing an Au nanowire may be referred to Japanese Patent Application Laid-Open No. 2006-233252 and the like; a method for producing a Cu nanowire may be referred to Japanese Patent Application Laid-Open No. 2002-266007 and the like; and a method for producing a Co nanowire may be referred to Japanese Patent Application Laid-Open No. 2004-149871 and the like. Particularly, the methods for producing Ag nanowires, reported in Adv. Mater. and Chem. Mater. as mentioned above, may be preferably applied as a method for producing a metal nanowire according to the present invention, since it is possible to easily produce an Ag nanowire in an aqueous system and the electrical conductivity of silver is the highest among all metals.

In accordance with the present invention, a three-dimensional conductive network is formed by mutual contact of metal nanowires and high conductivity is expressed, light can penetrate the window part of the conductive network in which no metal nanowire is present, and further, it becomes possible to perform efficiently the generation of electricity

from the organic photoelectric conversion layer portion by the scattering effect of the metal nanowires. It is a preferred embodiment to arrange a metal nanowire in a portion closer to the organic electric power generation layer portion in the first electrode because the scattering effect can be more effectively utilized.

(Optical functional layer)

The organic photoelectric conversion element of the present invention may include various optical function layers for the purpose of efficiently receiving sunlight. As an optical function layer, there may be disposed, for example, an anti-reflection film; a light condensing layer such as a microlens array; a light diffusion layer which can scatter light reflected by the cathode and can make the light incident again on the electric power generation layer; and the like.

As anti-reflection layers, various known anti-reflection layers can be disposed; for example, when a transparent resin film is a biaxially stretched polyethylene terephthalate film, it is preferable to set the refractive index of the adhesion assisting layer, which is adjacent to the film, to be from 1.57 to 1.63 since this will improve transmittance by decreasing the interface reflection between the film substrate and the adhesion assisting layer. As a method of adjusting a refractive index, it can be carried out by appropriately adjusting the ratio of a binder resin to an oxide sol having a relatively high refractive index such as a tin oxide sol or a cerium oxide sol and by coating it. Although the adhesion assisting layer may be a single layer, in order to improve an adhesion property, a constitution of two or more layers may also be used.

Regarding the light condensing layer, it is possible to increase an amount of the receiving light from a specific direction or, conversely, to reduce the incident angle dependency of sunlight by performing processing to dispose a structure of a microlens array shape on the sunlight receiving side of the supporting substrate or by using in combination with a so-called light condensing sheet.

As an example of a microlens array, there is made an arrangement in which the quadrangular pyramidal forms having a side of 30 $\mu$m and a vertex angle of 90 degrees are two-dimensionally arranged on the light extracting side of a substrate. One side is preferably in the range of 10 to 100 $\mu$m. When it is less than this range, the effect of diffraction will occur to result in coloring, while when it is more than this range, the thickness becomes large, and thus it is not preferable.

Further, examples of light scattering layers may include various anti-glare layers; layers in which nanoparticles, nanowires, and the like made of metals, various inorganic oxides, and the like are dispersed in colorless transparent polymers.

(Film production method · surface treatment method)

<Method for forming various layers>

Examples of methods for forming a bulk heterojunction layer in which an electron acceptor and an electron donor are mixed, and a transport layer and an electrode may include vapor deposition methods, coating methods (including cast methods and spin coat methods), and the like. Of these, examples of methods for forming a bulk heterojunction layer may include vapor deposition methods, coating methods (including cast methods and spin coat methods), and the like. Among these, a coating method is preferred in order to increase the area of the interface at which charge separation of the above-mentioned hole and electron occurs and to produce an element having high photoelectric conversion efficiency. Further, the coating method is also excellent in production rate.

Although there is no limitation in the coating method to be used in this case, examples of the method include spin coating methods, cast methods from a solution, dip coating methods, blade coating methods, wire bar coating methods, gravure coating methods, spray coating methods, and the like. Furthermore, pattering can also be carried out by printing methods such as inkjet methods, screen printing methods, letterpress printing methods, intaglio printing methods, offset printing methods, flexographic printing methods, and the like.

After coating, it is preferable to perform heating in order to remove the residual solvent, water, and a gas, as well as to improve the mobility and to shift the absorption in the longer wavelength due to crystallization of a semiconductor material. When an annealing treatment is carried out at a predetermined temperature during a production step, aggregation or crystallization is microscopically and partially promoted and a suitable phase separation structure can be yielded in a bulk heterojunction layer. As a result, the carrier mobility of the bulk heterojunction layer is improved and high efficiency can be obtained.

The electric power generation layer (bulk heterojunction layer) 14 may be constituted by a single layer containing a uniform mixture of an electron acceptor and an electron donor or may be constituted by a plurality of layers each having a different mixing ratio of an electron acceptor and an electron donor. In this case, the formation can be made by using such a material which becomes insoluble after coating as mentioned above.

<Patterning>

There is no limitation in particular in the method and the process of patterning an electrode, an electric power generation layer, a hole transport layer, an electron transport layer, and the like in the production of the organic photoelectric conversion element of the present invention, and a known method can be applied appropriately.
In the case of a soluble material for a bulk heterojunction layer, a transport layer, or the like, only a unnecessary part may be wiped off after whole-surface coating such as die coating or dip coating or it may be directly patterned during coating by using a method such as an inkjet method or a screen printing method.
In the case of an insoluble material such as an electrode material, mask deposition of an electrode can be performed during vacuum deposition or it can be patterned by a known method such as etching or lift-off. Further, it may also be possible to form a pattern by transferring the pattern formed on another substrate.
Although the constitution of the organic photoelectric conversion element and the solar cell was described above as an example of applications of the gas barrier film according to the present invention, the applications of the gas barrier film according to the present invention are not limited thereto but it can also be advantageously applied to other electronic devices such as organic EL elements.

EXAMPLES

The present invention will be specifically described with reference to examples below but the present invention is not limited thereto. In addition, in examples, the expression of (part (s)) or (%) represents (part (s) by mass) or (% by mass), unless specifically described otherwise.

Example 1

«Preparation of gas barrier film»

[Preparation of base (a)]

As a thermoplastic resin base (base), by using a polyester film (super low heat shrinkage PET Q83, manufactured by Teijin duPont Films Japan Limited) having a thickness of 125 μm, both surfaces of which are subjected to an easy adhesion treatment, and as will be described later, a bleed out preventing layer 1 was formed on one surface of the base, and a smooth layer 1 was formed on the other surface of the base, which is opposite to the bleed out preventing layer 1, the base being interposed therebetween, and thus a base (a) was prepared. Meanwhile, PET is an abbreviation of polyethylene terephthalate.

(Preparation of bleed out preventing layer 1)

On one surface of the above-described thermoplastic resin base, a UV curable organic/inorganic hybrid hard coat material OPSTAR Z7535 manufactured by JSR Corporation was applied so that the film thickness is 4.0 μm after drying, then the applied hard coat material was subjected to a curing treatment by using a high pressure mercury lamp, in an air atmosphere with an irradiation energy amount of 1.0 J/cm$^2$, under a drying conditions of 80°C for 3 minutes, and thus the bleed out preventing layer 1 was formed.

(Formation of smooth layer 1)

Subsequently, on a surface opposite to the surface on which the bleed out preventing layer 1 of the above-described thermoplastic resin base was formed, a UV curable organic/inorganic hybrid hard coat material OPSTAR Z7501 manufactured by JSR Corporation was applied so that the film thickness is 4.0 μm after drying, and then the applied hard coat material was dried at 80°C for 3 minutes. Next, the dried hard coat material was irradiated with an irradiation energy amount of 1.0 J/cm$^2$ in an air atmosphere by using a high pressure mercury lamp, and cured, and thus a smooth layer 1 was formed.
The surface roughness Rz on the surface of the smooth layer 1 formed by the above-described method was around 25 nm as measured in accordance to the method defined by JIS B 0601.
Meanwhile, the surface roughness was measured by using an AFM (atomic force microscope), SPI3800N DFM manufactured by Seiko Instruments Inc. The range per one measurement was set to 80 μm × 80 μm, and the measurement was performed three times at different measurement points, and the average of the Rz values that were obtained from each measurement was taken as the measured value.
Further, the linear expansion coefficient of the base (a) prepared in the above was measured according to the

following method. As a result, it was found to be 65 ppm/°C.

By using a thermal stress-strain measuring device, EXSTAR TMA/SS6000 type manufactured by Seiko Instruments Inc., the temperature of the base (a) to be measured was increased from 30°C to 50°C at a rate of 5°C per minute under a nitrogen atmosphere, and then held once. The temperature was increased again at a rate of 5°C per minute, and the base (a) was measured at 30 to 150°C to measure the linear expansion coefficient.

[Preparation of base (b)]

As a base having low retardation, a transparent polycarbonate film (Pure Ace, manufactured by Teijin Chemicals Ltd.) having a thickness of 100 μm was used and as will be described later, smooth layers 2 and 3 were formed on both surfaces of the base, and thus a base (b) was prepared.

(Preparation of smooth layer coating liquid A)

8.0 g of trimethylolpropane triglycidyl ether (EPOLIGHT 100 MF, manufactured by KYOEISHA CHEMICAL CO., LTD), 5.0 g of ethylene glycol diglycidyl ether (EPOLIGHT 40E, manufactured by KYOEISHA CHEMICALS Co., LTD), 12.0 g of silsesquioxane having an oxetanyl group: OX-SQ-H (manufactured by TOAGOSEI CO., LTD.), 32.5 g of 3-glycidoxypropyltrimethoxysilane, 2.2 g of Al (III) acetylacetonate, 134.0 g of methanol silica sol (solid content concentration: 30% by mass, manufactured by Nissan Chemical Industries, Ltd.), 0.1 g of BYK333 (a silicone-based surfactant, manufactured by BYK Japan KK), 125.0 g of butyl cellosolve, and 15.0 g of 0.1 mol/L hydrochloric acid aqueous solution were mixed and thoroughly stirred. The mixture was further allowed to stand and degassed at room temperature to prepare a smooth layer coating liquid A.

(Formation of smooth layer 2)

One surface of the above-described heat resistant base was subjected to a corona discharge treatment by a conventional method, then the above-prepared smooth layer coating liquid A was applied so that the film thickness of the smooth layer after drying is 4.0 μm, and then the applied coating liquid was dried at 80°C for 3 minutes. Further, it was subjected to a heating treatment at 120°C for 10 minutes to form a smooth layer 2.

(Formation of smooth layer 3)

On a surface opposite to the surface on which the smooth layer 2 of the above-described heat resistant base was formed, a smooth layer 3 was formed by using the same method as that of the smooth layer 2.

The surface roughness of each of the formed smooth layer 2 and smooth layer 3 was measured according to the method described in JIS B 0601. As a result, all the surface roughness Rz values were around 20 nm. Meanwhile, the measurement of the surface roughness was performed by using the same method as that in the description of base (a).

Further, the linear expansion coefficient of the base (b) prepared in the above was measured by using the same method as that in the description of base (a), and the linear expansion coefficient was 40 ppm/°C.

[Preparation of base (c)]

Except that as a heat resistant base, Silplus H100 having a thickness of 100 μm manufactured by Nippon Steel Chemical Co., Ltd., which is a film in which silsesquioxane having an organic-inorganic hybrid structure is used as a basic skeleton, was used instead of a transparent polyimide-based film (Neopulim L, manufactured by Mitsubishi Gas Chemical Company, Inc.) having a thickness of 200 μm in which easy adhesion processing is performed for both surfaces of a base, a base (c) was prepared by using the same method as that of base (b). In addition, the surface roughness of each of the smooth layer 2 and smooth layer 3 of base (c) was measured by using the same method as above, and all the surface roughness Rz values were around 20 nm.

Further, the linear expansion coefficient of the prepared base (c) prepared in the above was measured by using the same method as above, and the linear expansion coefficient was 80 ppm/°C.

[Formation of first barrier layer]

A first barrier layer of silicon oxide was formed on a transparent resin base (polyethylene terephthalate (PET) film with clear hard coat layer (CHC) manufactured by Kimoto Co., Ltd., in which the hard coat layer is formed of a ultraviolet curing resin containing an acrylic resin as a main component (PET thickness 125 μm, CHC thickness 6 μm)) according to atmospheric plasma method using a plasma CVD apparatus, Model PD-270STP, manufactured by Samco

Inc., under the following thin film formation conditions.

(Thin film formation conditions)

Discharge gas: Nitrogen gas 94.9% by volume
Reactive gas: Tetraethoxysilane (TEOS) 5 sccm (standard cubic centimeter per minute), concentration 0.5%
Addition gas: Oxygen gas 5.0% by volume
Oxygen pressure: 53.2 Pa
Power: 100 W at 13.56 MHz
Base retention temperature: 120°C

<First electrode side>

Type of power source: PHF-6k, 100 kHz (continuous mode), manufactured by HAIDEN LABORATORY, Co., Ltd.
Frequency: 100 kHz
Output density: 10 $W/cm^2$
Electrode temperature: 120°C

<Second electrode side>

Type of power source: 13.56 MHz CF-5000-13M, manufactured by PEARL KOGYO Co., Ltd.
Frequency: 13.56 MHz
Output density: 10 $W/cm^2$
Electrode temperature: 90°C

The first barrier layer 1 formed according to the method described above was composed of silicon oxide ($SiO_2$) and the film thickness was adjusted to the film thickness shown in Table 1 by controlling the time for film formation. The elastic modulus was equally 30 GPa (=E1) in a film thickness direction.

[Formation of second barrier layer]

(Formation of polysilazane layer)

On the base and the first barrier layer described above, a polysilazane-containing coating liquid for forming a second barrier layer shown below was applied by using a spin coater so that the film thickness after drying has the value shown in the table, and thus a polysilazane layer was formed. The drying was performed at 100°C for 2 minutes.

<Preparation of coating liquid for forming second barrier layer>

By using a mixture of a dibutyl ether solution containing 20% by mass of catalyst-free perhydropolysilazane (AQUAMICA NN120-20 manufactured by AZ Electronic Materials) and a dibutyl ether solution containing 20% by mass of perhydropolysilazane in which an amine catalyst is contained in an amount of 5% by mass in terms of solid content (AQUAMICA NAX120-20 manufactured by AZ Electronic Materials), an amine catalyst was adjusted to be 1% by mass in terms of solid content, then the resultant mixture was diluted with dibutyl ether, and thus a coating liquid for forming a water vapor barrier layer was prepared as a dibutyl ether solution having a total solid content of 2% by mass.

<Vacuum ultraviolet irradiation treatment>

The second barrier layer was formed by performing a vacuum ultraviolet irradiation treatment on the polysilazane layer according to the following conditions. The second barrier layer formed above was dried at 100°C for 2 minutes, and then subjected to an excimer conversion treatment by the following device and the following conditions to convert the polysilazane layer. Thus, the second barrier layer that is a polysilazane converted layer was formed. The conversion

treatment was performed at a dew-point temperature of -20°C.

(Vacuum ultraviolet irradiation device)

1) Vacuum ultraviolet irradiation device: excimer irradiation device MODEL: MECL-M-1-200 manufactured by M.D.COM. Inc.
2) Irradiation ultraviolet wavelength: 172 nm
3) Lamp sealing gas: Xe

<Conditions for conversion treatment>

1) Excimer light intensify: 130 mW/cm$^2$ (172 nm)
2) Distance between sample and light source: 2 mm
3) Stage heating temperature: 95°C
4) Oxygen concentration in irradiation device: 0.3%
5) Rate of stage conveyance at excimer light irradiation: 10 mm/sec
6) Number of stage conveyances at excimer light irradiation: 6 round trips

Energy irradiated to the surface of the sample application layer in the vacuum ultraviolet irradiation step was measured by using an ultraviolet accumulated actinometer manufactured by Hamamatsu Photonics K.K.: C8026/H8025 UV POWER METER, and using a sensor head with 172 nm. Based on the irradiation energy obtained by this measurement, the moving rate of sample stage was adjusted so that the accumulated light has the value shown in the table. In addition, vacuum ultraviolet irradiation was performed in the same manner as in the measurement of irradiation energy, that is, after the aging for 10 minutes.

[Formation of protective layer]

(Formation of polysiloxane layer)

On a surface of the sample having the second barrier layer formed thereon, the following polysiloxane-containing coating liquid for forming a protective layer was applied by a spin coater under the conditions that the film thickness after drying has the value shown in the table, and thus a polysiloxane layer was formed. The drying conditions were 120°C and for 20 minutes.

<Preparation of coating liquid for forming protective layer>

(GLASCA HPC 7003) and (GLASCA HPC 404H), manufactured by JSR Corporation, were mixed at a ratio of 10 : 1. Next, this mixture was diluted 2 times with butanol, further 5.0% of butyl cellosolve was added to the diluted mixture, and thus a coating liquid 14 for forming protective layer was prepared. The solid content of the coating liquid 14 for forming protective layer was 10%.

<Conversion treatment of polysiloxane layer: Vacuum ultraviolet ray irradiation treatment>

After forming a polysiloxane layer as described above, a protective layer was formed in the same manner as the formation of the second barrier layer described above by using an apparatus for vacuum ultraviolet ray irradiation treatment, which has the same constitution as that used for the conversion treatment of the second barrier layer, except that the accumulated light amount of vacuum ultraviolet ray is changed to 1000 mJ/cm$^2$. The accumulated light amount was controlled to have the value shown in the table.
Physical properties and composition of each gas barrier film 1 to 29 prepared according to the above method are shown in Table 1 below.

[Table 1]

| Sample number | Type of base | First barrier layer | Second barrier layer | | Protective layer | | Polysiloxane layer |
|---|---|---|---|---|---|---|---|
| | | Film thickness | Film thickness | Accumulated light amount of vacuum ultraviolet ray | Film thickness | Accumulated light amount of vacuum ultraviolet ray | Film density |
| | | (nm) | (nm) | ($mJ/cm^2$) | (nm) | ($mJ/cm^2$) | ($g/cm^3$) |
| 1 | b | 200 nm | - | - | - | - | - |
| 2 | b | 200 nm | 100 nm | 3000 $mJ/cm^2$ | - | - | - |
| 3 | b | - | 100 nm | 3000 $mJ/cm^2$ | 500 nm | 2000 $mJ/cm^2$ | 0.8 $g/cm^3$ |
| 4 | a | 200 nm | 100 nm | 3000 $mJ/cm^2$ | 500 nm | 2000 $mJ/cm^2$ | 0.8 $g/cm^3$ |
| 5 | b | 200 nm | 100 nm | 3000 $mJ/cm^2$ | 500 nm | 2000 $mJ/cm^2$ | 0.8 $g/cm^3$ |
| 6 | c | 200 nm | 100 nm | 3000 $mJ/cm^2$ | 500 nm | 2000 $mJ/cm^2$ | 0.8 $g/cm^3$ |
| 7 | b | 1 nm | 100 nm | 3000 $mJ/cm^2$ | 500 nm | 2000 $mJ/cm^2$ | 0.8 $g/cm^3$ |
| 8 | b | 10 nm | 100 nm | 3000 $mJ/cm^2$ | 500 nm | 2000 $mJ/cm^2$ | 0.8 $g/cm^3$ |
| 9 | b | 500 nm | 100 nm | 3000 $mJ/cm^2$ | 500 nm | 2000 $mJ/cm^2$ | 0.8 $g/cm^3$ |
| 10 | b | 1000 nm | 100 nm | 3000 $mJ/cm^2$ | 500 nm | 2000 $mJ/cm^2$ | 0.8 $g/cm^3$ |
| 11 | b | 1500 nm | 100 nm | 3000 $mJ/cm^2$ | 500 nm | 2000 $mJ/cm^2$ | 0.8 $g/cm^3$ |
| 12 | b | 200 nm | 5 nm | 3000 $mJ/cm^2$ | 500 nm | 2000 $mJ/cm^2$ | 0.8 $g/cm^3$ |
| 13 | b | 200 nm | 10 nm | 3000 $mJ/cm^2$ | 500 nm | 2000 $mJ/cm^2$ | 0.8 $g/cm^3$ |
| 14 | b | 200 nm | 500 nm | 3000 $mJ/cm^2$ | 500 nm | 2000 $mJ/cm^2$ | 0.8 $g/cm^3$ |
| 15 | b | 200 nm | 1000 nm | 3000 $mJ/cm^2$ | 500 nm | 2000 $mJ/cm^2$ | 0.8 $g/cm^3$ |
| 16 | b | 200 nm | 1500 nm | 3000 $mJ/cm^2$ | 500 nm | 2000 $mJ/cm^2$ | 0.8 $g/cm^3$ |
| 17 | b | 200 nm | 100 nm | 500 $mJ/cm^2$ | 500 nm | 2000 $mJ/cm^2$ | 0.8 $g/cm^3$ |
| 18 | b | 200 nm | 100 nm | 1000 $mJ/cm^2$ | 500 nm | 2000 $mJ/cm^2$ | 0.8 $g/cm^3$ |
| 19 | b | 200 nm | 100 nm | 5000 $mJ/cm^2$ | 500 nm | 2000 $mJ/cm^2$ | 0.8 $g/cm^3$ |
| 20 | b | 200 nm | 100 nm | 10000 $mJ/cm^2$ | 500 nm | 2000 $mJ/cm^2$ | 0.8 $g/cm^3$ |
| 21 | b | 200 nm | 100 nm | 15000 $mJ/cm^2$ | 500 nm | 2000 $mJ/cm^2$ | 0.8 $g/cm^3$ |
| 22 | b | 200 nm | 100 nm | 3000 $mJ/cm^2$ | 5 nm | 2000 $mJ/cm^2$ | 0.39 $g/cm^3$ |
| 23 | b | 200 nm | 100 nm | 3000 $mJ/cm^2$ | 200 nm | 2000 $mJ/cm^2$ | 0.49 $g/cm^3$ |
| 24 | b | 200 nm | 100 nm | 3000 $mJ/cm^2$ | 1000 nm | 2000 $mJ/cm^2$ | 0.97 $g/cm^3$ |
| 25 | b | 200 nm | 100 nm | 3000 $mJ/cm^2$ | 500 nm | 2000 $mJ/cm^2$ | 1.16 $g/cm^3$ |
| 26 | b | 200 nm | 100 nm | 3000 $mJ/cm^2$ | 500 nm | 2000 $mJ/cm^2$ | 0.8 $g/cm^3$ |
| 27 | b | 200 nm | 100 nm | 3000 $mJ/cm^2$ | 500 nm | 300 $mJ/cm^2$ | 1.15 $g/cm^3$ |
| 28 | b | 200 nm | 100 nm | 3000 $mJ/cm^2$ | 500 nm | 1000 $mJ/cm^2$ | 0.47 $g/cm^3$ |
| 29 | b | 200 nm | 100 nm | 3000 $mJ/cm^2$ | 500 nm | 15000 $mJ/cm^2$ | 0.38 $g/cm^3$ |

<<Evaluation of water vapor barrier property>>

<Apparatus used for evaluation of water vapor barrier property>

Deposition apparatus: vacuum deposition apparatus, JEE-400 manufactured by JEOL Ltd.

Constant temperature and humidity oven: Yamato Humidic Chamber IG47M

<Raw material used for evaluation of water vapor barrier property>

Metal corroded by reacting with water: calcium (granular)

Water vapor impermeable metal: aluminum (average ϕ: 4 mm, granular)

[Preparation of sample for evaluation of water vapor barrier property]

By using the vacuum deposition apparatus (a vacuum deposition apparatus, JEE-400 manufactured by JEOL Ltd.), on the surface on which a water vapor barrier layer of each of the barrier films prepared above, metal calcium was deposited in a size of 12 mm × 12 mm via a mask.

Thereafter, the mask was removed while remaining in the vacuum state, aluminum was deposited on the whole surface on one side of a sheet to temporarily seal the surface. Subsequently, the vacuum state was released, the resultant sheet was promptly transferred into a dry nitrogen gas atmosphere, quartz glass having a thickness of 0.2 mm was bonded on the deposited aluminum surface via an ultraviolet curable resin for sealing (manufactured by Nagase ChemteX Corporation), the resultant sheet was irradiated with ultraviolet ray, and the resin was cured and bonded to seal completely the surface, and thus each of samples for water vapor barrier property evaluation was prepared.

[Measurement of water vapor barrier property]

The obtained samples for water vapor barrier property evaluation was stored at a high temperature and high humidity environment of 85°C and 90%RH for 1000 hours, 100 hours, and 10 hours, respectively, and then the area in which the metal calcium had corroded was measured with the expression of % to the area with a size of 12 mm × 12 mm in which the metal calcium had deposited, and thus water vapor barrier property 1 was evaluated in accordance with the following criteria.

○: the area in which the metal calcium had corroded was less than 1.0% of the total area.
Δ: the area in which the metal calcium had corroded was 1.0% or more to less than 5.0% of the total area.
×: the area in which the metal calcium had corroded was 5.0% or more of the total area.

[Evaluation of bending resistance]

Each of the gas barrier films was repeatedly bent 100 times at an angle of 180 degrees to form a curvature radius of 10 mm, and then the water vapor permeability was measured according to the same method as described above. From a change in the water vapor permeability before and after the bending treatment, the deterioration resistance was measured according to the following equation and the bending resistance was evaluated according to the following criteria.

[Mathematical Formula 1]

Deterioration resistance = (Water vapor permeability after bending test/Water vapor permeability before bending test) x 100 (%)

○: the deterioration resistance was 80% or higher,

Δ: the deterioration resistance was 30% or higher but lower than 80%, and
×: the deterioration resistance was lower than 30%.

[Measurement of water resistance]

[Heating · water immersion treatment]

Each gas barrier film was maintained for 24 hours in a constant temperature dryer at 100°C. After that, it was immersed in pure water at 25°C for 24 hours. Further, by subsequently maintaining it in a constant temperature dryer at 100°C for 24 hours, the heating and water immersion treatment was performed. Each obtained sample for evaluation of water vapor barrier property was stored at high temperature and high humidity environment of 85°C and 90%RH for 100 hours, then the area in which the metal calcium had corroded was measured with the expression of % to the area with a size of 12 mm × 12 mm in which the metal calcium had deposited, and thus water vapor barrier property 1 was evaluated in accordance with the following criteria.

○: the area in which the metal calcium had corroded was less than 1.0% of the total area,
Δ: the area in which the metal calcium had corroded was 1.0% or more to less than 5.0% of the total area, and
×: the area in which the metal calcium had corroded was 5.0% or more of the total area.

[Evaluation of cutting process suitability]

After cutting each gas barrier film with Disc cutter DC-230 (manufactured by CADL, Ltd.) to a piece of B5 size, the edge portion of the cut piece was observed with a magnifier to determine the total number of cracks occurred on four sides. The cutting process suitability was evaluated according to the following criteria.

○: No crack is observed,
Δ: The occurrence number of cracks was 1 or more and 5 or less, and
×: The occurrence number of cracks was 6 or more and 10 or less.

The test results of barrier property, the bending resistance (bending property), and water resistance, which have been obtained according to the above evaluation and measurement, are shown in Table 2.

[Table 2]

| Sample number | Barrier property | | | Bending resistance | Water resistance | Cutting process suitability |
|---|---|---|---|---|---|---|
| | 85°C 90%RH Addition time | | | | | |
| | 10 Hours | 100 Hours | 1000 Hours | 100 Hours | 100 Hours | 100 Hours |
| 1 | × | × | × | × | × | × |
| 2 | ○ | ○ | × | ○ | Δ | × |
| 3 | ○ | Δ | × | ○ | Δ | × |
| 4 | ○ | ○ | ○ | ○ | ○ | ○ |
| 5 | ○ | ○ | ○ | ○ | ○ | ○ |
| 6 | ○ | ○ | ○ | ○ | ○ | ○ |
| 7 | Δ | Δ | Δ | Δ | Δ | Δ |
| 8 | ○ | ○ | Δ | Δ | ○ | Δ |
| 9 | ○ | ○ | ○ | ○ | ○ | ○ |
| 10 | ○ | ○ | ○ | ○ | ○ | ○ |
| 11 | ○ | ○ | ○ | Δ | ○ | Δ |
| 12 | Δ | Δ | Δ | Δ | Δ | Δ |

(continued)

| Sample number | Barrier property | | | Bending resistance | Water resistance | Cutting process suitability |
|---|---|---|---|---|---|---|
| | 85°C 90%RH Addition time | | | | | |
| | 10 Hours | 100 Hours | 1000 Hours | 100 Hours | 100 Hours | 100 Hours |
| 13 | ○ | ○ | Δ | Δ | Δ | Δ |
| 14 | ○ | ○ | ○ | ○ | ○ | ○ |
| 15 | ○ | ○ | ○ | ○ | ○ | ○ |
| 16 | ○ | ○ | ○ | Δ | ○ | Δ |
| 17 | Δ | Δ | Δ | Δ | Δ | Δ |
| 18 | ○ | ○ | ○ | ○ | Δ | ○ |
| 19 | ○ | ○ | ○ | ○ | ○ | ○ |
| 20 | ○ | ○ | ○ | ○ | ○ | ○ |
| 21 | ○ | ○ | ○ | Δ | ○ | ○ |
| 22 | Δ | Δ | Δ | Δ | Δ | Δ |
| 23 | ○ | ○ | ○ | ○ | ○ | Δ |
| 24 | ○ | ○ | ○ | ○ | ○ | ○ |
| 25 | ○ | ○ | ○ | Δ | ○ | Δ |
| 26 | Δ | Δ | Δ | Δ | Δ | ○ |
| 27 | ○ | ○ | Δ | ○ | Δ | Δ |
| 28 | ○ | ○ | ○ | ○ | ○ | Δ |
| 29 | ○ | ○ | ○ | Δ | ○ | Δ |

Example 2

«Preparation of organic EL element»

By using each of the gas barrier films prepared in Example 1 as a sealing film, organic EL elements 1 to 29 were prepared as an example of an electronic device, in accordance with the following method.

[Formation of transparent conductive film]

On each of the barrier layers of each of the gas barrier films prepared in Example 1, a transparent conductive film was prepared in accordance with the following method.

By using an apparatus of parallel plate type electrodes as a plasma discharge device, each of the above-described gas barrier film 1 to 29 was placed between the electrodes, to which mixed gas was introduced so as to form a thin film. In addition, as an earth (ground) electrode, an electrode that was obtained by coating an alumina sprayed film that has high density and high adhesion, on a stainless steel plate of 200 mm × 200 mm × 2 mm, then by applying a solution in which tetramethoxysilane had been diluted with ethyl acetate and drying the applied solution, then by curing the dried resultant with ultraviolet irradiation so as to perform a sealing treatment, by polishing and smoothening the surface of the dielectric that was coated in this manner, and by processing the resultant so that Rmax is 5 μm, was used. Further, as an application electrode, an electrode that was obtained by coating a dielectric material to a hollow square pure titanium pipe under the same conditions as those of the earth electrode was used. Multiple electrodes of the application electrode were prepared, and were provided so as to be opposed to the earth electrode to form a discharge space. In addition, by using a high frequency power source, CF-5000-13M manufactured by PEARL KOGYO Co., Ltd. as a power source used in plasma generation, electric power at a frequency of 13.56 MHz and 5 W/cm$^2$ was supplied.

Further, a mixed gas of the following composition was filled between electrodes so as to have a plasma state,

the surface of the above-described gas barrier film was subjected to an atmospheric pressure plasma treatment, a tindoped indium oxide (ITO) film was formed in a thickness of 100 nm on each of the water vapor barrier layers, and thus samples 1 to 29 in which a transparent conductive film had been formed were obtained.

Discharge gas: helium, 98.5% by volume
Reactive gas 1: oxygen, 0.25% by volume
Reactive gas 2: indium acetylacetonate, 1.2% by volume
Reactive gas 3: dibutyl tin diacetate, 0.05% by volume

[Preparation of organic EL element]

100 mm × 100 mm of each of samples 1 to 29 in which the obtained transparent conductive film had been formed was used as a substrate, to which patterning was performed, and then a gas barrier film substrate in which this ITO transparent electrode had been provided was subjected to ultrasonic cleaning with isopropyl alcohol, and the resultant substrate was dried with dry nitrogen gas. This transparent supporting substrate was fixed to a substrate holder of a vacuum deposition apparatus that is commercially available. On the other hand, 200 mg of α-NPD was placed in a resistive heating molybdenum boat, 200 mg of CBP was placed as a host compound in another resistive heating molybdenum boat, 200 mg of bathocuproine (BCP) was placed in another resistive heating molybdenum boat, 100 mg of Ir-1 was placed in another resistive heating molybdenum boat, and 200 mg of $Alq_3$ was placed in another resistive heating molybdenum boat, and then these were fixed in the vacuum deposition apparatus.

[Chem. 3]

Ir—1

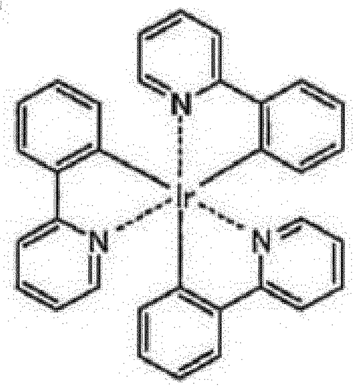

[Chem. 4]

$Alq_3$

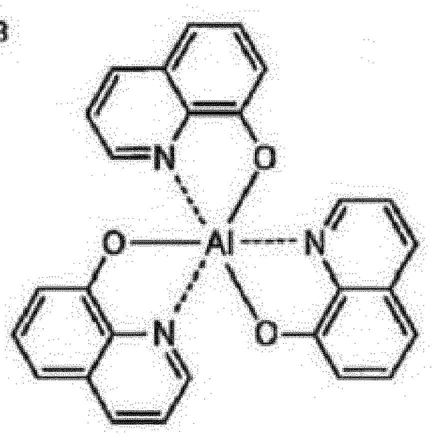

[Chem. 5]

α−NPD

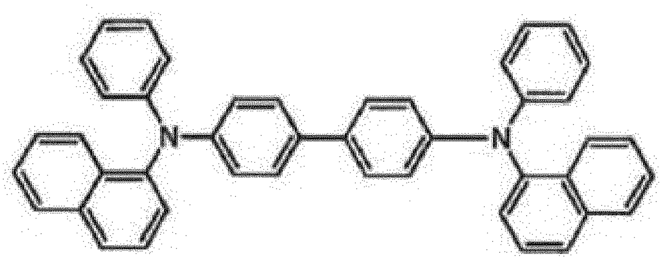

(Formation of hole transport layer)

Next, the pressure in the vacuum chamber was lowered to $4\times10^{-4}$ Pa, then the above-described heating boat containing α-NPD was applied with electric current and heated, and then a transparent supporting substrate was deposited at a deposition rate of 0.1 nm/sec to form a hole transport layer.

(Formation of light emitting layer)

Next, the above-described heating boat containing CBP and $Ir^{-1}$ was applied with electric current and heated, and then it was co-deposited on a hole transport layer at a deposition rate of 0.2 nm/sec and 0.012 nm/sec, respectively to form a light emitting layer. Meanwhile, the substrate temperature during the deposition was room temperature.

[Chem. 6]

CBP

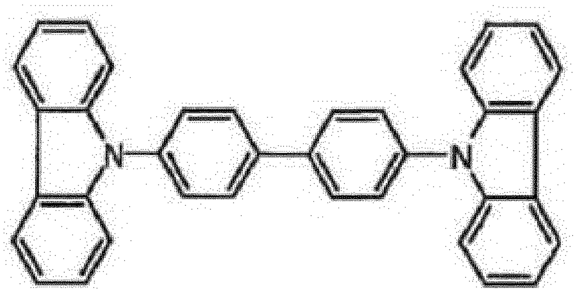

(Formation of hole blocking layer)

Further, the above-described heating boat containing BCP was applied with electric current and heated, and then it was deposited on the above-described light emitting layer at a deposition rate of 0.1 nm/sec to form a hole blocking layer having a film thickness of 10 nm.

[Chem. 7]

BCP

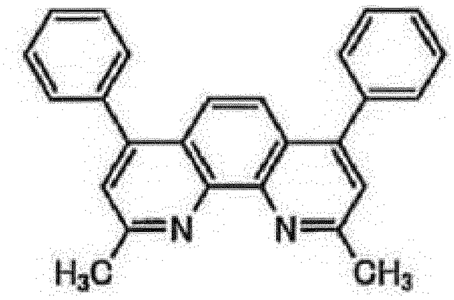

(Formation of electron transport layer)

Thereon, the above-described heating boat containing $Alq_3$ was applied with electric current and heated, and then it was deposited on the hole blocking layer at a deposition rate of 0.1 nm/sec to form an electron transport layer having a film thickness of 40 nm. Meanwhile, the substrate temperature during the deposition was room temperature.

(Formation of cathode)

Subsequently, 0.5 nm of lithium fluoride and 110 nm of aluminum were deposited to form a cathode, and organic EL elements 1 to 29 using samples 1 to 29, each of which contains a transparent conductive film, were prepared.

(Sealing of organic EL element)

In an environment that was purged with a nitrogen gas (inert gas), the aluminum deposited surface of an organic EL element samples 1 to 29 and an aluminum foil having a thickness of 100 μm were arranged to face each other, and then they were adhered by using an epoxy-based adhesive manufactured by Nagase ChemteX Corporation for performing sealing.

«Evaluation of organic EL element: evaluation of dark spot resistance and brightness unevenness resistance»

The sealed organic EL element samples 1 to 29 were applied with electric current in an environment of 40°C and 90%RH, and the changes of the situation of generation of dark spot and the like, and brightness unevenness were observed from day 0 up to day 120. As a result, it was confirmed that the organic EL element prepared by using the gas barrier films 4 to 29 of the present invention has characteristics that is excellent in the dark spot resistance and the brightness unevenness resistance, as compared to the organic EL element provided with the film 1 to 3 of Comparative examples.

## Claims

1. A gas barrier film comprising:

   a base,
   a first barrier layer formed on the surface of the base by a vapor growth method,
   a second barrier layer formed by a conversion treatment of a coating film formed by coating the surface of the first barrier layer with a first silicon compound, and
   a protective layer having no barrier property which is formed by a conversion treatment of a coating film formed by coating the surface of the second barrier layer with a second silicon compound.

2. The gas barrier film according to claim 1, wherein the first barrier layer formed by a vapor growth method comprises at least one selected from the group consisting of silicon oxide, silicon oxynitride, and silicon nitride.

3. The gas barrier film according to claim 1 or 2, wherein the first silicon compound comprises a polysilazane.

4. The gas barrier film according to any one of claims 1 to 3, wherein the second silicon compound comprises a polysiloxane.

5. The gas barrier film according to any one of claims 1 to 4, wherein an average film thickness of the second barrier layer is 10 nm to 1 μm and an average film thickness of the protective layer is 10 nm to 1 μm.

6. A method for manufacturing the gas barrier film according to any one of claims 1 to 5, wherein the second barrier layer is formed by a conversion treatment of a coating film, which is formed by coating the surface of the first barrier layer with a first silicon compound, by irradiation with vacuum ultraviolet ray having a wavelength component of 180 nm or less.

7. The method for manufacturing the gas barrier film according to claim 6, wherein an accumulated light amount of vacuum ultraviolet ray used for forming the second barrier layer is 1000 $mJ/cm^2$ or more and 10000 $mJ/cm^2$ or less and an accumulated light amount of vacuum ultraviolet ray used for forming the protective layer is 500 $mJ/cm^2$ or more and 10000 $mJ/cm^2$ or less.

8. The method for manufacturing the gas barrier film according to claim 6 or 7, wherein the second barrier layer and the protective layer are subjected to a step for heating at 50 to 200°C before irradiation with vacuum ultraviolet ray.

FIG. 1

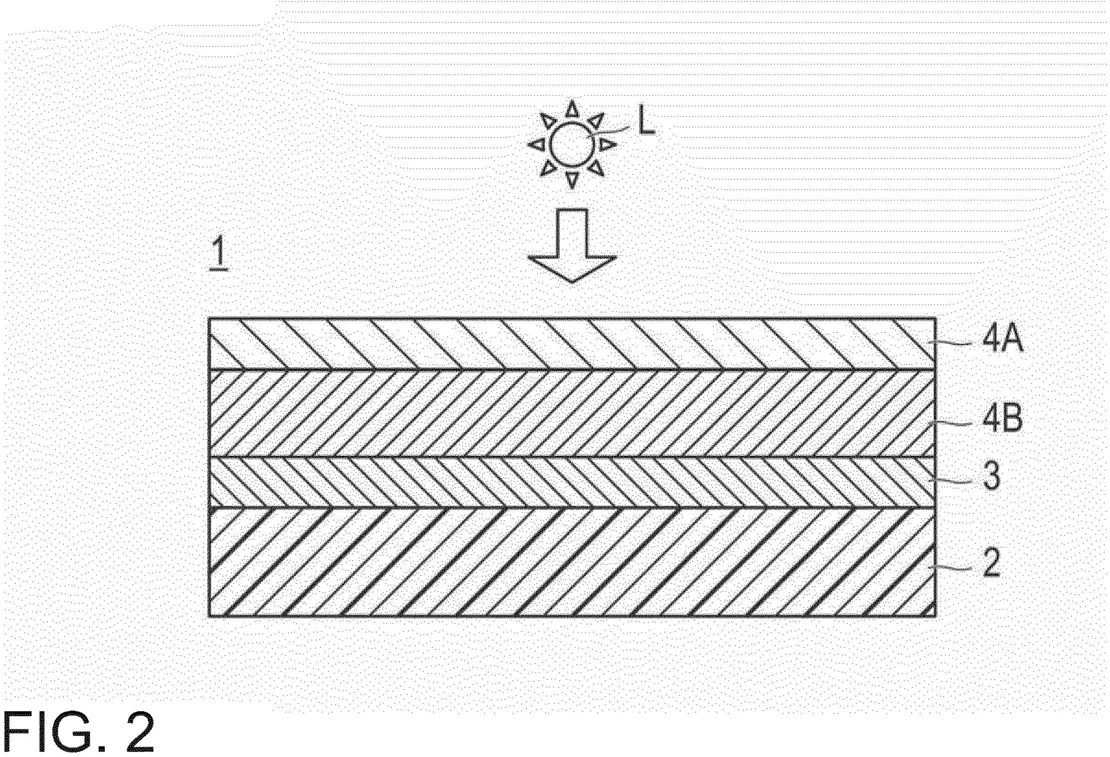


FIG. 2

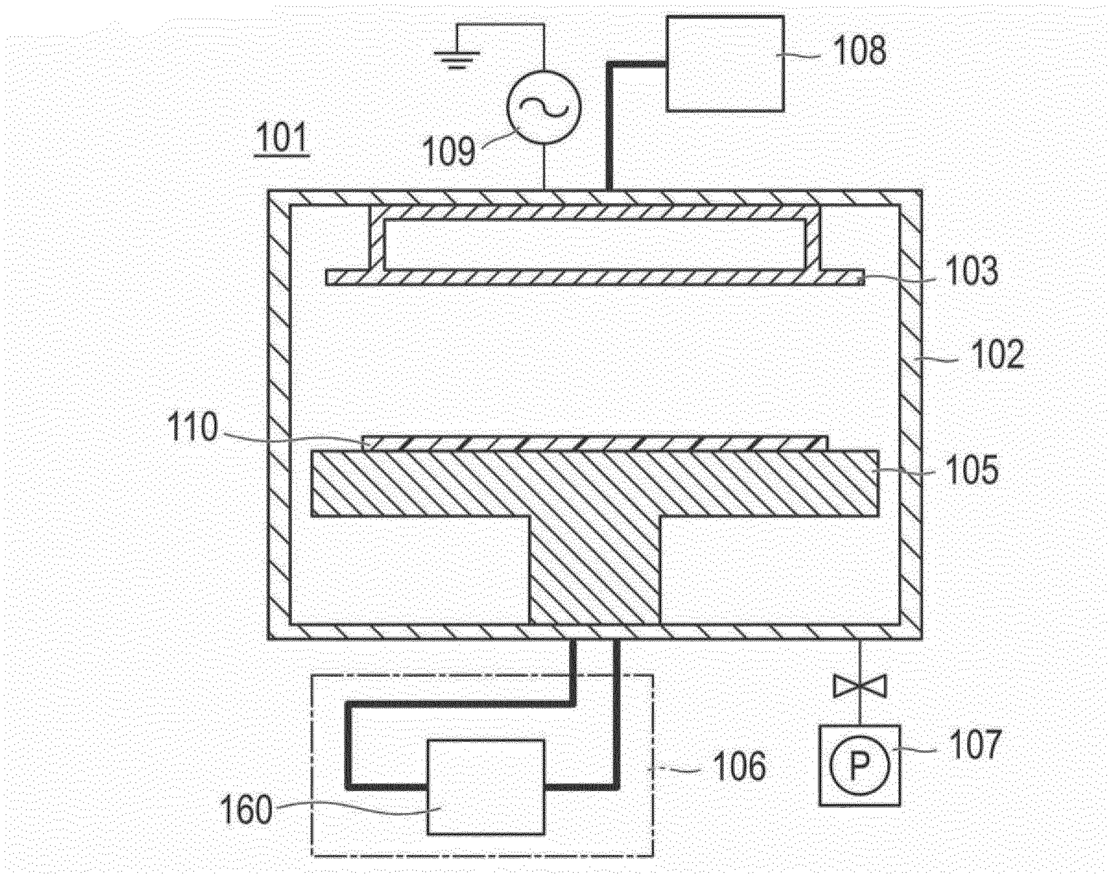

FIG. 3

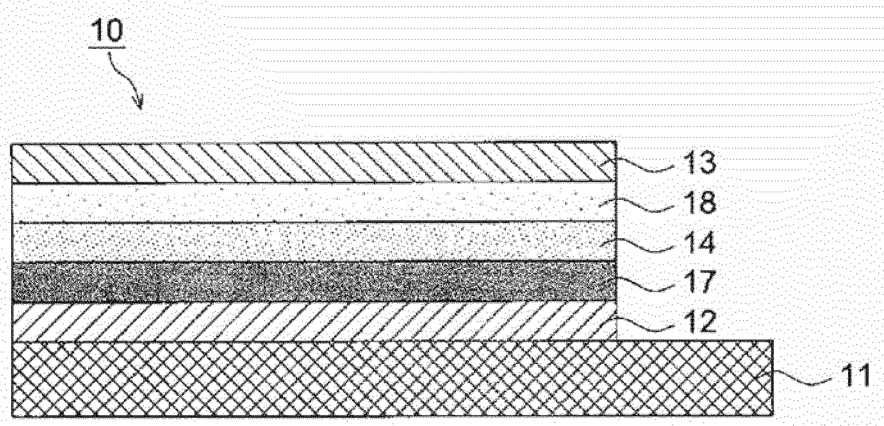


FIG. 4

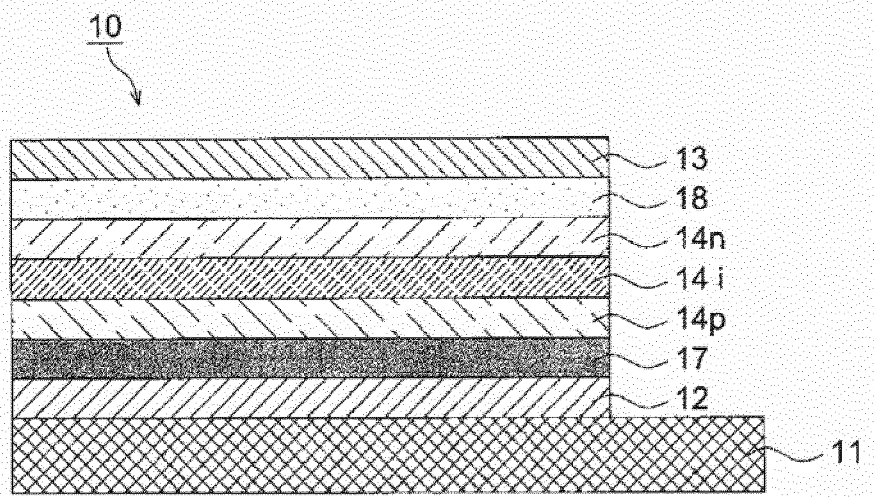

FIG. 5

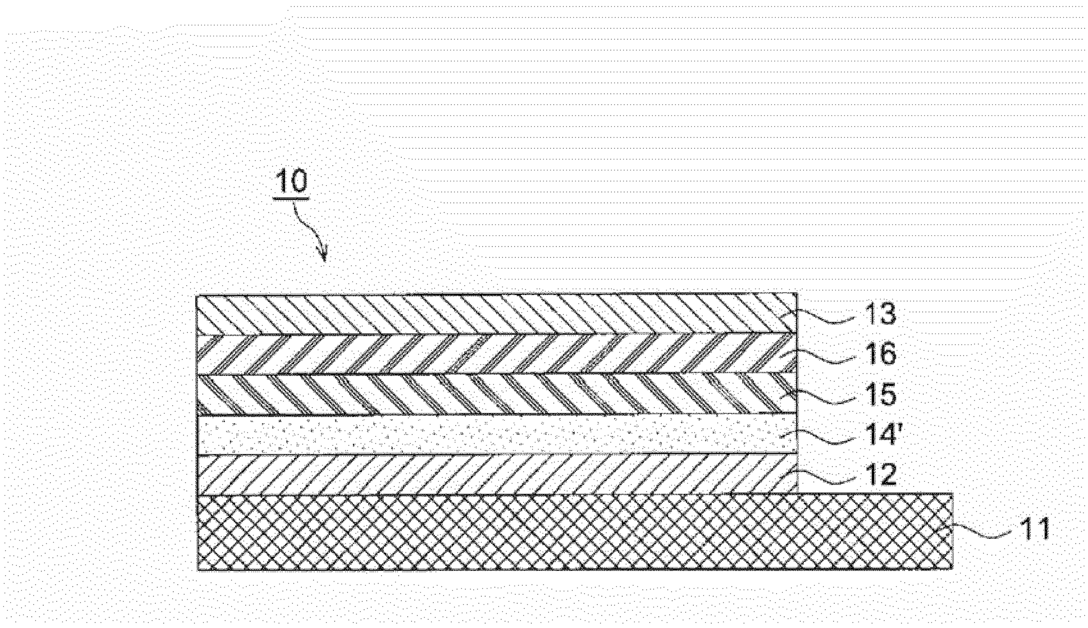

# INTERNATIONAL SEARCH REPORT

International application No.
PCT/JP2013/063460

A. CLASSIFICATION OF SUBJECT MATTER
*B32B9/00*(2006.01)i, *C23C16/42*(2006.01)i, *G09F9/30*(2006.01)i, *H01L31/042*(2006.01)i, *H01L51/42*(2006.01)i, *H01L51/50*(2006.01)i, *H05B33/02*(2006.01)i, *H05B33/10*(2006.01)i

According to International Patent Classification (IPC) or to both national classification and IPC

B. FIELDS SEARCHED

Minimum documentation searched (classification system followed by classification symbols)
B32B9/00, C23C16/42, G09F9/30, H01L31/042, H01L51/42, H01L51/50, H05B33/02, H05B33/10

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2013 |
| Kokai Jitsuyo Shinan Koho | 1971-2013 | Toroku Jitsuyo Shinan Koho | 1994-2013 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2012-76385 A (Konica Minolta Holdings, Inc.), 19 April 2012 (19.04.2012), claims 1, 4, 5; paragraphs [0046], [0069], [0073], [0153], [0154], [0172] (Family: none) | 1-8 |
| A | WO 2012/014653 A1 (Konica Minolta Holdings, Inc.), 02 February 2012 (02.02.2012), claims 1, 5, 7, 10, 12; paragraphs [0042], [0089], [0132], [0155], [0180]; fig. 1 & US 2013/0115423 A1 & EP 2599621 A1 & WO 2012/014653 A1 & CN 103025518 A & KR 10-2013-0032370 A | 1-8 |

☒ Further documents are listed in the continuation of Box C.  ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>15 August, 2013 (15.08.13) | Date of mailing of the international search report<br>27 August, 2013 (27.08.13) |
| Name and mailing address of the ISA/<br>Japanese Patent Office<br>Facsimile No. | Authorized officer<br><br>Telephone No. |

Form PCT/ISA/210 (second sheet) (July 2009)

INTERNATIONAL SEARCH REPORT

International application No. PCT/JP2013/063460

C (Continuation). DOCUMENTS CONSIDERED TO BE RELEVANT

| Category* | Citation of document, with indication, where appropriate, of the relevant passages | Relevant to claim No. |
|---|---|---|
| A | JP 2011-194653 A (Dainippon Printing Co., Ltd.), 06 October 2011 (06.10.2011), claim 1; paragraphs [0021] to [0026], [0041], [0085]; fig. 2 (Family: none) | 1-8 |
| A | JP 2012-51172 A (Fujifilm Corp.), 15 March 2012 (15.03.2012), claims 1, 3, 6, 9, 10; fig. 1 & US 2012/0052272 A1 & EP 2426164 A1 & CN 102380978 A & KR 10-2012-0021279 A | 1-8 |
| A | JP 11-151774 A (Dainippon Printing Co., Ltd.), 08 June 1999 (08.06.1999), claims 1, 2; fig. 1 (Family: none) | 1-8 |
| A | JP 9-70917 A (Oike & Co., Ltd.), 18 March 1997 (18.03.1997), claim 1; paragraph [0001]; fig. 1, 2 (Family: none) | 1-8 |
| A | JP 2008-159824 A (National Institute of Advanced Industrial Science and Technology), 10 July 2008 (10.07.2008), claim 1; paragraphs [0040] to [0047]; fig. 1 & US 2010/0140756 A1 & WO 2008/078516 A1 | 1-8 |
| A | JP 3511325 B2 (Mitsui Chemicals, Inc.), 29 March 2004 (29.03.2004), claim 1; paragraph [0001]; fig. 1, 2 (Family: none) | 1-8 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2009255040 A
- JP 3511325 B
- JP 2008235165 A
- JP 8112879 A
- JP 5238827 A
- JP 6122852 A
- JP 6240208 A
- JP 6299118 A
- JP 6306329 A
- JP 7196986 A
- JP 2012016854 A
- JP 2005283561 A
- WO 0316599 A
- WO 0328125 A
- US 6690029 B
- JP 2004107216 A
- US 2003136964 A
- WO 2008000664 A
- JP 2008016834 A
- JP 2006199674 A
- JP 2008130889 A
- US 7329709 B
- WO 2006019270 A
- JP 5271166 A
- JP 2006233252 A
- JP 2002266007 A
- JP 2004149871 A


### Non-patent literature cited in the description


- *J. Amer. Chem. Soc.,* vol. 127 (14), 4986
- *J. Amer. Chem. Soc,* vol. 123, 9482
- *J. Amer. Chem. Soc.,* 2008, vol. 130, 2706
- *Technical Digest of the International PVSEC-17,* 2007, 1225
- *Nature Material,* 2006, vol. 5, 328
- *Adv Mater,* 2007, 4160
- *Nature Mat.,* 2007, vol. 6, 497
- *Technical Digest of the International PVSEC,* 2007, 1225
- *Adv. Mater.,* 2008, vol. 20, 2116
- *Adv. Mater.,* 2002, vol. 14, 833-837
- *Chem. Mater.,* 2002, vol. 14, 4736-4745